# EUROPEAN PATENT APPLICATION

(11) **EP 2 135 901 A1**
(43) Date of publication of application: **23.12.2009**
(21) Application number: 08721374.0
(22) Date of filing: 05.03.2008
(51) Int. Cl.: C09B 23/00, C09B 29/48, C09B 45/14, C09B 45/18, C09B 45/20, C09B 45/48, C09B 47/12, C09B 47/18, C09B 47/20, G03F 7/004

(54) **COMPOUND FOR PHOTORESIST, PHOTORESIST SOLUTION, AND ETCHING METHOD USING THE PHOTORESIST SOLUTION**

(30) Priority: 05.03.2007 JP 2007054289; 27.07.2007 JP 2007196756; 16.08.2007 JP 2007212149; 15.10.2007 JP 2007267664; 15.10.2007 JP 2007267665; 28.02.2008 JP 2008047127; 28.02.2008 JP 2008047130; 28.02.2008 JP 2008047237; 28.02.2008 JP 2008047238; 28.02.2008 JP 2008047243
(71) Applicant: Fujifilm Corporation, Tokyo 106-0031 (JP)
(72) Inventor: WATANABE, Tetsuya, Minami-ashigara-shi Kanagawa 250-0193 (JP); USAMI, Yoshihisa, Ashigarakami-gun Kanagawa 258-8538 (JP)
(74) Representative: HOFFMANN EITLE
(86) International application number: PCT/JP2008/053954
(87) International publication number: WO 2008/108406

(57) **Abstract**

The present invention relates to a compound for photoresist, selected from the group consisting of a compound comprising an oxonol dye skeleton, a cyanine dye, a styryl dye, a compound comprising a merocyanine dye skeleton, a compound comprising a phthalocyanine dye skeleton, an azo compound, and a complex compound of an azo compound and a metal ion. The present invention further provides a photoresist liquid comprising at least one of the compound for photoresist and a method of etching a surface being processed using the photoresist liquid.

## Description

### CROSS-REFERENCE TO RELATED APPLICATIONS

This application claims the benefit of priority to Japanese Patent Application Nos. 2007-054289 filed on March 5, 2007,2007-196756 filed on July 27, 2007, 2007-212149 filed on August 16, 2007, 2007-267664 filed on October 15, 2007, 2007-267665 filed on October 15, 2007, 2008-047243 filed on February 28, 2008, 2008-047127 filed on February 28, 2008, 2008-047130 filed on February 28, 2008, 2008-047237 filed on February 28, 2008, and 2008-047238 filed on February 28, 2008, which are expressly incorporated herein by reference in their entirety.

### TECHNICAL FIELD

The present invention relates to a compound for photoresist and a photoresist liquid, that permits the formation of minute patterns. The present invention further relates to a method of etching a surface being processed using the photoresist liquid.

### BACKGROUND TECHNIQUE

In the process of manufacturing electronic components such as semiconductor elements, magnetic bubble memories, and integrated circuits, the technique of forming a minute pattern and employing it as an etching mask to etch the layer beneath it is widely employed.
In recent years, light-emitting elements such as LEDs have been utilized in various applications. The LED is comprised of a semiconductor element, in which multiple layers of semiconductive films, including a light-emitting layer, are laminated on a substrate (also referred to as a "chip" hereinafter) and packaged with resin or the like. Since the refractive index of the uppermost layer (or outermost layer) of the light outlet of the chip differs from that of the resin of the package, reflection occurs at the boundary between the two, diminishing light-emitting efficiency. Thus, to prevent such reflection at boundaries and achieve the goal of improving light-emitting efficiency, it has been proposed that a minute irregular structure be provided on the surface of the light outlet of the chip (see, for example, Japanese Unexamined Patent Publication (KOKAI) No. 2003-174171 or English language family member US2002/0195609A1 and Japanese Unexamined Patent Publication (KOKAI) No. 2003-209283 or English language family member US2003/0132445A1, which are expressly incorporated herein by reference in their entirety.

The fifth embodiment in Japanese Unexamined Patent Publication (KOKAI) No. 2003-174191 discloses a method of providing an antireflective film as the topmost layer constituting the above-mentioned light outlet of the light-emitting diode by manufacturing in advance a mold of minute irregular shape to form a minute irregular shape on the surface of the antireflective film, and press molding the surface of the antireflective film with the mold to impart an irregular shape to the surface of the light outlet. It also discloses, as a modification example thereof, the method of roughing in random directions with a grinder the surface of the antireflective film instead of press molding it with a mold. However, the former method requires an onerous process of fabricating a mold, as well as presenting a drawback in the form of the cost associated with fabricating the mold, while the latter method makes it difficult to consistently achieve a surface of uniform roughness, creating the problem of variation in product performance.
On the other hand, Japanese Unexamined Patent Publication (KOKAI) No. 2003-209283 discloses a method of forming a line and space pattern of triangular cross-section on a current diffusion layer constituting the topmost layer of the light outlet of a semiconductor element by blade processing, and then conducting treatment with hydrochloric acid at elevated temperature to form submicron irregularities on the surface of the current diffusion layer. It also discloses a method of employing photoresist on a current diffusion layer to form a line and space pattern, and then conducting reactive ion etching (RIE) to form minute irregularities similar to the above on the surface of the current diffusion layer. However, both of these methods present problems in the form of onerous processes.

Photolithography is a conventionally known technique employed to fabricate minute irregular structures, semiconductor devices, and the like. In photolithography, a resist composition containing a light-sensitive compound is coated on the surface of a substrate or the like, pattern exposed through a photomask, and developed. Thus, either exposed portions or unexposed portions are selectively removed to form a resist pattern. Subsequently, the resist pattern is employed as an etching mask to form a minute irregular pattern or semiconductor elements on the surface of the substrate or the like.

However, in conventional photolithography employing a photoresist liquid containing a light-sensitive compound, a developing step is required after pattern exposure, thereby increasing the steps.

### DISCLOSURE OF THE INVENTION

Accordingly, it is an object of the present invention to provide a novel compound for photoresist, employed for minute processing by means of photolithography, and more particularly, a novel compound for photoresist making it possible to omit the developing step following pattern exposure.
A further object of the present invention is to provide a photoresist liquid employing the above compound for photoresist.
A still further object of the present invention is to provide a method of etching a desired surface employing the above photoresist liquid.

The present inventors conducted extensive research into achieving the above-stated objects, resulting in the discovery that the pattern exposure of a dye film containing a dye compound selected from the group consisting of a compound comprising an oxonol dye skeleton, a cyanine dye, a styryl dye, a compound comprising a merocyanine dye skeleton, a compound comprising a phthalocyanine dye skeleton, an azo compound, and a complex compound of an azo compound and a metal ion generated a chemical and/or physical change in the physical properties of the portion irradiated with light by heating of the dye, permitting the use of the dye film as an etching mask following pattern exposure. The present invention was devised on that basis.

The present invention relates to a compound for photoresist, selected from the group consisting of a compound comprising an oxonol dye skeleton, a cyanine dye, a styryl dye, a compound comprising a merocyanine dye skeleton, a compound comprising a phthalocyanine dye skeleton, an azo compound, and a complex compound of an azo compound and a metal ion.

According to one embodiment, the above compound for photoresist is selected from the compound (also referred to as "oxonol dye", hereinafter) comprising an oxonol dye skeleton, denoted by the following general formula (I).

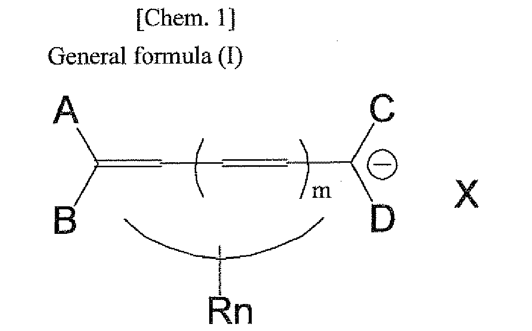

[In general formula (I), each of A, B, C, and D independently denotes an electron-withdrawing group, with a total of a Hammett's σₚ value of the electron-withdrawing group denoted by A and that of the electron-withdrawing group denoted by B being equal to or greater than 0.6 and a total of a Hammett's σₚ value of the electron-withdrawing group denoted by C and that of the electron-withdrawing group denoted by D being equal to or greater than 0.6, A and B may be linked together to form a ring, C and D may be linked together to form a ring, R denotes a substituent on a methine carbon, m denotes an integer of equal to or greater than 0 but equal to or less than 3, n denotes an integer of equal to or greater than 0 but equal to or less than (2m+1), plural Rs present may be respectively identical or different and may be linked together to form a ring when n denotes an integer of equal to or greater than 2, and X denotes a counter ion that neutralizes a charge of the compound denoted by general formula (I).]

The above oxonol dye is preferably selected from those having a thermal decomposition temperature of equal to or higher than 100 °C but equal to or lower than 500 °C.

According to one embodiment, the above compound for photoresist is selected from the cyanine dye denoted by the following general formula (IV):

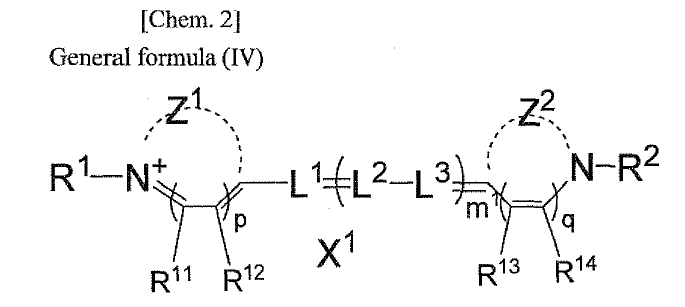

[In general formula (IV), each of Z¹ and Z² independently denotes a group of nonmetal atoms required to form an optionally condensed, five- or six-membered nitrogen-containing hetero ring, each of L¹, L², and L³ independently denotes a methine chain, m¹ denotes an integer ranging from 0 to 2, each of R¹ and R² independently denotes a substituent, plural L²s and L³s present may be identical or different when m¹ denotes 2; each of p and q independently denotes 0 or 1, each of R¹¹, R¹², R¹³, and R¹⁴ independently denotes a hydrogen atom or a substituent; and X¹ denotes a counter ion neutralizing a charge of the compound denoted by general formula (IV).]

According to one embodiment, the above compound for photoresist is selected from the styryl dye denoted by the following general formula (V):

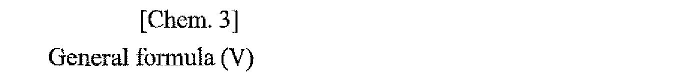

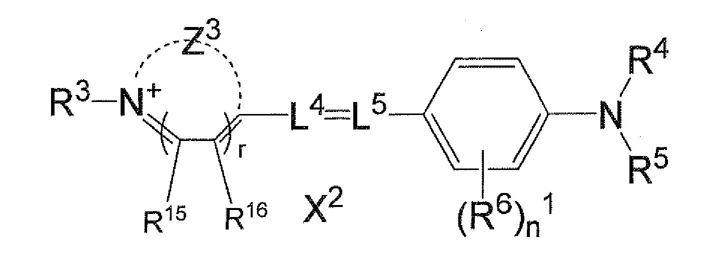

[In general formula (V), Z³ denotes a group of nonmetal atoms required to form an optionally condensed, five- or six-membered nitrogen-containing hetero ring, each of L⁴ and L⁵ independently denotes a methine chain, each of R³, R⁴, R⁵, and R⁶ independently denotes a substituent, n¹ denotes an integer ranging from 0 to 4, plural R⁶s present may be identical or different when n¹ is equal to or greater than 2; r denotes 0 or 1, each of R¹⁵ and R¹⁶ independently denotes a hydrogen atom or a substituent; and X² denotes a counter ion neutralizing a charge of the compound denoted by general formula (V).]

The above cyanine dye and styryl dye are preferably selected from those having a thermal decomposition temperature of equal to or higher than 100 °C but equal to or lower than 600 °C.

According to one embodiment, the compound for photoresist is selected from the compound (also referred to as "merocyanine dye", hereinafter) comprising a merocyanine dye skeleton, denoted by the following general formula (VI).

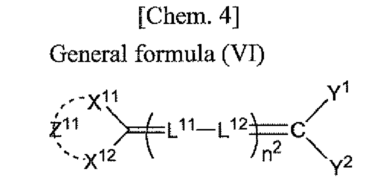

[In general formula (VI), Z¹¹ denotes a group of atoms forming a five- or six-membered hetero ring with X¹¹ and X¹², each of X¹¹ and X¹² independently denotes a carbon atom or a hetero atom, with at least either of X¹¹ or X¹² denoting a hetero atom, each of Y¹ and Y² independently denotes a substituent, with at least either of Y¹ and Y² denoting a cyano group, alkylcarbonyl group, arylcarbonyl group, alkoxycarbonyl group, aryloxycarbonyl group, aminocarbonyl group, alkylsulfone group, arylsulfone group, alkylsulfonyl group, arylsulfonyl group, or aminosulfonyl group, Y¹ and Y² may be linked together to form a ring, each of L¹¹ and L¹² independently denotes a methine group, and n² denotes an integer ranging from 0 to 2.]

The above merocyanine dye is preferably selected from those having a thermal decomposition temperature of equal to or higher than 150 °C but equal to or lower than 500 °C.

According to one embodiment, the above compound for photoresist is selected from the compound (also referred to as "phthalocyanine dye", hereinafter) comprising a phthalocyanine dye skeleton, denoted by the following general formula (VII).

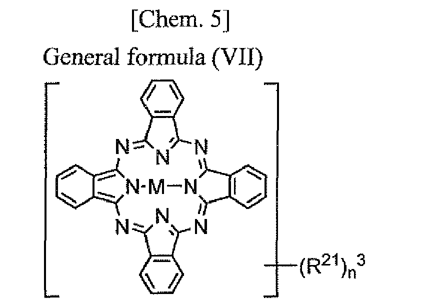

[In general formula (VII), R²¹ denotes a substituent, n³ denotes an integer ranging from 1 to 8, plural R²¹s present may be identical to or different from each other when n³ is an integer of equal to or greater than 2, and M denotes two hydrogen atoms, a divalent to tetravalent metal atom, a divalent to tetravalent oxymetal atom, or a divalent to tetravalent metal atom comprising a ligand.]

The phthalocyanine dye denoted by general formula (VII) is preferably selected from the compound denoted by the following general formula (VIII).

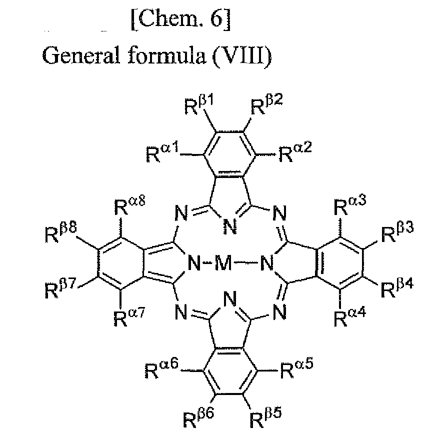

[In general formula (VIII), each of R^{α1} to R^{α8} and R^{β1} to R^{β8} independently denotes a hydrogen atom, halogen atom, cyano group, nitro group, formyl group, carboxyl group, sulfo group, substituted or unsubstituted alkyl group having 1 to 20 carbon atoms, substituted or unsubstituted aryl group having 6 to 14 carbon atoms, substituted or unsubstituted heterocyclic group having 1 to 10 carbon atoms, substituted or unsubstituted alkoxy group having 1 to 20 carbon atoms, substituted or unsubstituted aryloxy group having 6 to 14 carbon atoms, substituted or unsubstituted acyl group having 2 to 21 carbon atoms, substituted or unsubstituted alkylsulfonyl group having 1 to 20 carbon atoms, substituted or unsubstituted arylsulfonyl group having 6 to 14 carbon atoms, heterylsulfonyl group having 1 to 10 carbon atoms, substituted or unsubstituted carbamoyl group having 1 to 25 carbon atoms, substituted or unsubstituted sulfamoyl group having 0 to 32 carbon atoms, substituted or unsubstituted alkoxycarbonyl group having 2 to 20 carbon atoms, substituted or unsubstituted aryloxycarbonyl group having 7 to 15 carbon atoms, substituted or unsubstituted acylamino group having 2 to 21 carbon atoms, substituted or unsubstituted sulfonylamino group having 1 to 20 carbon atoms, or substituted or unsubstituted amino group having 0 to 36 carbon atoms, with at least 8 from among R^{α1} to R^{α8} and R^{β1} to R^{β8} being hydrogen atoms, but without all of R^{α1} to R^{α8} being hydrogen atoms; and M is defined in the same manner as in general formula (VII).]

According to one embodiment, in general formula (VIII), either R^{α1} or R^{α2}, either R^{α3} or R^{α4}, either R^{α5} or R^{α6}, and either R^{α7} or R^{α8} are not a hydrogen atom.

The above phthalocyanine dye is preferably selected from those having a thermal decomposition temperature of equal to or higher than 150 °C but equal to or lower than 500 °C.

According to one embodiment, the above compound for photoresist is selected from the compound denoted by the following general formula (IX) or the complex compound of the compound and a metal ion:

[Chem. 7]

General formula (IX) Q¹-N=N-Q²

[In general formula (IX), Q¹ denotes an aryl group or a heterocyclic group, Q² denotes an aryl group, heterocyclic group, or CR⁴¹R⁴², each of R⁴¹ and R⁴² independently denotes a substituent with a total value of a Hammett's σp value of the substituent denoted by R⁴¹ and that of the substituent denoted by R⁴² being equal to or greater than 0.6.]

Among the compounds denoted by general formula (IX), one particularly preferred group includes the azo compound denoted by the following general formula (X-1) and the complex compound of the azo compound and a metal ion.

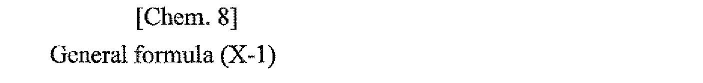

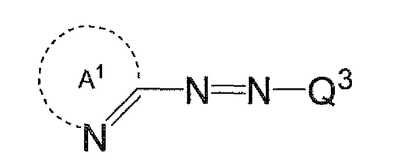

[In general formula (X-1), A¹ denotes a group of atoms forming a hetero aromatic ring with a carbon atom and nitrogen atom to which this is bonded, and Q³ is defined in the same manner as Q² in general formula (IX).]

Among the compounds denoted by general formula (IX), another particularly preferred group includes the azo compound denoted by the following general formula (X-2) and the complex compound of the azo compound and a metal ion.

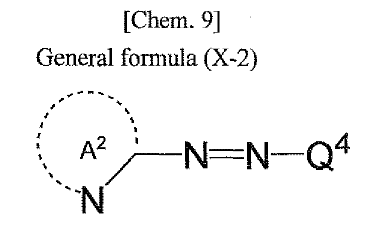

[In general formula (X-2), A² denotes a group of atoms forming a hetero aromatic ring with a carbon atom and nitrogen atom to which this is bonded, and Q⁴ is defined in the same manner as Q² in general formula (IX).]

The above azo compound and the complex compound of the azo compound and a metal ion are preferably selected from those having a thermal decomposition temperature of equal to or higher than 150 °C but equal to or lower than 500 °C.

Another aspect of the present invention relates to a photoresist liquid, comprising at least one of the compound for photoresist of the present invention.

According to one embodiment, the above photoresist liquid comprises the above compound for photoresist in a quantity of equal to or greater than 50 mass percent based on total solid component comprised in the photoresist liquid.

Another aspect of the present invention relates to a method of etching a surface being processed, comprising forming a photoresist film by coating the photoresist liquid of the present invention on a surface being processed; pattern exposing the photoresist film; and subjecting at least a portion of the surface being processed on which is present the photoresist film following the pattern exposure to etching, to etch at least a portion of the surface being processed in an area corresponding to the portion that has been exposed in the pattern exposure.

According to one embodiment, a light employed for the pattern exposure is a laser beam having a wavelength, λnm, the compound for photoresist comprised in the photoresist film is a compound selected from the group consisting of a oxonol dye, a cyanine dye, a styryl dye, a merocyanine dye, an azo compound, and a complex compound of an azo compound and a metal ion, and the compound has a maximum wavelength: λmax within a range of λ±150 nm.

According to one embodiment, a light employed for the pattern exposure is a laser beam having a wavelength, λnm, the compound for photoresist comprised in the photoresist film is a phthalocyanine dye, and the phthalocyanine dye has a maximum absorption within a range of λ±150 nm.

According to the present invention, since an etching mask can be formed only by pattern exposure, that is to say, without conducting a developing step with a developer, each developing step in a photolithography process, that is carried out plural times in a process of fabricating various semiconductor devises, can be omitted, thereby achieving significant simplification. Furthermore, according to the present invention, minute irregularities can be formed on a surface being processed.

### BEST MODE FOR CARRYING OUT THE INVENTION

### [Compound for photoresist]

The compound for photoresist of the present invention is a compound selected from the group consisting of a compound comprising an oxonol dye skeleton, a cyanine dye, a styryl dye, a compound comprising a merocyanine dye skeleton, a compound comprising a phthalocyanine dye skeleton, an azo compound, and a complex compound of an azo compound and a metal ion.
The present inventors discovered that when a dye film comprising a compound (also referred to as "dye compound", hereinafter) selected from the group consisting of a compound comprising an oxonol dye skeleton, a cyanine dye, a styryl dye, a compound comprising a merocyanine dye skeleton, a compound comprising a phthalocyanine dye skeleton, an azo compound, and a complex compound of an azo compound and a metal ion was partially irradiated with light, the physical properties of the irradiated portions changed locally, and that resistance to etching decreased relative to the dye film prior to light exposure. They also discovered that the dye film could function as an etching mask. The present inventors have presumed the following with regard to this phenomenon.
When the dye film comprising the above dye compound is irradiated with spots of light by a laser beam, for example, the dye compound in the irradiated portions heats up. This heating causes the dye compound to undergo a change in physical properties, such as thermal decomposition, which is thought to result in localized physical and/or chemical change in the light-irradiated portions of the dye film, forming pits (openings) or portions of locally reduced durability (low-durability portions). The dye film in which the pits have been formed will function as an etching mask, of course. Since the low-durability portions are readily etched away in the etching step, a dye film in which low-durability portions have been formed by pattern exposure will also function as an etching mask. The dye film itself that contains the oxonol dye also has good resistance to etching and was found to function well as a film durable to etching. In this context, the etching method may be either a dry or wet etching method. In particular, application to dry etching is desirable because the step of washing away the wet etching liquid is unneeded.
In particular, the present inventors observed the behavior of the dye film containing the above dye compound during irradiation with a laser beam. As the temperature of the center portion of the area irradiated with a laser beam rose, a phenomenon whereby the temperature of the surrounding portions dropped was confirmed. Although the reason for the drop in temperature in surrounding portions was not determined, the drop in temperature of the surrounding portions inhibits spreading of the change in physical properties to surrounding portions despite the formation of low-durability portions and the formation of pits due to thermal decomposition in the center portion of areas irradiated by the laser beam. Thus, in pattern exposure with a laser beam, it is thought that a pattern of smaller diameter than the diameter of the laser beam can be formed in the dye film. Accordingly, pattern exposure of a dye film with a laser beam causes just a small diameter exposure area that is even narrower than the area irradiated by the laser beam diameter to become a low-durability portion. As a result, minute pattern exposure can be achieved that is similar to pattern exposure with a fine beam smaller in diameter than a laser beam.
Further, the dye film containing the above dye compound forms pits or low-durability portions in areas irradiated in pattern exposure. Thus, the developing process after pattern exposure is unnecessary and thus it is possible to conduct the etching step as a subsequent step of the pattern exposure.
The "photoresist" in the present invention includes embodiments that form a resist pattern by means of heat generated by such pattern exposure.
The compound for photoresist of the present invention will be described in greater detail below.

The compound for photoresist of the present invention can be a compound comprising an oxonol dye skeleton. In the present invention, the phrase "compound comprising an oxonol dye skeleton" means a methine dye, characterized in that an alternating conjugate system constituting a chromophore is terminated by a hetero atom or a carbon atom having a negative charge, thereby causing the negative charge to be present in a nonlocalized manner throughout the entire conjugated system.

Among compounds comprising an oxonol dye skeleton, from the perspectives of light absorption characteristics, thermal decomposition characteristics, and the like, the oxonol dye denoted by general formula (I) below can be given by way of example.

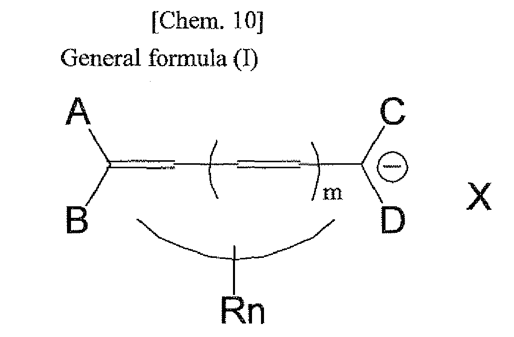

In general formula (I), each of A, B, C, and D independently denotes an electron-withdrawing group, with a total of a Hammett's σₚ value of the electron-withdrawing group denoted by A and that of the electron-withdrawing group denoted by B being equal to or greater than 0.6 and a total of a Hammett's σₚ value of the electron-withdrawing group denoted by C and that of the electron-withdrawing group denoted by D being equal to or greater than 0.6, A and B may be linked together to form a ring, C and D may be linked together to form a ring, R denotes a substituent on a methine carbon, m denotes an integer of equal to or greater than 0 but equal to or less than 3, n denotes an integer of equal to or greater than 0 but equal to or less than (2m+1), plural Rs present may be respectively identical or different and may be linked together to form a ring when n denotes an integer of equal to or greater than 2, and X denotes a counter ion that neutralizes a charge of the compound denoted by general formula (I).
The oxonol dye denoted by general formula (I) will be described below.

In general formula (I), each of A, B, C, and D independently denotes an electron-withdrawing group. However, the total of the Hammett's substituent constant σₚ value (referred to as "σₚ value", hereinafter) of the electron-withdrawing group denoted by A and that of the electron-withdrawing group denoted by B is equal to or greater than 0.6, and the total of the Hammett's σₚ value of the electron-withdrawing group denoted by C and that of the electron-withdrawing group denoted by D is equal to or greater than 0.6. When the total of the Hammett's σₚ values is equal to or greater than 0.6, absorption characteristics and heat decomposition properties suitable as a compound for photoresist can be achieved. Each of A, B, C, and D may be respectively identical or different. Further, A and B, or C and D, may be linked together to form a ring.

The total of the Hammett's σₚ values of the electron-withdrawing group denoted by A and the electron-withdrawing group denoted by B, and the total of the Hammett's σₚ values of the electron-withdrawing group denoted by C and the electron-withdrawing group denoted by D, are each desirably 0.6 to 1.7, preferably 0.7 to 1.6. Further, the Hammett's σₚ value of each of the electron-withdrawing groups denoted by A, B, C, and D independently desirably falls within a range of 0.30 to 0.85, preferably within a range of 0.35 to 0.80.

The Hammett's σₚ value is described, for example, in Chem. Rev. 91, 165 (1991) and in references sited therein. The Hammett's σₚ value of items not described therein can be calculated by the method described in these documents. When A and B (or C and D) are linked to form a ring, the σₚ value of A (or C) means the σₚ value of the -A-B-H (or -C-D-H) group, and the σₚ value of B (or D) means the σₚ value of the -B-A-H (or -D-C-H) group. In that case, the σₚ values differ because the bond orientation of the two differs.

Desirable specific examples of the electron-withdrawing groups denoted by A, B, C, and D are: cyano groups, nitro groups, acyl groups with 1 to 10 carbon atoms (such as acetyl groups, propionyl groups, butyryl groups, pivaloyl groups, and benzoyl groups), alkoxycarbonyl groups having 2 to 12 carbon atoms (such as methoxycarbonyl groups, ethoxycarbonyl groups, isopropoxycarbonyl groups, butoxycarbonyl groups, and decyloxycarbonyl groups), aryloxycarbonyl groups having 7 to 11 carbon atoms (such as phenoxycarbonyl groups), carbamoyl groups having 1 to 10 carbon atoms (such as methylcarbamoyl groups, ethylcarbamoyl groups, and phenylcarbamoyl groups), alkylsulfonyl groups having 1 to 10 carbon atoms (such as methanesulfonyl groups), arylsulfonyl groups having 6 to 10 carbon atoms (such as benzenesulfonyl groups), alkoxysulfonyl groups having 1 to 10 carbon atoms (such as methoxysulfonyl groups), sulfamoyl groups having 1 to 10 carbon atoms (such as ethylsulfamoyl groups and phenylsulfamoyl groups), alkylsulfinyl groups having 1 to 10 carbon atoms (such as methanesulfinyl groups and ethanesulfinyl groups), arylsulfinyl groups having 6 to 10 carbon atoms (such as benzenesulfinyl groups), alkylsulfenyl groups having 1 to 10 carbon atoms (such as methanesulfenyl groups and ethanesulfenyl groups), arylsulfenyl groups having 6 to 10 carbon atoms (such as benzenesulfenyl groups), halogen atoms, alkynyl groups having 2 to 10 carbon atoms (such as ethynyl groups), diacylamino groups having 2 to 10 carbon atoms (such as diacetylamino groups), phosphoryl groups, carboxyl groups, and five-membered and six-membered heterocyclic groups (such as 2-benzothiazolyl groups, 2-benzooxazolyl groups, 3-pyridyl groups, 5-(1H)-tetrazolyl groups, and 4-pyrimidyl groups).

Examples of the substituent on the methine carbon denoted by R in general formula (I) are: chain or cyclic alkyl groups having 1 to 20 carbon atoms (such as methyl, ethyl, n-propyl, isopropyl, and n-butyl groups), substituted or unsubstituted aryl groups having 6 to 18 carbon atoms (such as phenyl, chlorophenyl, anisyl, toluyl, 2,4-di-t-amyl, and 1-naphthyl groups), alkenyl groups (such as vinyl and 2-methylvinyl groups), alkynyl groups (such as ethynyl, 2-methylethynyl, and 2-phenylethynyl groups), halogen atoms (such as F, Cl, Br, and I), cyano groups, hydroxyl groups, carboxyl groups, acyl groups (such as acetyl, benzoyl, salicyloyl, and pivaloyl groups), alkoxy groups (such as methoxy, butoxy, and cyclohexyloxy groups), aryloxy groups (such as phenoxy and 1-naphthoxy groups), alkylthio groups (such as methylthio, butylthio, benzylthio, and 3-methoxypropylthio groups), arylthio groups (such as phenylthio and 4-chlorophenylthio groups), alkylsulfonyl groups (such as methanesulfonyl and butanesulfonyl groups), arylsulfonyl groups (such as benzenesulfonyl and paratoluenesulfonyl groups), carbamoyl groups having 1 to 10 carbon atoms, amido groups having 1 to 10 carbon atoms, imido groups having 2 to 12 carbon atoms, acyloxy groups having 2 to 10 carbon atoms, alkoxycarbonyl groups having 2 to 10 carbon atoms, and heterocyclic groups (such as aromatic heterocyclic rings such as pyridyl, thienyl, furyl, thiazolyl, imidazolyl, and pyrazolyl groups, and aliphatic heterocyclic rings such as pyrrolidine rings, piperidine rings, morpholine rings, pyran rings, thiopyran rings, dioxane rings, and dithiolane rings).

R is desirably a halogen atom, chain or cyclic alkyl group having 1 to 8 carbon atoms, aryl group having 6 to 10 carbon atoms, alkoxy group having 1 to 8 carbon atoms, aryloxy group having 6 to 10 carbon atoms, or heterocyclic group having 3 to 10 carbon atoms; preferably a chlorine atom, alkyl group having 1 to 4 carbon atoms (such as a methyl group, ethyl group, or isopropyl group), phenyl, alkoxy group having 1 to 4 carbon atoms (such as a methoxy or ethoxy group), phenoxy group, or nitrogen-containing heterocyclic group having 4 to 8 carbon atoms (such as a 4-pyridyl group, benzoxazole-2-yl group, or benzothiazole 2-yl group).

n denotes an integer of equal to or greater than 0 but equal to or less than (2m+1). Further below m will be described in detail. When n is an integer of equal to or greater than 2, plural Rs present may be respectively identical or different, and may be linked together to form a ring. In that case, the ring is desirably comprised of 4 to 8 members, preferably 5 or 6 members. The constituent atoms of the ring are desirably carbon atoms, oxygen atoms, and/or nitrogen atoms, preferably carbon atoms.

A, B, C, D, and R may further comprise substituents. Examples of such substituents are the examples given above for monovalent substituents denoted by R in general formula (I). In the present invention, the "carbon number" of a given group comprising substituents refers to the number of carbon atoms of the portion not including any substituent.

In the oxonol dye denoted by general formula (I), it is desirable from the perspective of thermal decomposition for A and B, and/or C and D, to be linked to form a ring. Examples of such rings are given below. In the examples, each of Ra, Rb, and Rc independently denotes a hydrogen atom or a substituent. The details of the substituents denoted by Ra, Rb, and Rc are as set forth above for R. Ra, Rb, and Rc may be linked together to form a carbon ring or a heterocyclic ring. Examples of carbon rings are cyclohexyl, cycloheptyl, cyclohexene, and benzene rings, and other saturated or unsaturated 4- to 7-membered carbon rings. Examples of heterocylic rings are piperidine, piperazine, morpholine, tetrahydrofuran, furan, thiophene, pyridine, and pyrazine rings, and other saturated or unsaturated 4- to 7- membered heterocyclic rings. These carbon rings and heterocyclic rings may be further substituted. Examples of groups that can further substitute are the groups given above by way of example for the substituent denoted by R.

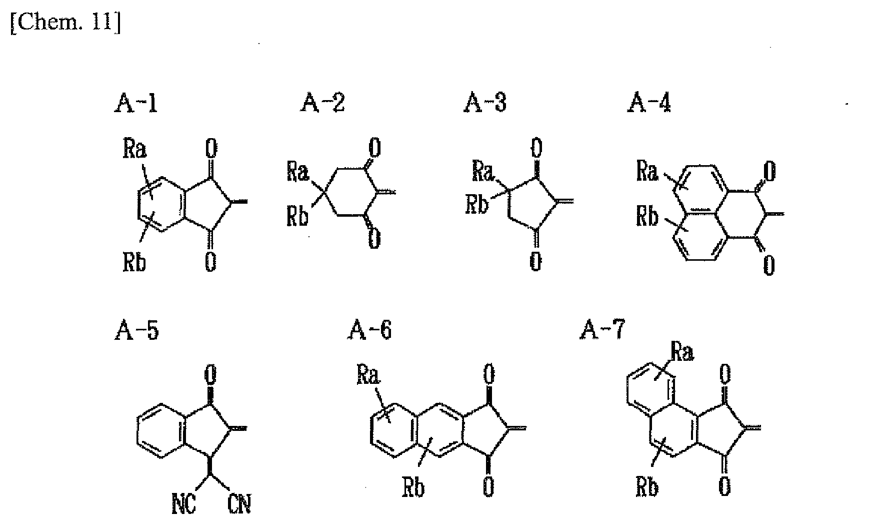

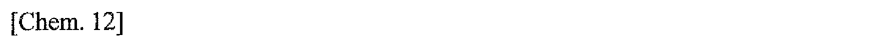

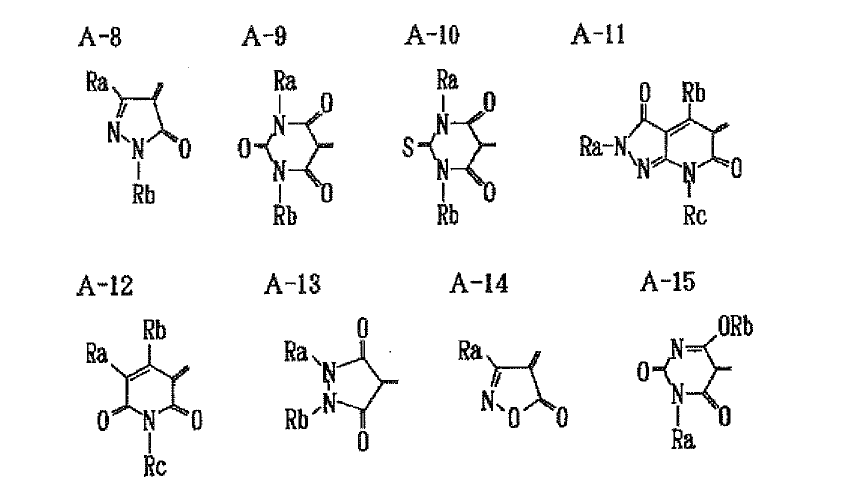

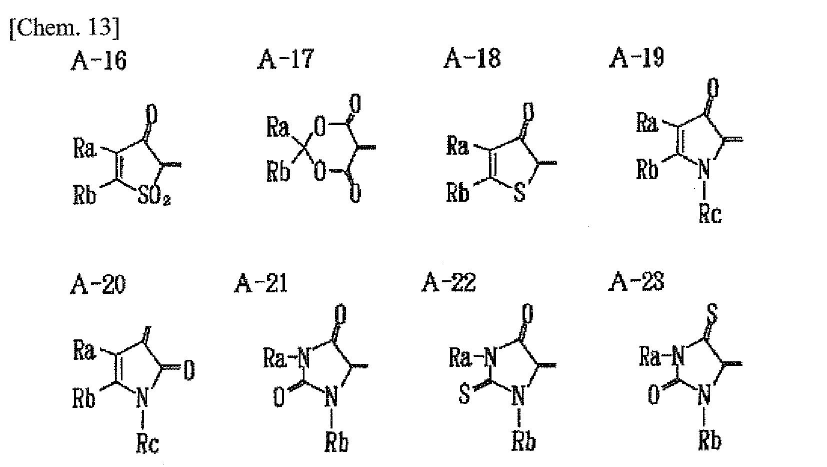

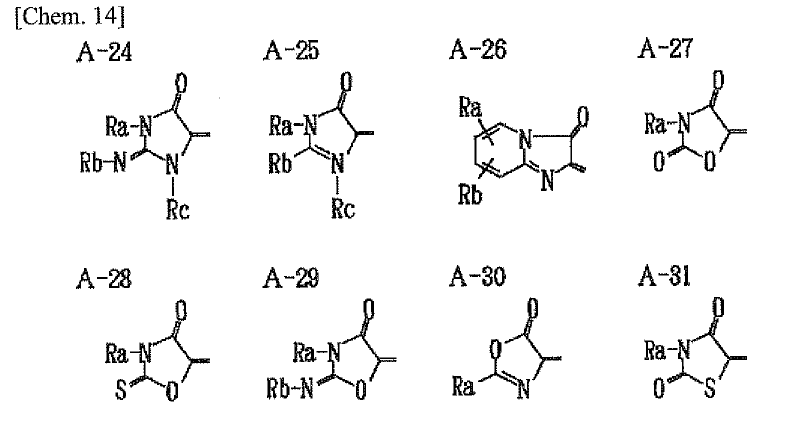

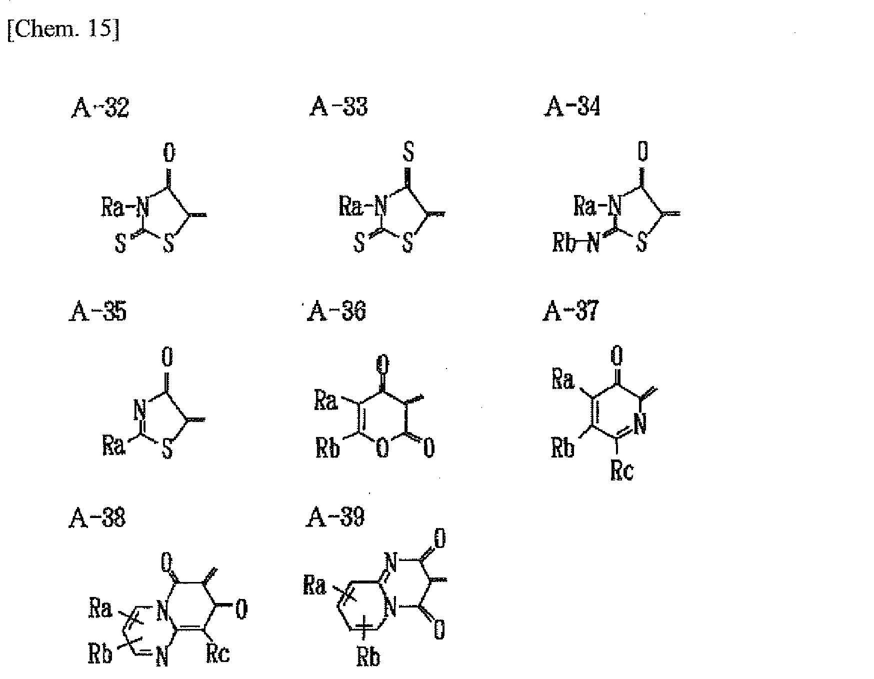

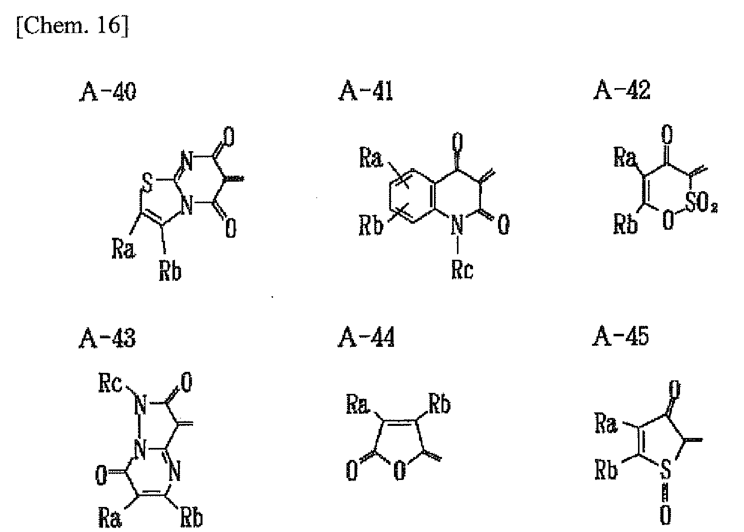

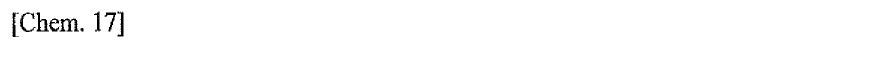

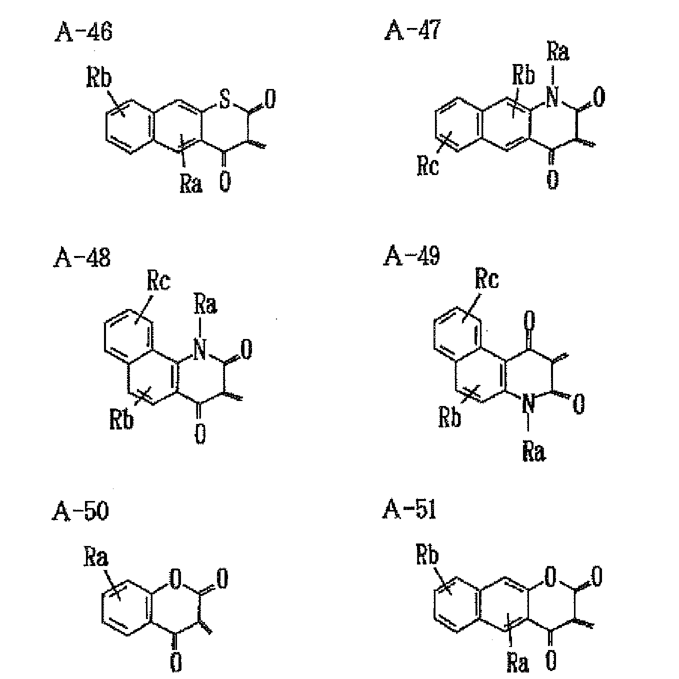

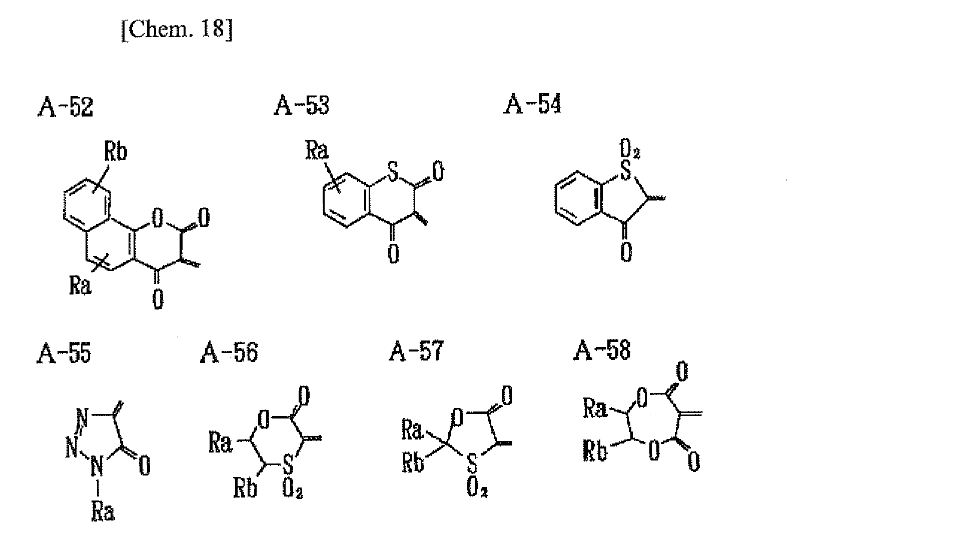

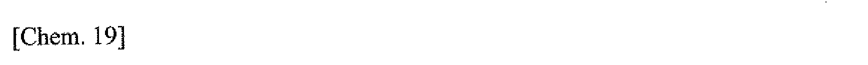

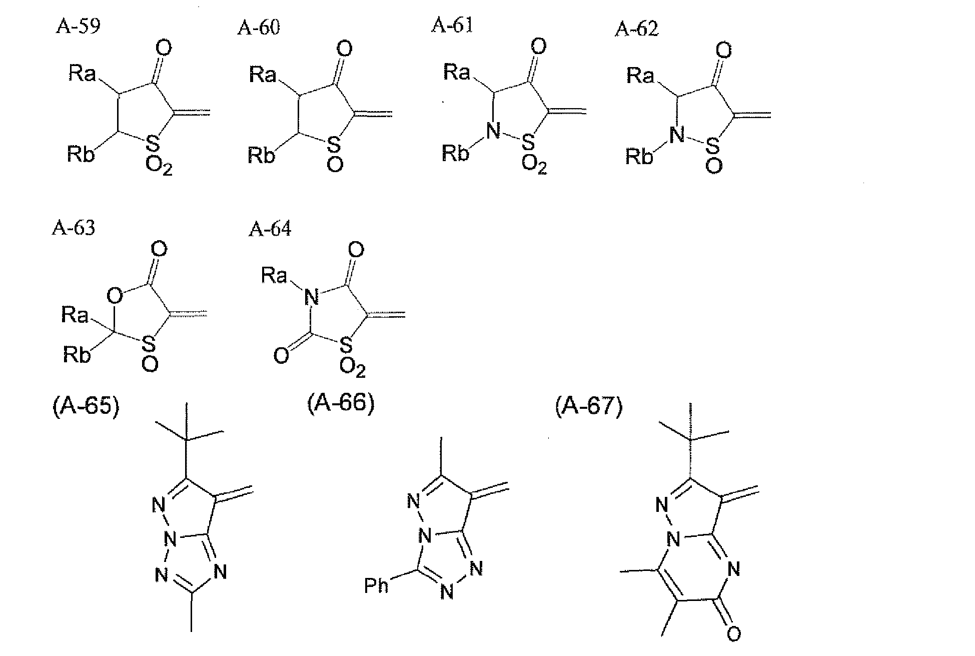

Of the above, A-8, A-9, A-10, A-11, A-12, A-13, A-14, A-16, A-17, A-36, A-39, A-41, A-54, and A-57 are examples of desirable rings. A-8, A-9, A-10, A-13, A-14, A-16, A-17, and A-57 are examples of preferred rings. The optimal ring forms are given by A-9, A-10, A-13, A-17, and A-57.

In general formula (I), m denotes an integer of equal to or greater than 0 but equal to or lower than 3. Based on the value of m, the absorption wavelength of the oxonol dye by general formula (I) varies greatly. The value of m is desirably selected to achieve the optimal absorption wavelength based on the oscillation wavelength of the laser employed in resist processing. The details are set forth further below. When processing resist using the compound for photoresist of the present invention, a laser beam employed in optical recording can be employed as a light employed in resist processing. For example, when the center oscillation wavelength of the laser employed in resist processing is 780 nm (the semiconductor laser employed in CD-R recording), m in general formula (I) desirably denotes 2 or 3. When the center oscillation wavelength is 635 nm or 650 nm (the semiconductor laser employed in DVD-R recording), m desirably denotes 1 or 2. And when the center oscillation wavelength is equal to or lower than 550 nm (for example, a blue-violet semiconductor laser with a center oscillation wavelength of 405 nm), m desirably denotes 0 or 1, preferably 0.

In general formula (I), the counter ion denoted by X neutralizes the charge of the compound denoted by general formula (I). It can be an anion, cation, single ion species, or combination of multiple ion species. It is normally a cation, and may be an inorganic cation or an organic cation. Examples of inorganic cations are: hydrogen ions, metal ions, and ammonium ions (NH₄⁺). Metal ions are desirable; alkali metal ions (such as Li⁺, Na⁺, and K⁺) and transition metal ions (such as Cu²⁺ and Co²⁺) are preferred. Transition metal ions may be coordinated with organic ligands.

An onium ion is desirable and the ion denoted by general formula (III) below is preferred as the organic cation denoted by X. These compounds are readily obtained by the Menshutkin reaction of a corresponding dipyridyl and a halogen compound containing the target substitute (for example, see Japanese Unexamined Patent Publication (KOKAI) Showa No. 61-148162), or by an arylation reaction based on the method described in Japanese Unexamined Patent Publication (KOKAI) Showa No. 51-16675 and Japanese Unexamined Patent Publication (KOKAI) Heisei No. 1-96171.

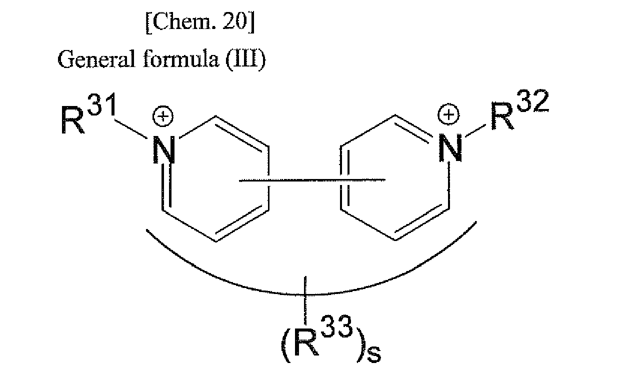

In general formula (III), each of R³¹ and R³² independently denotes an alkyl group, alkenyl group, alkynyl group, aryl group, or heterocyclic group, R³³ denotes a substituent, and s denotes an integer falling within a range of 0 to 8. When s is an integer of equal to or greater than 2, plural R³³s present may be respectively identical or different, and may be linked together to form a ring.

In general formula (III), the alkyl group denoted by R³¹ or R³² may be linear, branched, or cyclic; it desirably comprises 1 to 18 carbon atoms, and preferably comprises 1 to 8 carbon atoms. Specific examples of these alkyl groups are methyl, ethyl, n-propyl, isopropyl, n-butyl, isobutyl, s-butyl, isoamyl, n-hexyl, cyclohexyl, 2-ethylhexyl, and n-octyl groups.

In general formula (III), the alkenyl group denoted by R³¹ or R³² desirably comprises 2 to 18 carbon atoms, preferably 2 to 8 carbon atoms. Specific examples are vinyl, 2-propenyl, 2-methyl, propenyl, and 1,3-butadienyl groups.

In general formula (III), the alkynyl group denoted by R³¹ or R³² desirably comprises 2 to 18 carbon atoms, preferably 2 to 8 carbon atoms. Specific examples are ethynyl, propynyl, and 3,3-dimethylbutynyl groups.

In general formula (III), the aryl group denoted by R³¹ or R³² desirably comprises 6 to 18 carbon atoms, preferably 6 to 10 carbon atoms. Specific examples are phenyl, 1-naphthyl, and 2-naphthyl groups.

In general formula (III), the heterocyclic group denoted by R³¹ or R³² is desirably a saturated or unsaturated heterocyclic group comprising 4 to 7 carbon atoms, with the hetero atoms contained desirably being nitrogen, oxygen, or sulfur atoms. Specific examples are 4-pyridyl, 2-pyridyl, 2-pyrazyl, 2-pyrimidyl, 4-pyrimidyl, 2-imidazolyl, 2-furyl, 2-thiophenyl, 2-benzooxazolyl, and 2-benzothioxazolyl groups.

In general formula (III), the alkyl group, alkenyl group, alkynyl group, aryl group, or heterocyclic group denoted by R³¹ or R³² may be further substituted. Examples of the substituents are those given by way of example of the substituent denoted by R in general formula (I).

In general formula (III), R³³ denotes a substituent. The details of the substituent denoted by R³³ are as set forth for the substituent denoted by R in general formula (I). A substituted or unsubstituted alkyl group having 1 to 18 carbon atoms is desirable, and an unsubstituted alkyl group having 1 to 8 carbon atoms is preferred.

In general formula (III), s denotes an integer falling within a range of 0 to 8, desirably an integer falling within a range of 0 to 4, preferably an integer falling within a range of 0 to 2, and more preferably, 0. When s is an integer of equal to or greater than 2, plural R³³s present may be respectively identical or different, and may be linked together to form a ring. The two pyridine rings in general formula (III) may be linked at any position, are desirably linked at the 2 position and 4 position of the pyridine rings, and are preferably linked at the 4 positions of the two pyridine rings.

The oxonol dyes denoted by general formula (I) may be bonded at any position to form a polymer. In that case, the various units may be identical or different, and may be bonded to polymer chains of polystyrene, polymethacrylate, polyvinyl alcohol, cellulose, or the like.

General formula (I) includes multiple tautomers based on differences in the notation of the localized position of the anion. In particular, when one from among A, B, C, and D denotes -CO-E (E being a substituent), the common practice is to denote the negative charge as being localized on the oxygen atom. For example, when D is -CO-E, the notation is generally as given in general formula (II) below; compounds represented by such notation are included in general formula (I).

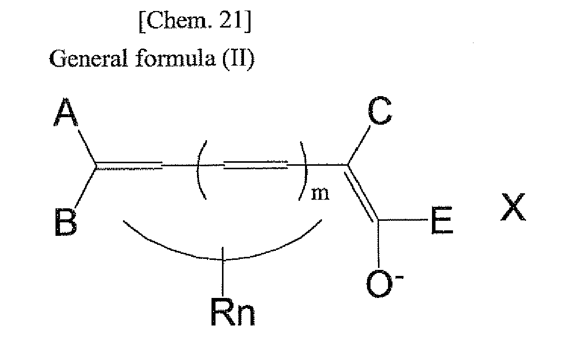

The definitions of A, B, C, R, m, n, and x in general formula (II) are identical to those in general formula (I).

Specific examples of the oxonol dye denoted by general formula (I) are the specific examples of oxonol dyes given in Japanese Unexamined Patent Publication (KOKAI) Showa No. 63-209995 or English language family member U.S. Patent No. 4,968,593; Japanese Unexamined Patent Publication (KOKAI) Heisei No. 10-297103 or English language family member U.S. Patent No. 6,670,475; Japanese Unexamined Patent Publication (KOKAI) Heisei No. 11-348420; Japanese Unexamined Patent Publication (KOKAI) No. 2000-52658 or English language family member U.S. Patent No. 6,225,024; and Japanese Unexamined Patent Publication (KOKAI) No. 2000-272241. Some of these compounds will be given as examples below.

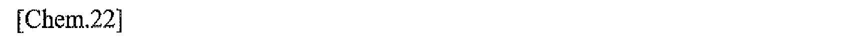

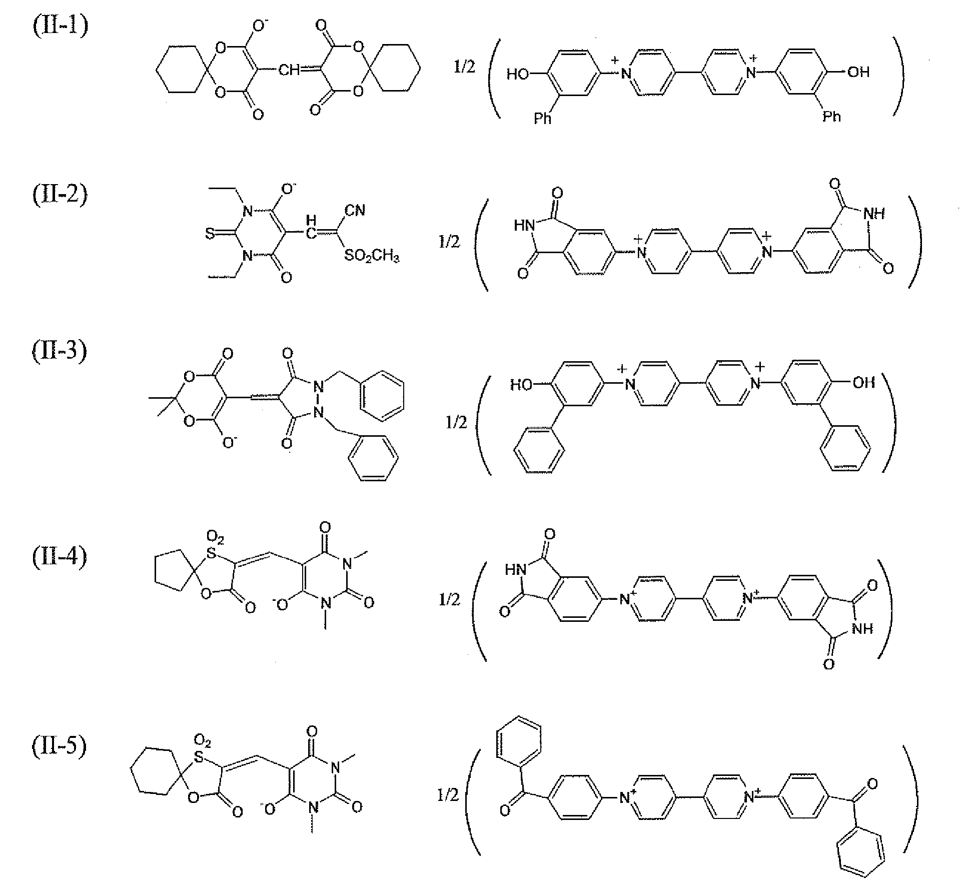

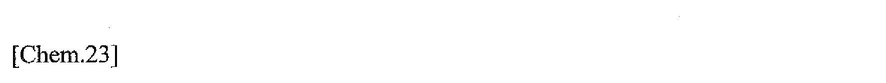

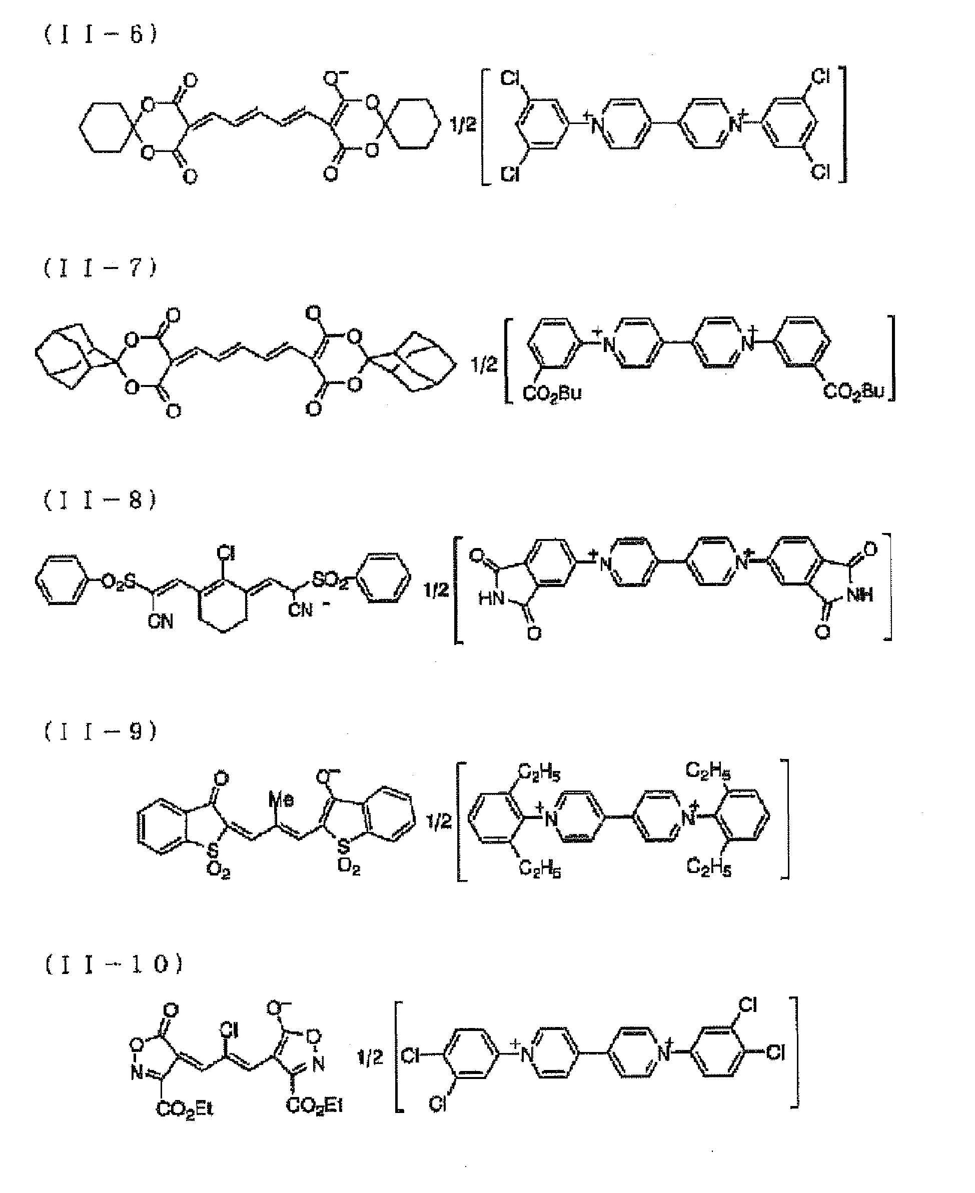

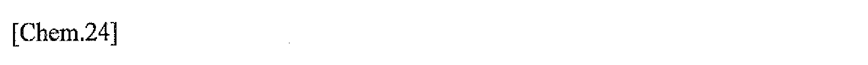

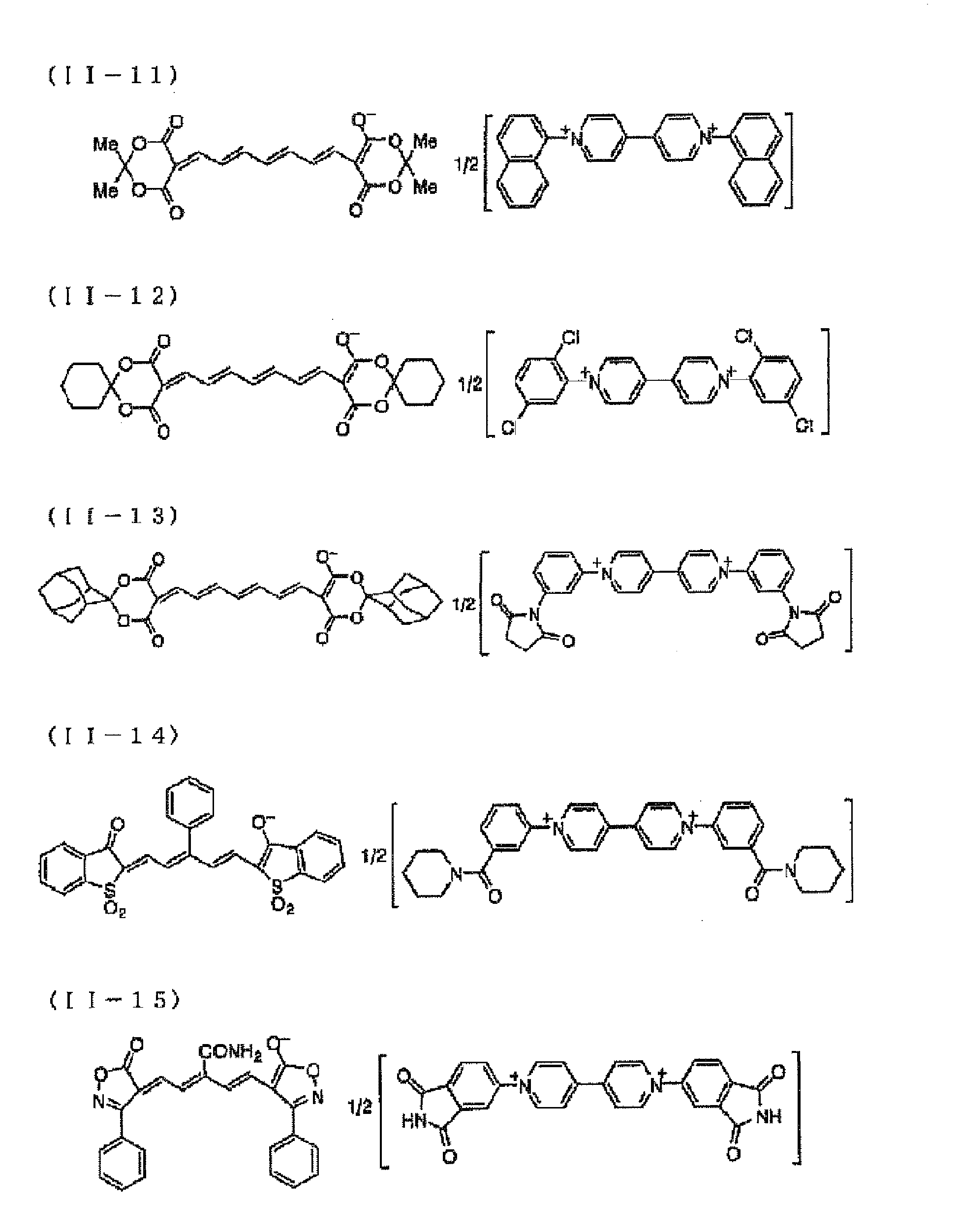

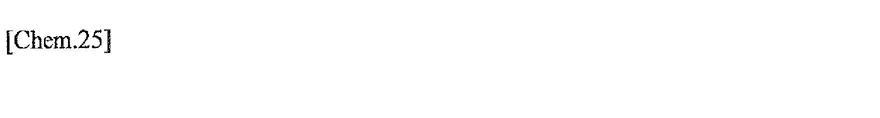

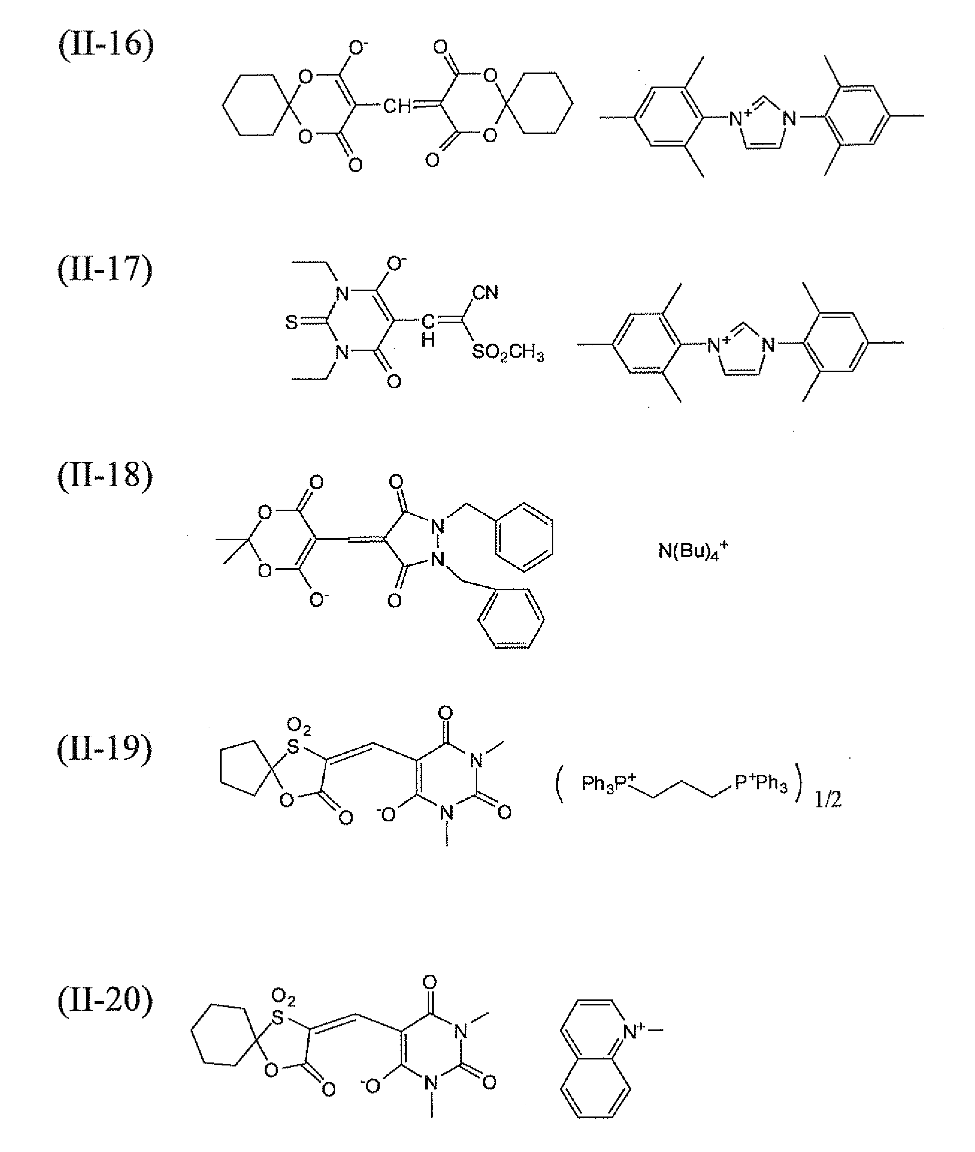

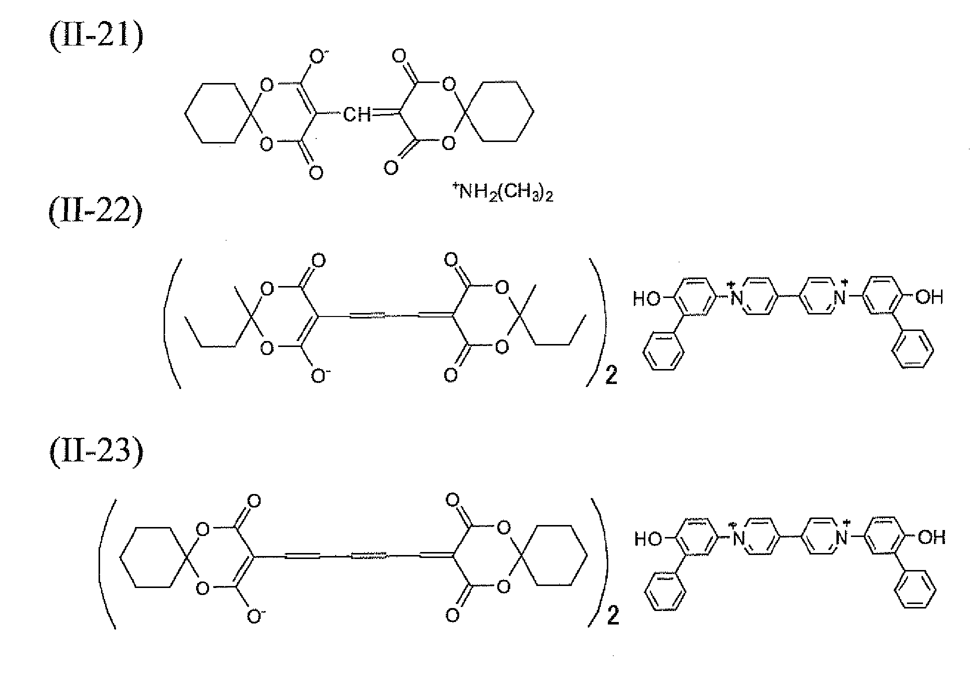

From the perspective of sensitivity during pattern exposure by laser, the thermal decomposition temperature of the compound for photoresist of the present invention in the form of a compound comprising an oxonol dye skeleton is desirably equal to or greater than 100°C but equal to or lower than 600°C; preferably equal to or higher than 100°C but equal to or lower than 500°C; more preferably equal to or higher than 120°C but equal to or lower than 400°C; and optimally equal to or higher than 150°C but equal to or lower than 300°C.

In the present invention, the thermal decomposition temperature refers to a value that is obtained by TG/DTA measurement. As a specific example, the temperature is raised at 10°C/minute over a range of 30°C to 550°C under an N₂ gas flow (flow rate: 200 mL/minute) with an EXSTAR6000 made by Seiko Instruments Inc., and the thermal decomposition temperature is obtained as the temperature when the mass reduction rate reaches 10 percent.

The compound for photoresist of the present invention in the form of a compound having an oxonol dye skeleton can be synthesized by known methods, and is in some cases available as a commercial product. The literature cited above by way of example as references describing specific examples of oxonol dyes can be consulted with respect to the synthesis method.

The compound for photoresist of the present invention can be a compound selected from the group consisting of a cyanine dye and a styryl dye. In the present invention, the term "cyanine dye" means a methine dye characterized in that the alternating conjugation system comprised of chromophores is terminated by a hetero atom having a positive charge, thereby causing the positive charge to be present in nonlocalized manner throughout the entire conjugated system. The term "styryl dye" means a dye having a structure in which a hetero atom having a positive charge and a carbon ring-type aromatic ring are bonded by a dimethine chain or a polymethine chain.

Among compounds selected from the group consisting of a cyanine dye and a styryl dye, from the perspective of light absorption characteristics, thermal decomposition characteristics, and the like, desirable examples of the compound for photoresist of the present invention are the cyanine dye denoted by general formula (IV) and the styryl dye denoted by general formula (V).

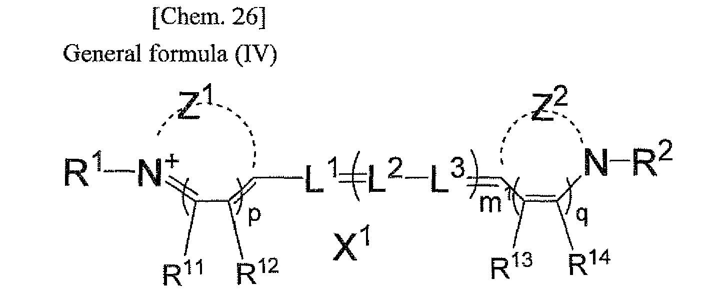

[In general formula (IV), each of Z¹ and 2² independently denotes a group of nonmetal atoms required to form an optionally condensed, five- or six-membered nitrogen-containing hetero ring, each of L¹, L², and L³ independently denotes a methine chain, m¹ denotes an integer ranging from 0 to 2, each of R¹ and R² independently denotes a substituent, plural L²s and L³s present may be identical or different when m¹ denotes 2; each of p and q independently denotes 0 or 1, each of R¹¹, R¹², R¹³, and R¹⁴ independently denotes a hydrogen atom or a substituent; and X¹ denotes a counter ion neutralizing a charge of the compound denoted by general formula (IV).]

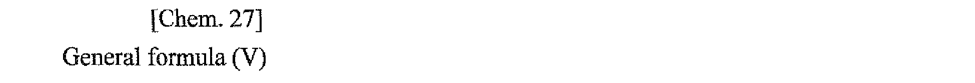

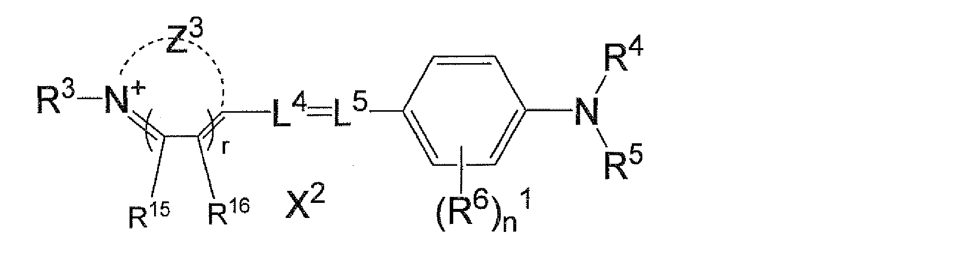

[In general formula (V), Z³ denotes a group of nonmetal atoms required to form an optionally condensed, five- or six-membered nitrogen-containing hetero ring, each of L⁴ and L⁵ independently denotes a methine chain, each of R³, R⁴, R⁵, and R⁶ independently denotes a substituent, n¹ denotes an integer ranging from 0 to 4, plural R⁶s present may be identical or different when n¹ is equal to or greater than 2; r denotes 0 or 1, each of R¹⁵ and R¹⁶ independently denotes a hydrogen atom or a substituent; and X² denotes a counter ion neutralizing a charge of the compound denoted by general formula (V).]

The compounds denoted by general formulas (IV) and (V) will be described below.

### General formula (IV)

In general formula (IV), each of Z¹ and Z² independently denotes a group of nonmetal atoms required to form an optionally condensed, five- or six-membered nitrogen-containing hetero ring, and each of p and q independently denotes 0 or 1. The nitrogen-containing hetero ring formed by Z¹ and Z² may be substituted or unsubstituted. The substituents are not specifically limited. Specific examples thereof are the examples of the substituent denoted by R¹ and R², described further below.

Specific examples of the above nitrogen-containing hetero ring are: when p or q is 0, benzothiazole, benzooxazole, benzoimidazole, indolenine, thiazole, thiazoline, oxazole, oxazoline, imidazole, imidazoline, 2-pyridinium, 2-quinolinium, and condensed rings thereof; when p or q is 1, 4-pyridinium, 4-quinolinium, and condensed rings thereof. Desirable examples are benzothiazole, benzooxazole, benzoimidazole, and indolenine; preferred examples are benzooxazole and indolenine; and an optimal example is indolenine.

Each of R¹ and R² independently denotes a substituent. Examples of desirable substituents are given below:
substituted or unsubstituted linear, branched chain, or cyclic alkyl groups having 1 to 18 carbon atoms (desirably, 1 to 8 carbon atoms) (such as methyl, ethyl, propyl, isopropyl, n-butyl, isobutyl, sec-butyl, t-butyl, cyclohexyl, methoxyethyl, ethoxycarbonylethyl, cyanoethyl, diethylaminoethyl, hydroxyethyl, chloroethyl, acetoxyethyl, and trifluoromethyl groups); alkenyl groups having 2 to 18 carbon atoms (desirably, 2 to 8 carbon atoms) (such as vinyl groups); alkynyl groups having 2 to 18 carbon atoms (desirably, 2 to 8 carbon atoms) (such as ethynyl groups); substituted or unsubstituted aryl groups having 6 to 18 carbon atoms (desirably, 6 to 10 carbon atoms) (such as phenyl, 4-methylphenyl, 4-methoxyphenyl, 4-carboxyphenyl, and 3,5-dicarboxyphenyl groups); substituted or unsubstituted aralkyl groups having 7 to 18 carbon atoms (desirably, 7 to 12 carbon atoms) (such as benzyl and carboxybenzyl groups); substituted or unsubstituted acyl groups having 2 to 18 carbon atoms (desirably, 2 to 8 carbon atoms) (such as acetyl, propionyl, butanoyl, and chloroacetyl groups); substituted or unsubstituted alkyl or arylsulfonyl groups having 1 to 18 carbon atoms (desirably, 1 to 8 carbon atoms) (such as methanesulfonyl and p-toluenesulfonyl groups); alkylsulfinyl groups having 1 to 18 carbon atoms (desirably, 1 to 8 carbon atoms) (such as methanesulfinyl, ethanesulfinyl, and octanesulfinyl groups); alkoxycarbonyl groups having 2 to 18 carbon atoms (desirably, 2 to 8 carbon atoms) (such as methoxycarbonyl, ethoxycarbonyl, and butoxycarbonyl groups); aryloxycarbonyl groups having 7 to 18 carbon atoms (desirably, 7 to 12 carbon atoms) (such as phenoxycarbonyl, 4-methylphenoxycarbonyl, and 4-methoxyphenylcarbonyl groups); substituted or unsubstituted alkoxy groups having 1 to 18 carbon atoms (desirably, 1 to 8 carbon atoms) (such as methoxy, ethoxy, n-butoxy, and methoxyethoxy groups); substituted or unsubstituted aryloxy groups having 6 to 18 carbon atoms (desirably, 6 to 10 carbon atoms) (such as phenoxy and 4-methoxyphenoxy groups); alkylthio groups having 1 to 18 carbon atoms (desirably 1 to 8 carbon atoms) (such as methylthio and ethylthio groups); arylthio groups having 6 to 10 carbon atoms (desirably, 1 to 8 carbon atoms) (such as phenylthio groups); substituted or unsubstituted acryloxy groups having 2 to 18 carbon atoms (desirably, 2 to 8 carbon atoms) (such as acetoxy, ethylcarbonyloxy, cyclohexylcarbonyloxy, benzoyloxy, and chloroacetyloxy groups); substituted or unsubstituted sulfonyloxy groups having 1 to 18 carbon atoms (desirably, 1 to 8 carbon atoms) (such as methanesulfonyloxy groups); substituted or unsubstituted carbamoyloxy groups having 2 to 18 carbon atoms (desirably 2 to 8 carbon atoms) (such as methylcarbamoyloxy and diethylcarbamoyloxy groups); unsubstituted amino groups or substituted amino groups having 1 to 18 carbon atoms (desirably 1 to 8 carbon atoms) (such as methylamino, dimethylamino, diethylamino, anilino, methoxyphenylamino, chlorophenylamino, pyridylamino, methoxycarbonylamino, n-butoxycarbonylamino, phenoxycarbonylamino, phenylcarbamoylamino, ethylthiocarbamoylamino, methylsulfamoylamino, phenylsulfamoylamino, ethylcarbonylamino, ethylthiocarbonylamino, cyclohexylcarbonylamino, benzoylamino, chloroacetylamino, methanesulfonylamino, and benzenesulfonylamino groups); amido groups having 1 to 18 carbon atoms (desirably, 1 to 8 carbon atoms) (such as acetamide, acetylmethylamide, and acetyloctylamide groups); substituted or unsubstituted ureido groups having 1 to 18 carbon atoms (desirably, 1 to 8 carbon atoms) (such as unsubstituted ureido groups, methylureido groups, ethylureido groups, and dimethylureido groups); substituted or unsubstituted carbamoyl groups having 1 to 18 carbon atoms (desirably 1 to 8 carbon atoms) (such as unsubstituted carbamoyl groups, methylcarbamoyl groups, ethylcarbamoyl groups, n-butylcarbamoyl groups, t-butylcarbamoyl groups, dimethylcarbamoyl groups, morpholinocarbamoyl groups, and pyrrolidinocarbamoyl groups); unsubstituted sulfamoyl groups or substituted sulfamoyl groups having 1 to 18 carbon atoms (desirably, 1 to 8 carbon atoms) (such as methylsulfamoyl and phenylsulfamoyl groups); halogen atoms (such as fluorine, chlorine, and bromine atoms); hydroxyl groups; mercapto groups; nitro groups; cyano groups, carboxyl groups; sulfo groups; phosphono groups (such as diethoxyphosphono groups); and heterocyclic groups (such as oxazole rings, benzooxazole rings, thiazole rings, benzothiazole rings, imidazole rings, benzoimidazole rings, indolenine rings, pyridine rings, morpholine rings, piperidine rings, pyrrolidine rings, sulfolane rings, furan rings, thiophene rings, pyrazole rings, pyrrole rings, chroman rings, and coumarin rings).

R¹ and R² are desirably alkyl groups having 1 to 18 carbon atoms, and optimally, methyl groups.

Each of R¹¹, R¹², R¹³, and R¹⁴ independently denotes a hydrogen atom or a substituent. When R¹¹, R¹², R¹³, or R¹⁴ denotes a substituent, the substituent is not specifically limited. Examples of these substituents are the examples given for the substituents denoted by R¹ and R².

In general formula (IV), each of L¹, L², and L³ independently denotes a methine chain. The methine chain may be substituted. Examples of substituents are those given by way of example for the substituents denoted by R¹ and R². The absence of substituents is desirable.

m¹ denotes an integer falling within a range of 0 to 2. When m denotes 2, plural L²s and L³s present may be identical or different, m¹ is desirably 0 or 1, and is optimally 0.

X¹ denotes a counter ion that neutralizes the charge of the compound denoted by general formula (IV). Whether a given dye is a cation or an anion, and whether or not it possesses a net ion charge, depends on auxochromes and substituents. When the substituent comprises a dissociative group, it may dissociate and hold a negative charge. In that case, as well, the overall charge of the molecule is neutralized by X¹. Typical cations include inorganic and organic ammonium ions (such as tetraalkylammonium ions and pyridinium ions) and alkali metal ions. On the other hand, anions may be inorganic anions or organic anions, such as halogen anions (such as fluoride ions, chloride ions, bromide ions, and iodide ions), substituted arylsulfonic acid ions (such as p-toluenesulfonic acid ions and p-chlorobenzenesulfonic acid ions), aryldisulfonic acid ions (such as 1,3-benzenedisulfonic acid ions, 1,5-naphthalenedisulfonic acid ions, and 2,6-naphthalenedisulfonic acid ions), alkyl sulfuric acid ions (such as methyl sulfate ions), sulfuric acid ions, thiocyanic acid ions, perchloric acid ions, tetrafluoroboric acid ions, picric acid ions, acetic acid ions, and trifluoromethanesulfonic acid ions.
Charge-equilibrating counter ions in the form of ionic polymers or other dyes having the opposite charge of the dye may be employed. Metal complex ions (such as bisbenzene-1,2-dithiolate nickel (III) and azo dye chelate compounds) may also be possible.

### General formula (V)

In general formula (V), Z³ denotes a group of nonmetal atoms required to form an optionally condensed, five- or six-membered nitrogen-containing hetero ring. r denotes 0 or 1. The details of specific examples of nitrogen-containing hetero rings formed with Z³ are identical to those of the nitrogen-containing hetero rings formed with Z¹ and Z² in general formula (IV). Each of R¹⁵ and R¹⁶ independently denotes a hydrogen atom or a substituent. The substituent is not specifically limited when R¹⁵ or R¹⁶ denotes a substituent, and when Z³ comprises a substituent. Examples of these substituents are the substituents given by way of example for substituents denoted by R¹ and R².

Each of R³, R⁴, R⁵, and R⁶ independently denotes a substituent. The details of specific examples of R³ to R⁶ are the same as those for R¹ and R² in general formula (IV).

n¹ denotes an integer falling within a range of 0 to 4. When n^{l} is equal to or greater than 2, plural R⁶s present may be identical or different. n¹ is desirably 0.

In general formula (V), each of L⁴ and L⁵ independently denotes a methine chain. The methine chain may comprise a substituent. Examples of the substituent are those given by way of example for the substituents denoted by R¹ and R² in general formula (IV). The absence of substituents is desirable.

X² denotes a counter ion that neutralizes the charge of the compound denoted by general formula (V). The details of X², such as specific examples, are identical to those of X¹ in general formula (IV).

Specific examples of the compound for photoresist of the present invention in the form of cyanine dyes and styryl dyes are the cyanine dyes described in Japanese Unexamined Patent Publication (KOKAI) No. 2001-232945 and the styryl dyes described in Japanese Unexamined Patent Publication (KOKAI) No. 2002-74740. Some of these compounds will be given by way of example below. IV-1 to IV-65 are specific examples of cyanine dyes and V-1 to V-10 are specific examples of styryl dyes.

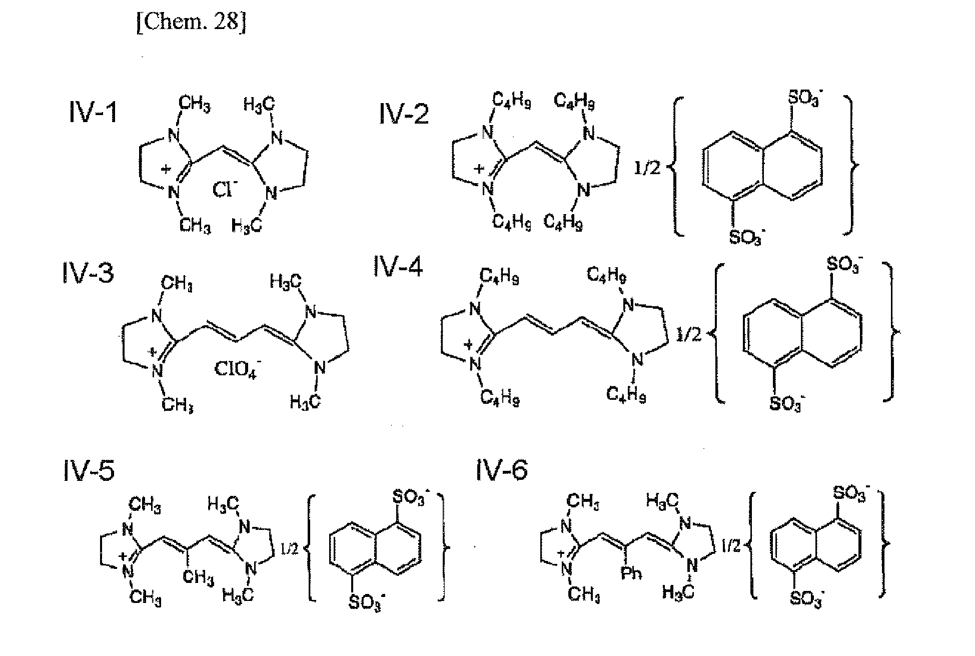

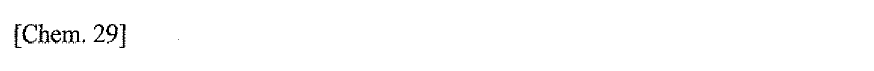

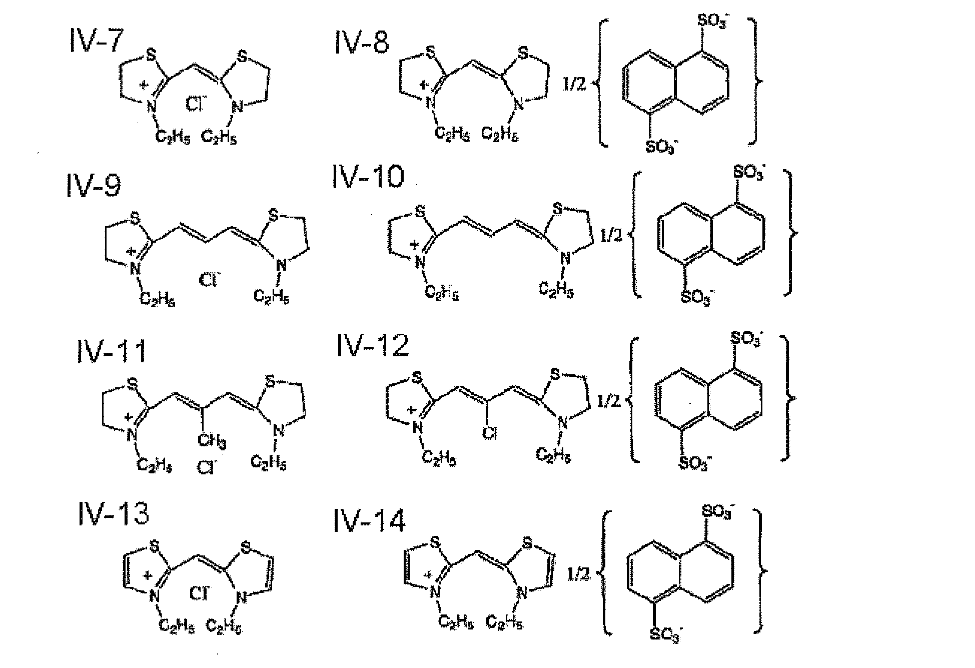

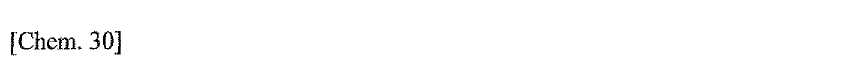

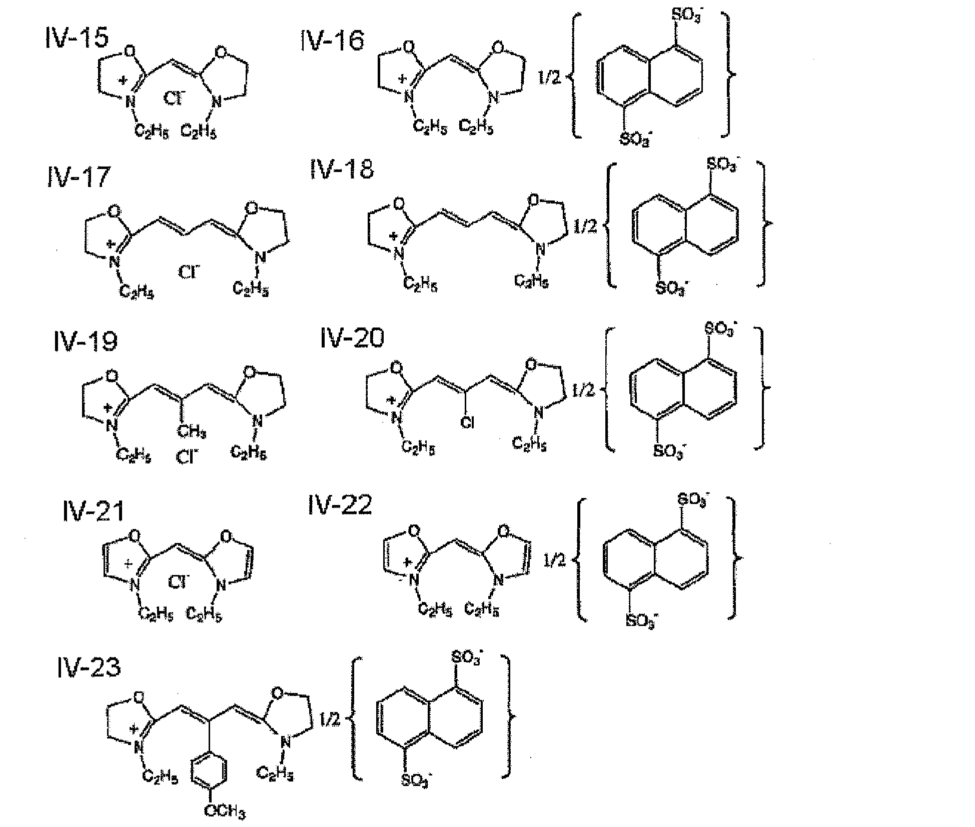

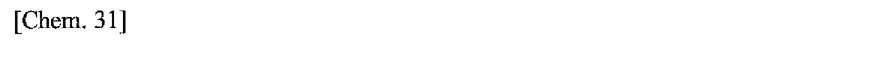

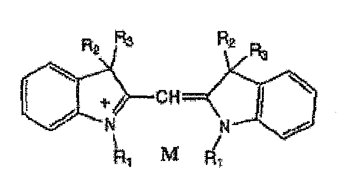

| No. | R1 | R2 | R3 | M |
|---|---|---|---|---|
| IV-24 | CH₃ | CH₃ | CH₃ | Cl⁻ |
| IV-25 | CH₃ | CH₃ | CH₃ | 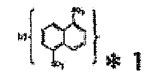 |
| IV-26 | CH₃ | CH₃ | CH₃ | 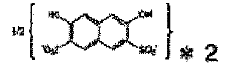 |
| IV-27 | C₂H₅ | CH₃ | CH₃ | 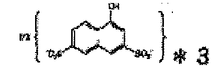 |
| IV-28 | C₄H₉ | CH₃ | CH₃ | 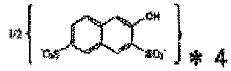 |
| IV-29 | C₄H₃ | CH₃ | CH₃ | 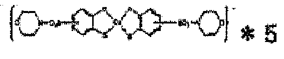 |

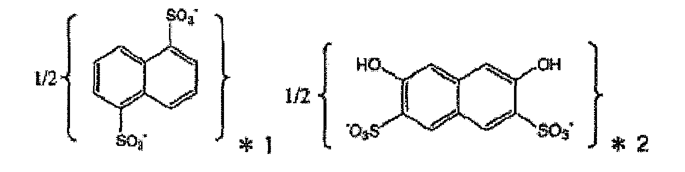

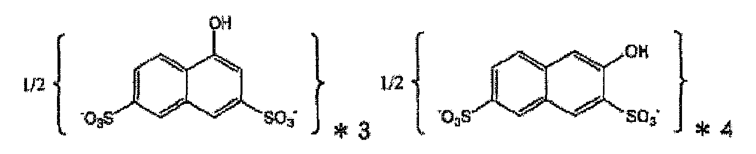

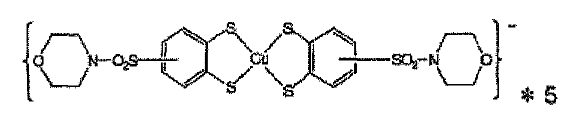

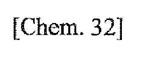

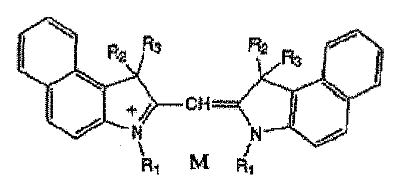

| No. | R1 | R2 | R3 | M |
|---|---|---|---|---|
| IV-30 | CH₃ | CH₃ | CH₃ | Cl⁻ |
| IV-31 | CH₃ | CH₃ | CH₃ | 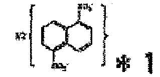 |
| IV-32 | CH₃ | CH₃ | CH₃ | 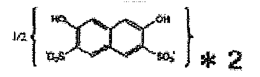 |
| IV-33 | C₂H₅ | CH₃ | CH₃ | 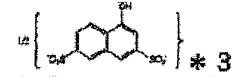 |
| IV-34 | C₄H₉ | CH₃ | CH₃ | ClO₄⁻ |
| IV-35 | C₄H₉ | CH₃ | CH₃ | 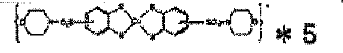 |

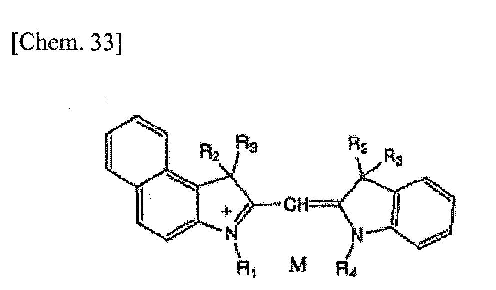

| No. | R1 | R2 | R3 | R4 | M |
|---|---|---|---|---|---|
| IV-36 | C₄H₉ | CH₃ | CH₃ | CH₃ | 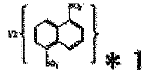 |
| IV-37 | CH₃ | CH₃ | CH₃ | CH₃ | 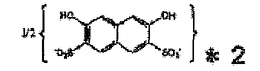 |
| IV-38 | C₄H₉ | CH₃ | CH₃ | C₄H₉ | 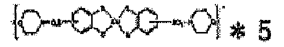 |
| IV-30 | C₄H₉ | C₂H₅ | CH₃ | C₄H₉ | BF₄⁻ |

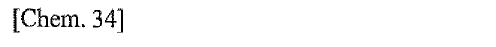

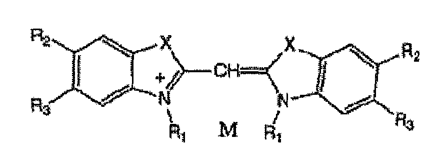

| No. | R1 | R2 | R3 | K | M |
|---|---|---|---|---|---|
| IV-40 | CH₃ | H | H | 0 | I⁻ |
| IV-41 | CH₃ | Br | H | 0 | 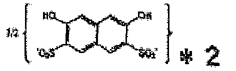 |
| IV-42 | C₄H₉ | CH₃ | H | 0 | 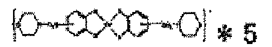 |
| IV-43 | CH₃ | H | H | S | I⁻ |
| IV-44 | CH₃ | H | H | S | 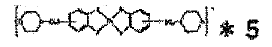 |
| IV-45 | CH₃ | H | Cl | S | 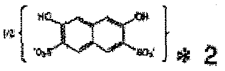 |
| IV-46 | C₄H₉ | H | H | S | 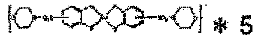 |
| IV-47 | CH₃ | 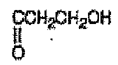 | H | S | I⁻ |
| IV-48 | CH₃ | H | H | 0 | 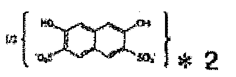 |
| IV-49 | CH₃ | H | H | S | 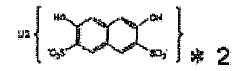 |
| IV-50 | CH₃ | Cl | Cl | 0 | 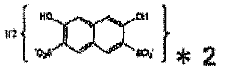 |

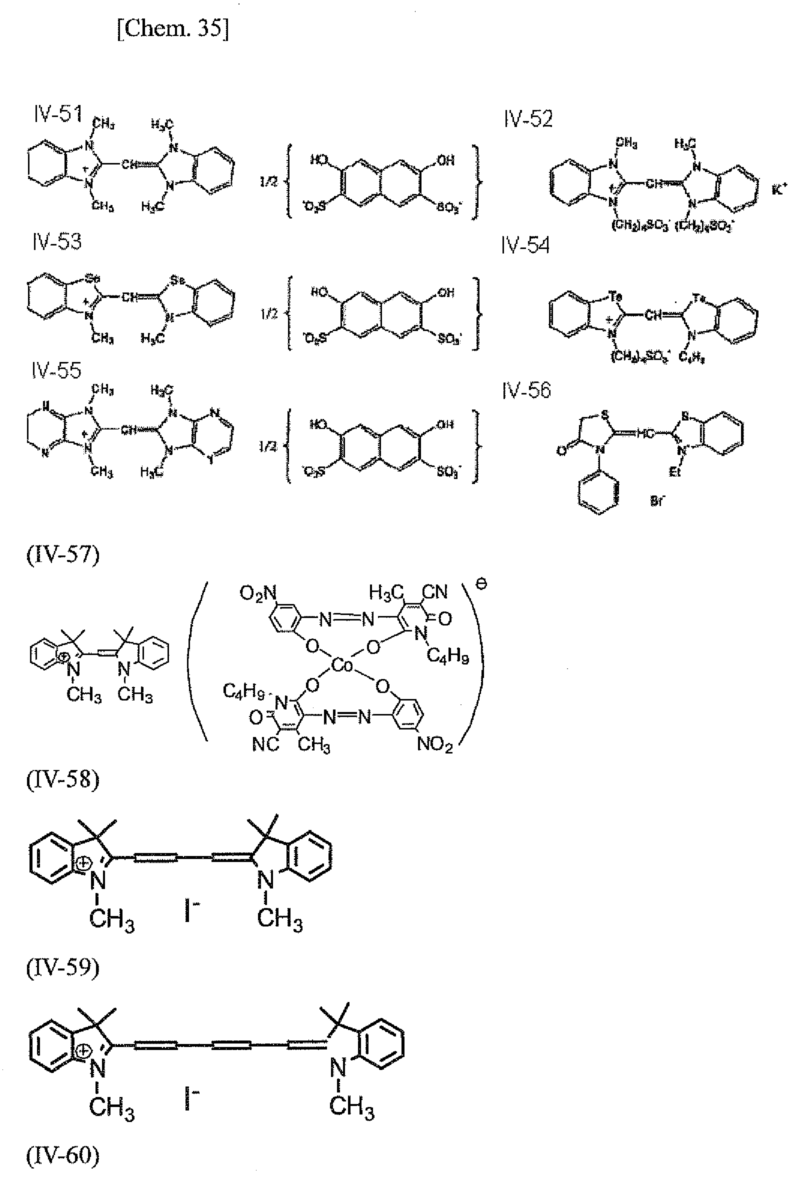

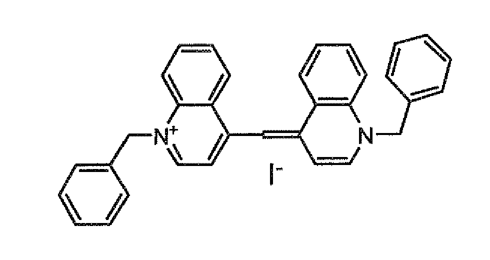

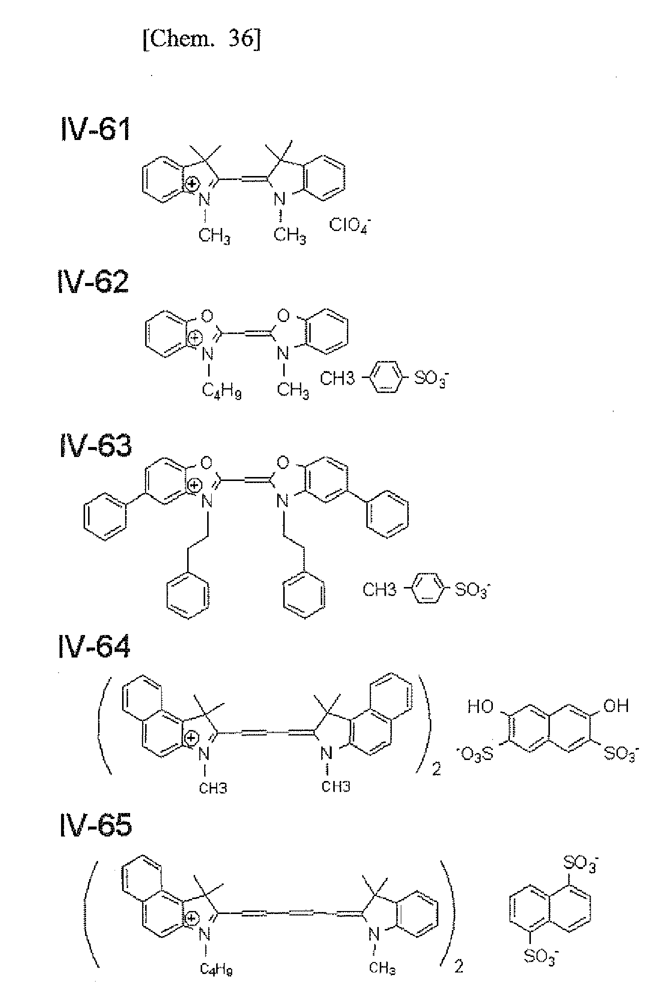

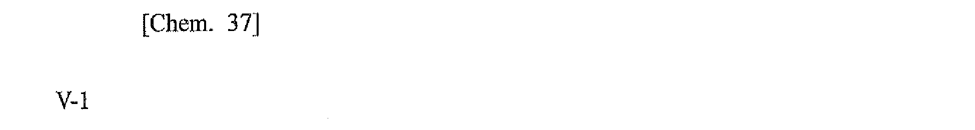

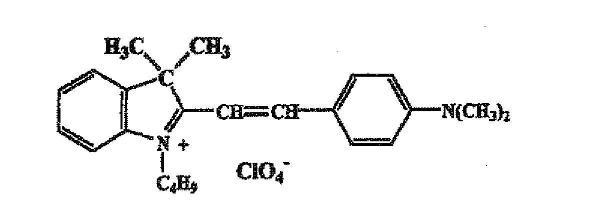

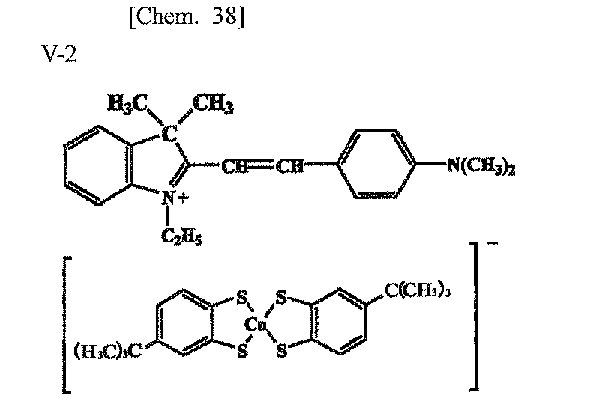

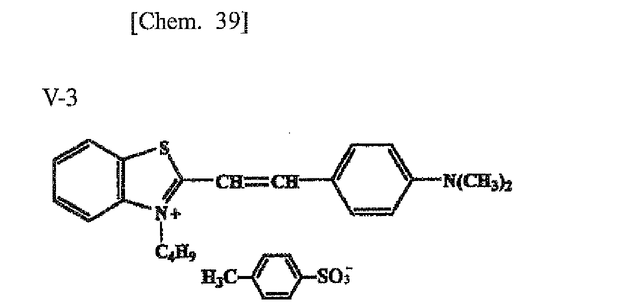

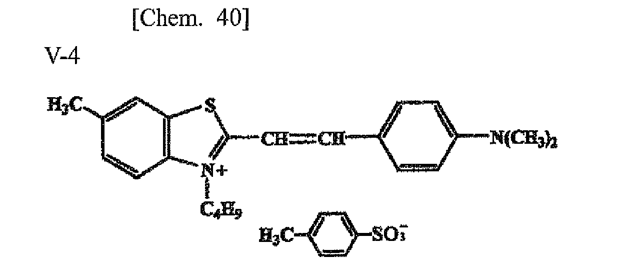

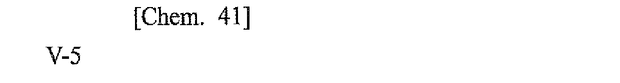

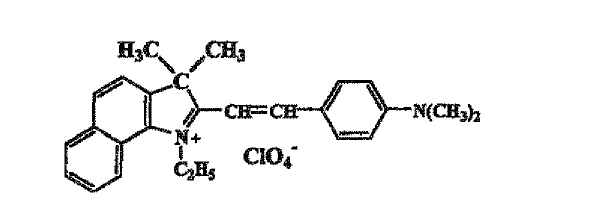

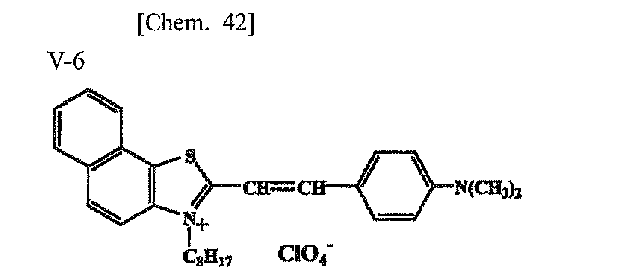

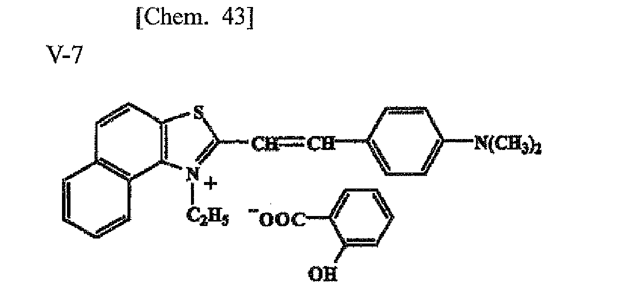

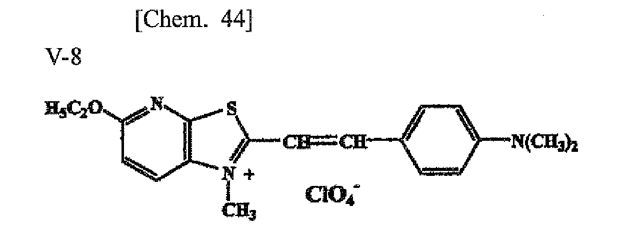

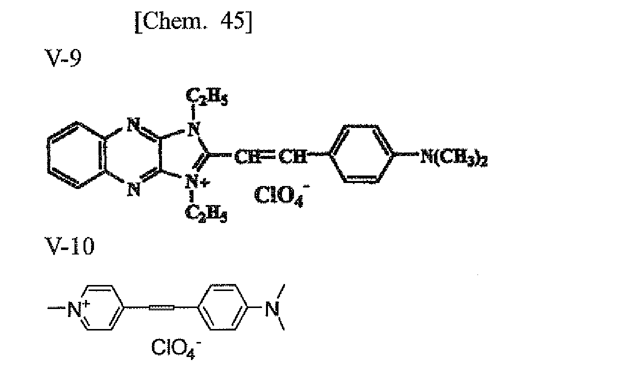

From the perspective of sensitivity during pattern exposure by laser, the thermal decomposition temperature of the compound for photoresist of the present invention in the form of a cyanine dye or styryl dye is desirably equal to or higher than 100°C but equal to or lower than 600°C, preferably equal to or higher than 120°C but equal to or lower than 550°C, and optimally equal to or higher than 150°C but equal to or lower than 500°C.

The compound for photoresist of the present invention in the form of a cyanine dye or styryl dye can be synthesized by known methods, and in some cases, commercial products are available.

The compound for photoresist of the present invention can also be a compound comprising a merocyanine dye skeleton. In the present invention, the term "merocyanine dye skeleton" means a dye skeleton having an electrically neutral methine chromophore.

Among compounds comprising a merocyanine dye skeleton, the merocyanine dyes denoted by general formula (VI) below are examples of merocyanine dyes that are desirable from the perspective of light absorption characteristics, thermal decomposition characteristics, and the like.

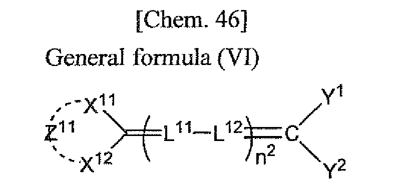

In general formula (VI), Z¹¹ denotes a group of atoms forming a five- or six-membered hetero ring with X¹¹ and X¹². Each of X¹¹ and X¹² independently denotes a carbon atom or a hetero atom. However, at a minimum, either X¹¹ or X¹² denotes a hetero atom. Nitrogen atoms or sulfur atoms are desirable as hetero atoms.

Examples of hetero rings formed by Z¹¹, X¹¹, and X¹² are thiazoline rings, oxazoline rings, dithiol rings, imidazoline rings, benzo-condensed rings thereof, or rings having the structures indicated below.

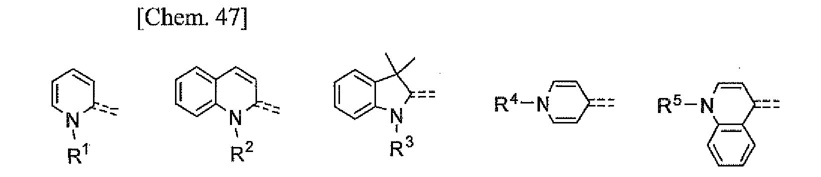

In the above, each of R¹ to R⁵ independently denotes a substituent. The substituents are not specifically limited. Examples are the substituents described further below as substituents that can be present on hetero rings.

Of the above, desirable hetero rings are thiazoline rings, oxazoline rings, dithiol rings, imidazoline rings, and benzo-condensed rings thereof. Optimal hetero rings are benzothiazoline rings, benzooxazoline rings, benzodithiol rings, or benzoimidazoline rings. These can be further condensed with other aromatic rings.

The above hetero ring may comprise substituents other than hydrogen atoms. Examples of desirable substituents are alkyl groups having 1 to 20 carbon atoms, aryl groups having 6 to 14 carbon atoms, aralkyl groups having 7 to 15 carbon atoms, heterocyclic groups having 1 to 10 carbon atoms, alkoxy groups having 1 to 20 carbon atoms, aryloxy groups having 6 to 14 carbon atoms, alkylsulfenyl groups having 1 to 20 carbon atoms, arylsulfenyl groups having 6 to 14 carbon atoms, alkylsulfonyl groups having 1 to 20 carbon atoms, arylsulfonyl groups having 6 to 14 carbon atoms, acyl groups having 2 to 21 carbon atoms, carbamoyl groups having 1 to 25 carbon atoms, sulfamoyl groups having 0 to 32 carbon atoms, alkoxycarbonyl groups having 1 to 20 carbon atoms, aryloxycarbonyl groups having 7 to 15 carbon atoms, acylamino groups having 2 to 21 carbon atoms, sulfonylamino groups having 1 to 20 carbon atoms, amino groups having 0 to 32 carbon atoms, cyano groups, nitro groups, hydroxy groups, carboxy groups, sulfo groups, and halogen atoms. Examples of preferred substituents are alkyl groups having 3 to 16 carbon atoms, aryl groups having 6 to 10 carbon atoms, alkoxy groups having 3 to 16 carbon atoms, and aryloxy groups having 6 to 10 carbon atoms.

In general formula (VI), each of Y¹ and Y² independently denotes a substituent. At a minimum, either Y¹ or Y² denotes a cyano group, alkylcarbonyl group, arylcarbonyl group, alkoxycarbonyl group, aryloxycarbonyl group, aminocarbonyl group, alkylsulfone group, arylsulfone group, alkylsulfonyl group, arylsulfonyl group, or aminosulfonyl group. Additional examples of substituents are those given by way of example as substituents that can be present in hetero rings.

Each of Y¹ and Y² desirably independently denotes a cyano group, alkylcarbonyl group, arylcarbonyl group, alkoxycarbonyl group, aryloxycarbonyl group, aminocarbonyl group, alkylsulfone group, arylsulfone group, alkylsulfonyl group, arylsulfonyl group, or aminosulfonyl group. Y¹ and Y² desirably denote cyano groups, alkylcarbonyl groups, arylcarbonyl groups, alkoxycarbonyl groups, aryloxycarbonyl groups, or aminocarbonyl groups. When Y¹ and Y² denote alkylcarbonyl groups, arylcarbonyl groups, alkoxycarbonyl groups, aryloxycarbonyl groups, aminocarbonyl groups, alkylsulfone groups, arylsulfone groups, alkylsulfonyl groups, arylsulfonyl groups or aminosulfonyl groups, they may further comprise substituents. Examples of the substituents are alkyl groups having 1 to 20 carbon atoms, aryl groups having 6 to 14 carbon atoms, aralkyl groups having 7 to 15 carbon atoms, heterocyclic groups having 1 to 10 carbon atoms, alkoxy groups having 1 to 20 carbon atoms, aryloxy groups having 6 to 14 carbon atoms, alkylsulfenyl groups having 1 to 20 carbon atoms, arylsulfenyl groups having 6 to 14 carbon atoms, alkylsulfonyl groups having 1 to 20 carbon atoms, arylsulfonyl groups having 6 to 14 carbon atoms, acyl groups having 2 to 21 carbon atoms, carbamoyl groups having 1 to 25 carbon atoms, sulfamoyl groups having 0 to 32 carbon atoms, alkoxycarbonyl groups having 1 to 20 carbon atoms, aryloxycarbonyl groups having 7 to 15 carbon atoms, acylamino groups having 2 to 21 carbon atoms, sulfonylamino groups having 1 to 20 carbon atoms, amino groups having 0 to 32 carbon atoms, cyano groups, nitro groups, hydroxy groups, carboxy groups, sulfo groups, and halogen atoms. Desirable examples are alkyl groups having 3 to 16 carbon atoms and aryl groups having 6 to 10 carbon atoms.

Y¹ and Y² may be linked together to form a ring. Examples of the ring that is formed are the above exemplified ring structures A-1 to A-64. Desirable rings are A-8, A-9, A-10, A-11, A-12, A-13, A-14, A-16, A-17, A-36, A-39, A-41, A-54, and A-57. Preferred rings are A-2, A-8, A-9, A-10, A-13, A-14, A-16, A-17, and A-57. Optimal rings are A-2 and A-9.

In general formula (VI), each of L¹¹ and L¹² independently denotes a methine group. The methine group may be substituted. Examples of the substituent are the above substituents given by way of example of substituents that may be present on the hetero ring.

In general formula (VI), n² denotes an integer falling within a range of 0 to 2. From the perspective of wavelength suitability, 0 or 1 is desirable, and 0 is optimal.

The compounds denoted by general formula (VI) may be bonded at any position to form a polymer; in that case, the various units may be identical or different, and may be bonded to polymer chains such as polystyrene, polymethacrylate, polyvinylalcohol, and cellulose.

The compound denoted by general formula (VI) may have a charge or may be neutral. Whether the compound denoted by general formula (VI) is a cation or an anion, and whether or not it possesses a net ion charge, depends on auxochromes and substituents. When the substituent comprises a dissociative group, it may dissociate and hold a negative charge. In that case, as well, the overall charge of the molecule is neutralized by a counter ion. Typical counter ions in the form of cations include inorganic and organic ammonium ions (such as tetraalkylammonium ions and pyridinium ions) and alkali metal ions. On the other hand, anions may be inorganic anions or organic anions, such as halogen anions (such as fluoride ions, chloride ions, bromide ions, and iodide ions), substituted arylsulfonic acid ions (such as p-toluenesulfonic acid ions and p-chlorobenzenesulfonic acid ions), aryldisulfonic acid ions (such as 1,3-benzenedisulfonic acid ions, 1,5-naphthalenedisulfonic acid ions, and 2,6-naphthalenedisulfonic acid ions), alkylsulfuric acid ions (such as methyl sulfate ions), sulfuric acid ions, thiocyanic acid ions, perchloric acid ions, tetrafluoroboric acid ions, picric acid ions, acetic acid ions, and trifluoromethanesulfonic acid ions.
Charge-equilibrating counter ions in the form of ionic polymers or other dyes having the opposite charge of the dye may be employed. Metal complex ions (such as bisbenzene-1,2-dithiolate nickel (III)) may also be possible.

Specific desirable examples of the compound denoted by general formula (VI) are given below, but the present invention is not limited thereto.

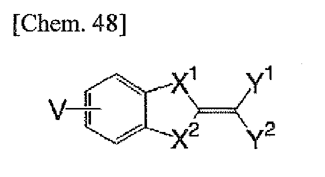

| Compound | X¹ | X² | V | Y¹ | Y² |
|---|---|---|---|---|---|
| S-1 | S | S | H | COCH₂CH(CH₃)₂ | COCH₃ |
| S-2 | S | S | H | COCH₂CH(CH₃)₂ | CN |
| S-3 | S | S | H | CONH₂ | CONH₂ |
| S-4 | S | S | 4,7-OCH(CH₃)₂ | CN | CN |
| S-5 | S | S | 4,7-OCH₂CH₃ | CN | CO₂CH₂CH₃ |
| S-6 | S | S | 4,7-OH | CN | CO₂OH₂OH₃ |
| S-7 | S | N-CH₂CH₃ | H | CN | CO₂CH₃ |
| S-8 | S | N-CH₂CH(CH₃)₂ | H | CO₂CH₃ | CO₂CH₃ |
| S-9 | S | N-CH₂OH(CH₃)₂ | 5-OCH₃ | COCH₂CH₃ | COCH₂CH₃ |
| S-10 | S | N-CH₂CH₂CH₃ | H | CON(CH₂CH₃)₂ | CON(CH₂CH₃)₂ |
| S-11 | O | N-CH₂CH₃ | 4,7-O(CH₂)₂CH₃ | COCH₃ | COCH₃ |
| S-12 | O | N-CH₂CH₃ | 4,5-benzo | CONH₂ | CONH₂ |
| S-13 | N-CH₂CH₃ | N-CH₂GH₃ | 5,6-benzo | CN | CO₂CH(CH₃)₂ |
| S-14 | N-CH₂CH₂CH₃ | N-CH₂CH₂CH₃ | 5-SCH₃ | CN | CN |
| S-15 | S | S | 4,7-OCH₃ | CN | CF₃ |

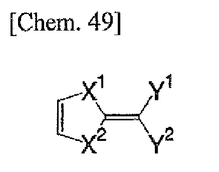

| Compound | X₁ | X₂ | Y₁ | Y₂ |
|---|---|---|---|---|
| S-16 | S | S | CN | CN |
| S-17 | S | N-CH₂CH₃ | CN | CO₂CH₂CH₃ |
| S-18 | O | N-CH₃ | CO₂CH₃ | CO₂CH₃ |
| S-19 | N-CH₂CH₃ | N-CH₂CH₃ | COCH₂CH₂CH₃ | COCH₃ |
| S-20 | S | S | CN | CF₃ |

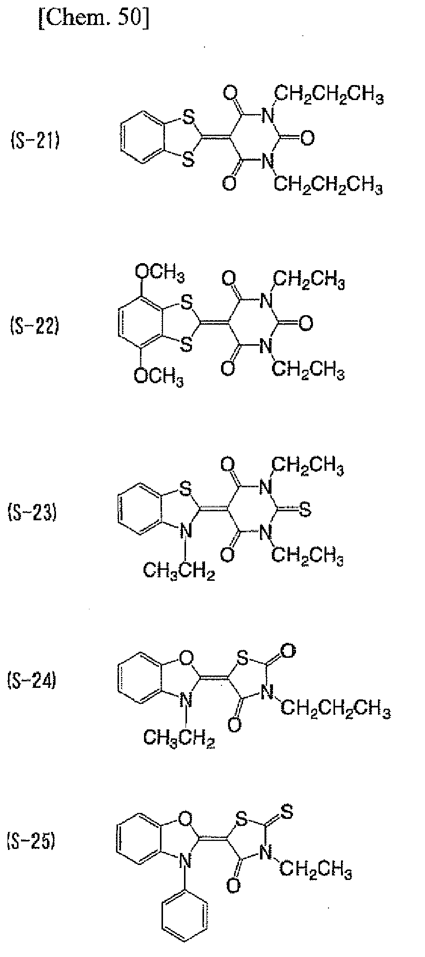

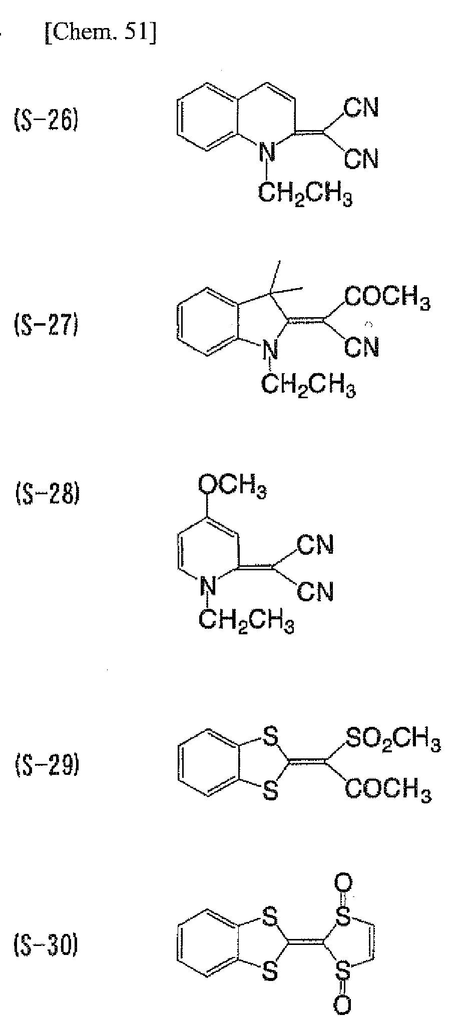

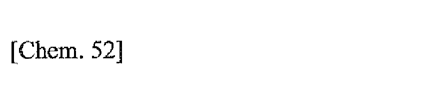

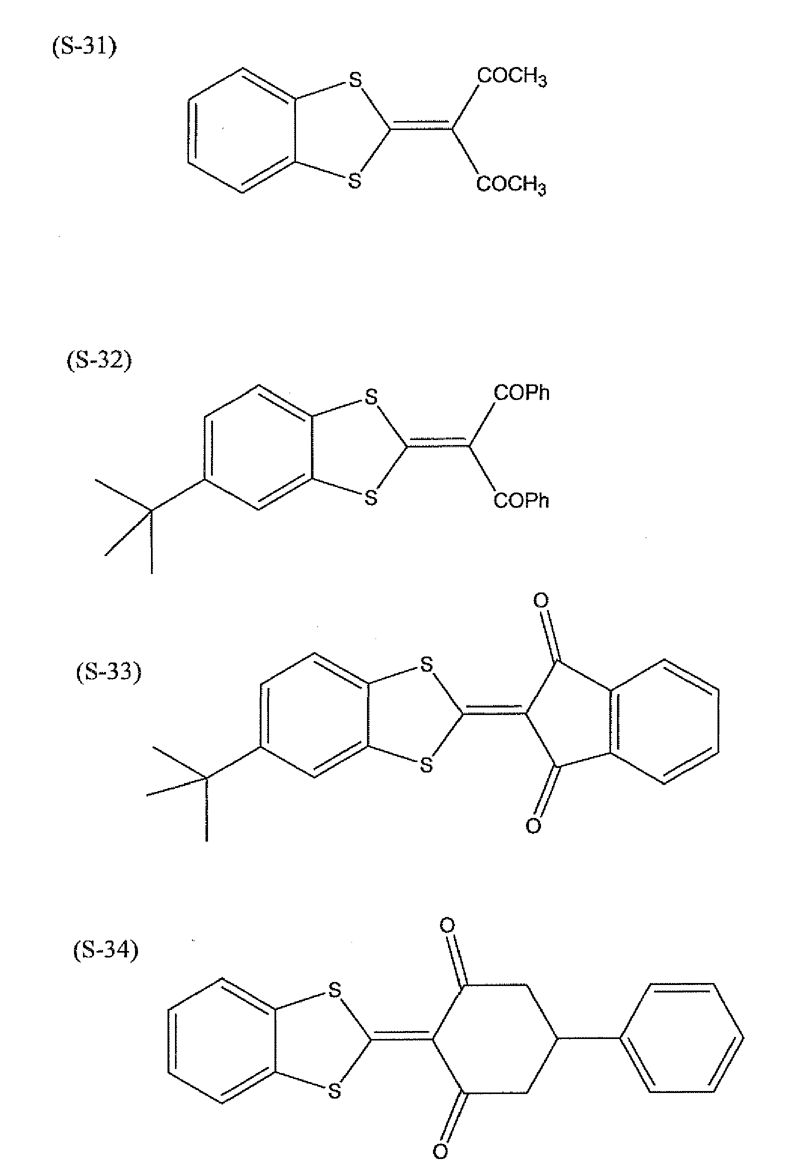

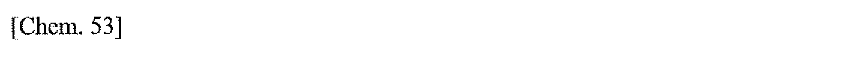

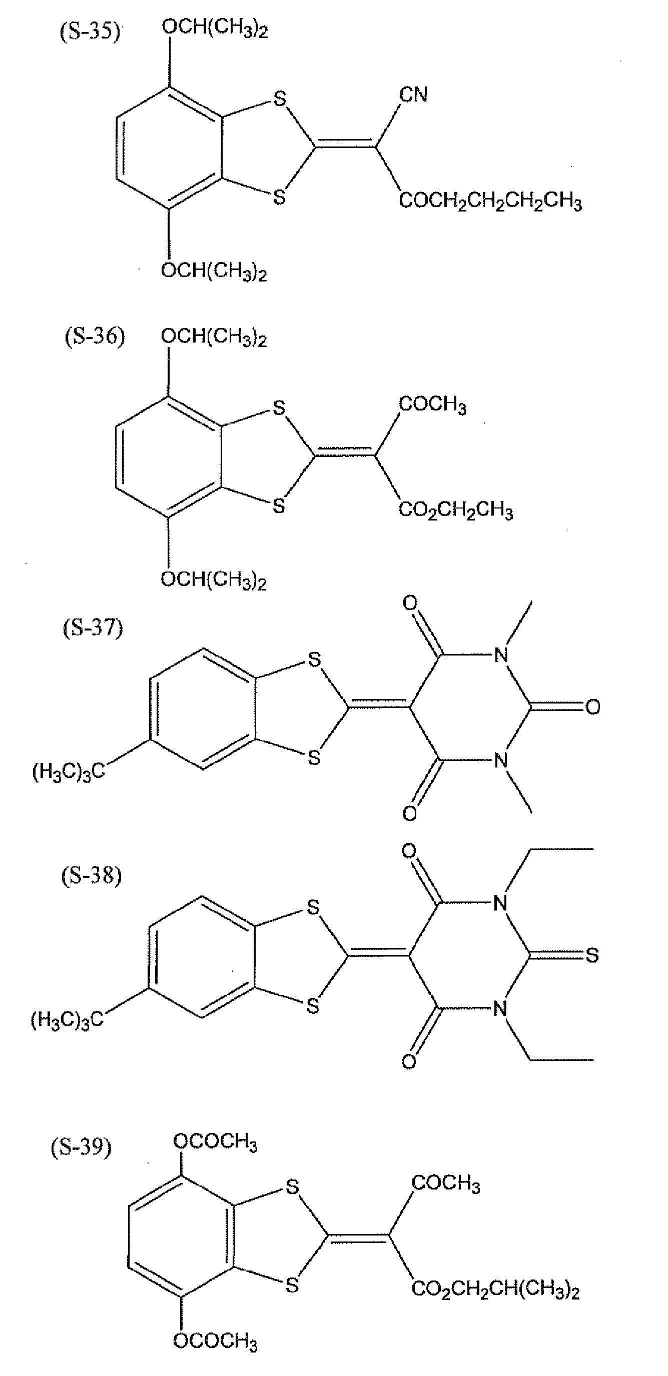

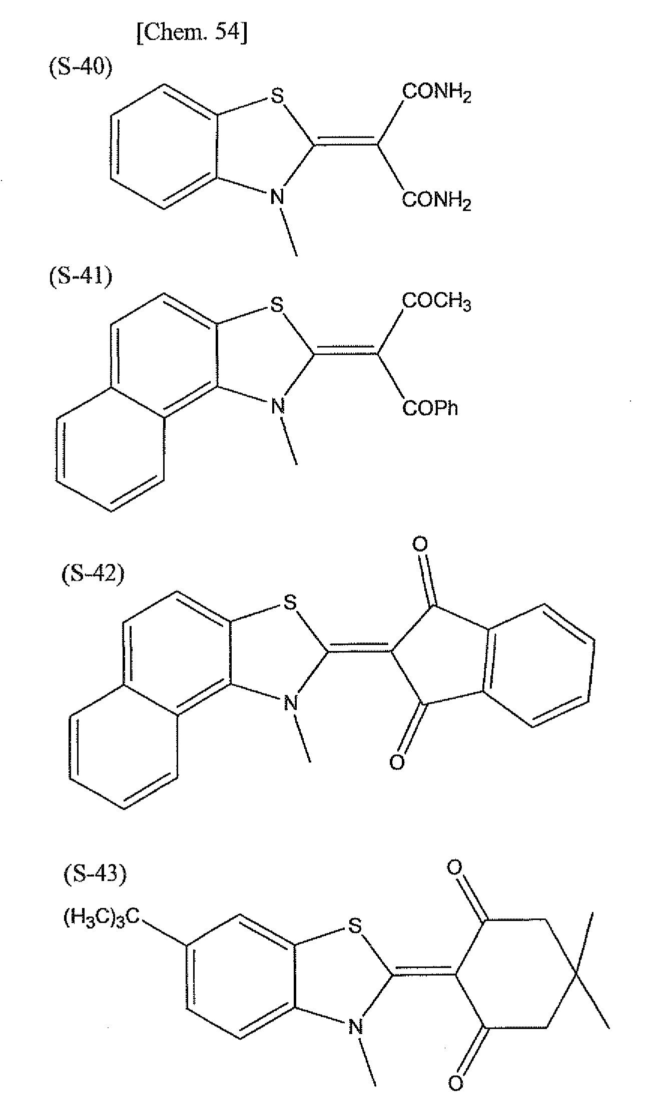

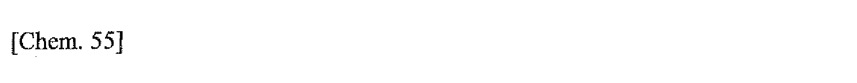

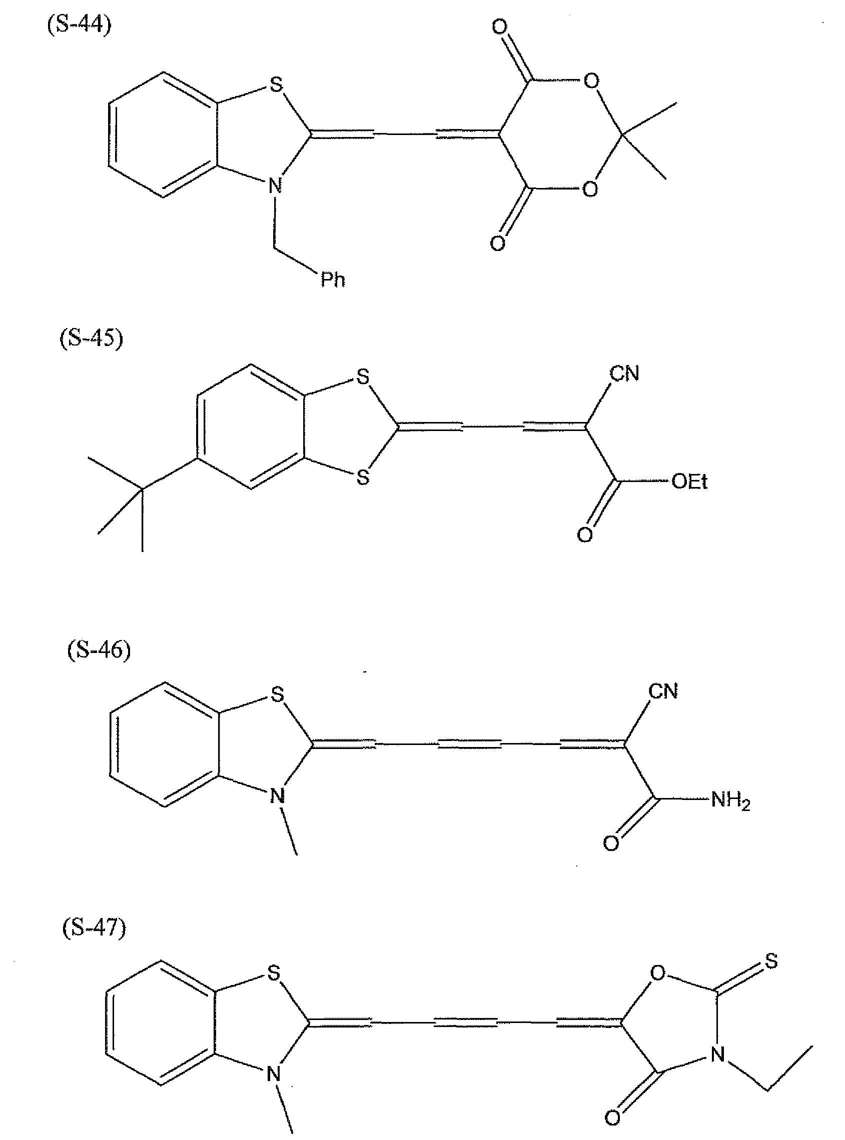

The compound for photoresist of the present invention in the form of a compound having a merocyanine dye skeleton can be synthesized by known methods, and in some cases, commercial products are available. For example, the compound denoted by general formula (VI) can be synthesized by methods that are described, cited, or similar to those set forth in F. M. Harmer, Heterocyclic Compounds - Cyanine Dyes and Related Compounds, John Wiley & Sons, New York, London, published in 1964; D. M. Sturmer, Heterocyclic Compounds - Special topics in heterocyclic chemistry, Chapter 18, Section 14, pp. 482-515, John Wiley & Sons, New York and London, published in 1977; Rodd's Chemistry of Carbon Compounds, 2nd Ed., Vol. IV, Part B, published in 1977, Chapter 15, pp. 369-422, published by Elsevier Science Publishing Company, Inc., New York; British Patent No. 1,077,611; and the like, which are expressly incorporated herein by reference in their entirety.

From the perspective of sensitivity during pattern exposure by laser, the thermal decomposition temperature of the compound for photoresist of the present invention in the form of a compound having a merocyanine dye structure is desirably equal to or higher than 100°C but equal to or lower than 600°C, preferably equal to or higher than 100°C but equal to or lower than 600°C, more preferably equal to or higher than 120°C but equal to or lower than 550°, and optimally, equal to or higher than 150°C but equal to or lower than 500°C.

The compound for photoresist of the present invention can be a compound comprising a phthalocyanine dye skeleton. Among compounds comprising a phthalocyanine dye skeleton, from the perspectives of light absorption characteristics, thermal decomposition characteristics, and the like, the phthalocyanine dye denoted by general formula (VII) below is an example of a desirable phthalocyanine dye.

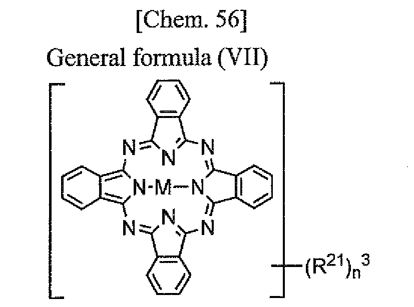

In general formula (VII), R²¹ denotes a substituent. Examples of the substituent are those given by way of example as R^{α1} to R^{α9} and R^{β1} to R^{β8} in general formula (VIII), described further below.

n³ denotes an integer falling within a range of 1 to 8, desirably 1 to 6, and preferably, 1 to 4. When n³ is an integer of equal to or greater than 2, plural R²¹s present may be identical to or different from each other.

M denotes two hydrogen atoms, a divalent to tetravalent metal atom, a divalent to tetravalent oxymetal atom, or a divalent to tetravalent metal atom comprising a ligand. Specific examples and desirable examples thereof are those set forth further below for general formula (VIII).

An example of a desirable embodiment of the phthalocyanine dye denoted by general formula (VII) is the phthalocyanine dye denoted by general formula (VIII) below.

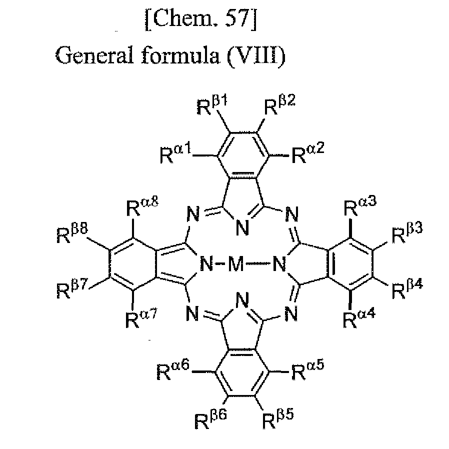

In general formula (VIII), each of R^{α1} to R^{α8} and R^{β1} to R^{β8} independently denotes a hydrogen atom, halogen atom, cyano group, nitro group, formyl group, carboxyl group, sulfo group, substituted or unsubstituted alkyl group having 1 to 20 carbon atoms, substituted or unsubstituted aryl group having 6 to 14 carbon atoms, substituted or unsubstituted heterocyclic group having 1 to 10 carbon atoms, substituted or unsubstituted alkoxy group having 1 to 20 carbon atoms, substituted or unsubstituted aryloxy group having 6 to 14 carbon atoms, substituted or unsubstituted acyl group having 2 to 21 carbon atoms, substituted or unsubstituted alkylsulfonyl group having 1 to 20 carbon atoms, substituted or unsubstituted arylsulfonyl group having 6 to 14 carbon atoms, heterylsulfonyl group having 1 to 10 carbon atoms, substituted or unsubstituted carbamoyl group having 1 to 25 carbon atoms, substituted or unsubstituted sulfamoyl group having 0 to 32 carbon atoms, substituted or unsubstituted alkoxycarbonyl group having 2 to 20 carbon atoms, substituted or unsubstituted aryloxycarbonyl group having 7 to 15 carbon atoms, substituted or unsubstituted acylamino group having 2 to 21 carbon atoms, substituted or unsubstituted sulfonylamino group having 1 to 20 carbon atoms, or substituted or unsubstituted amino group having 0 to 36 carbon atoms. In this context, the amino groups include anilino groups. From the perspectives of solvent solubility, absorption characteristics, and thermal decomposition properties, at least 8 from among R^{α1} to R^{α8} and R^{β1} to R^{β8} are hydrogen atoms, but without all of R^{α1} to R^{α8} being hydrogen atoms.

Each of R^{α1} to R^{α8} and R^{β1} to R^{β8} desirably independently denotes a hydrogen atom, halogen atom, carboxyl group, sulfo group, substituted or unsubstituted alkyl group having 1 to 16 carbon atoms (such as a methyl, ethyl, n-propyl, or i-propyl group), substituted or unsubstituted aryl group having 6 to 14 carbon atoms (such as a phenyl, p-methoxyphenyl, or p-octadecylphenyl group), substituted or unsubstituted alkoxy group having 1 to 16 carbon atoms (such as a methoxy, ethoxy, or n-octyloxy group), substituted or unsubstituted aryloxy group having 6 to 10 carbon atoms (such as a phenoxy or p-ethoxyphenoxy group), substituted or unsubstituted alkylsulfonyl group having 1 to 20 carbon atoms (such as a methanesulfonyl group, n-propylsulfonyl group, or n-octylsulfonyl group), substituted or unsubstituted arylsulfonyl group having 6 to 14 carbon atoms (such as a toluenesulfonyl or benzenesulfonyl group), substituted or unsubstituted sulfamoyl group having 0 to 20 carbon atoms (such as a methylsulfamoyl or n-butylsulfamoyl group), alkoxycarbonyl group having 1 to 17 carbon atoms (such as a methoxycarbonyl or n-butoxycarbonyl group), substituted or unsubstituted aryloxycarbonyl group having 7 to 15 carbon atoms (such as a phenoxycarbonyl or m-chlorophenylcarbonyl group), substituted or unsubstituted acylamino group having 2 to 21 carbon atoms (such as an acetylamino, pivaloylamino, or n-hexylamino group), or a sulfonylamino group having 1 to 18 carbon atoms (such as a methanesulfonylamino or n-butanesulfonylamino group).

R^{α1} to R^{α8} and R^{β1} to R^{β8} more preferably denote hydrogen atoms, halogen atoms, carboxyl groups, sulfo groups, substituted or unsubstituted alkyl groups having 1 to 16 carbon atoms, substituted or unsubstituted alkoxy groups having 1 to 16 carbon atoms, substituted or unsubstituted alkylsulfonyl groups having 1 to 20 carbon atoms, substituted or unsubstituted arylsulfonyl groups having 6 to 14 carbon atoms, substituted or unsubstituted sulfamoyl groups having 2 to 20 carbon atoms, alkoxycarbonyl groups having 1 to 13 carbon atoms, substituted or unsubstituted acylamino groups having 2 to 21 carbon atoms, or sulfonylamino groups having 1 to 18 carbon atoms.

More preferably, R^{α1} to R^{α8} denote hydrogen atoms, halogen atoms, sulfo groups, substituted or unsubstituted alkoxy groups having 1 to 16 carbon atoms, substituted or unsubstituted alkylsulfonyl groups having 1 to 20 carbon atoms, substituted or unsubstituted arylsulfonyl groups having 6 to 14 carbon atoms, substituted or unsubstituted sulfamoyl groups having 2 to 20 carbon atoms, substituted or unsubstituted acylamino groups having 2 to 21 carbon atoms, or sulfonylamino groups having 1 to 18 carbon atoms, and R^{β1} to R^{β8} denote hydrogen atoms or halogen atoms.
Particularly preferably, R^{α1} to R^{α8} denote hydrogen atoms, sulfo groups, substituted or unsubstituted alkylsulfonyl groups having 1 to 20 carbon atoms, unsubstituted arylsulfonyl groups having 6 to 14 carbon atoms, or unsubstituted sulfamoyl groups having 7 to 20 carbon atoms, and R^{β1} to R^{β8} denote hydrogen atoms.

In general formula (VIII), from the perspectives of solvent solubility, absorption characteristics, and thermal decomposition properties, either R^{α1} or R^{α2}, either R^{α3} or R^{α4}, either R^{α5} or R^{α6}, and either R^{α7} or R^{α8} -- a total of four -- desirably simultaneously don't denote hydrogen atoms.

In general formula (VIII), when the above-described groups denoted by R^{α1} to R^{α8} and R^{β1} to R^{β8} have substituents, examples of the substituents are as follows:
chain or cyclic substituted or unsubstituted alkyl groups having 1 to 20 carbon atoms (such as methyl, ethyl, isopropyl, cyclohexyl, benzyl, and phenethyl groups), substituted or unsubstituted aryl groups having 6 to 18 carbon atoms (such as phenyl, chlorophenyl, 2,4-di-t-amylphenyl, and 1-naphthyl groups), substituted or unsubstituted alkenyl groups having 2 to 20 carbon atoms (such as vinyl and 2-methylvinyl groups), substituted or unsubstituted alkynyl groups having 2 to 20 carbon atoms (such as ethynyl, 2-methylethynyl, and 2-phenylethynyl groups), halogen atoms (such as F, Cl, Br, and I), cyano groups, hydroxyl groups, carboxyl groups, substituted or unsubstituted acyl groups having 2 to 20 carbon atoms (such as acetyl, benzoyl, salicyloyl, and pivaloyl groups), substituted or unsubstituted alkoxy groups having 1 to 20 carbon atoms (such as methoxy, butoxy, and cyclohexyloxy groups), substituted or unsubstituted aryloxy groups having 6 to 20 carbon atoms (such as phenoxy, 1-napthoxy, and p-methoxyphenoxy groups), substituted or unsubstituted alkylthio groups having 1 to 20 carbon atoms (such as methylthio, butylthio, benzylthio, and 3-methoxypropylthio groups), substituted or unsubstituted arylthio groups having 6 to 20 carbon atoms (such as phenylthio and 4-chlorophenylthio groups), substituted or unsubstituted alkylsulfonyl groups having 1 to 20 carbon atoms (such as methanesulfonyl and butanesulfonyl groups), substituted or unsubstituted arylsulfonyl groups having 6 to 20 carbon atoms (such as benzenesulfonyl and paratoluenesulfonyl groups), substituted or unsubstituted carbamoyl groups having 1 to 17 carbon atoms (such as unsubstituted carbamoyl, methylcarbamoyl, ethylcarbamoyl, n-butylcarbamoyl, and dimethylcarbamoyl groups), substituted or unsubstituted acylamino groups having 1 to 16 carbon atoms (such as acetylamino and benzoylamino groups), substituted or unsubstituted acyloxy groups having 2 to 10 carbon atoms (such as acetoxy and benzoyloxy groups), substituted or unsubstituted alkoxycarbonyl groups having 2 to 10 carbon atoms (such as methoxycarbonyl and ethoxycarbonyl groups), five- or six-membered substituted or unsubstituted heterocyclic groups (such as pyridine groups, thienyl groups, furyl groups, thiazolyl groups, imidazolyl groups, pyrazolyl groups, and other aromatic heterocyclic groups; pyrrolidine rings, piperidine rings, morpholine rings, pyran rings, thiopyran rings, dioxane rings, dithiolane rings, and other nonaromatic heterocyclic groups).

In general formula (VIII), desirable examples of the substituents substituting the groups described above as the groups denoted by R^{α1} to R^{α8} and R^{β1} R^{β8} are chain or cyclic substituted or unsubstituted alkyl groups having 1 to 16 carbon atoms, aryl groups having 6 to 14 carbon atoms, alkoxy groups having 1 to 16 carbon atoms, aryloxy groups having 6 to 14 carbon atoms, halogen atoms, alkoxycarbonyl groups having 2 to 17 carbon atoms, carbamoyl groups having 1 to 10 carbon atoms, and acylamino groups having 1 to 10 carbon atoms.
Of these, the following are desirable: chain or cyclic alkyl groups having 1 to 10 carbon atoms, aryl groups having 6 to 10 carbon atoms, alkoxy groups having 1 to 10 carbon atoms, aryloxy groups having 6 to 10 carbon atoms, chlorine atoms, alkoxycarbonyl groups having 2 to 11 carbon atoms, carbamoyl groups having 1 to 7 carbon atoms, and acylamino groups having 1 to 8 carbon atoms.
Of these, the following are preferred: branched chain or cyclic unsubstituted alkyl groups having 1 to 8 carbon atoms, unsubstituted alkoxy groups having 1 to 8 carbon atoms, unsubstituted alkoxycarbonyl groups having 3 to 9 carbon atoms, phenyl, and chlorine atoms. The optimal substituents are unsubstituted alkoxy groups having 1 to 6 carbon atoms.

M denotes two hydrogen atoms, a divalent to tetravalent metal atom, a divalent to tetravalent oxymetal atom, or a divalent to tetravalent metal atom comprising a ligand. M desirably denotes a divalent to tetravalent metal atom. Of these, copper atoms, zinc atoms, magnesium atoms, or palladium atoms are desirable. Copper atoms and zinc atoms are preferred, and copper atoms are optimal.

The compounds denoted by general formula (VII) or (VIII) may be bonded at any position to form polymers. In that case, the individual units may be identical to or different from each other, and may be bonded to a polymer chain such as polystyrene, polymethacrylate, polyvinylalcohol, or cellulose.

The compounds denoted by general formula (VII) or (VIII) may be employed singly as specific compounds, or several such compounds of differing structure may be mixed for use. In particular, to prevent crystallization of the resist film, it is desirable to employ a mixture of isomers having substituents at different positions.

Specific examples of phthalocyanine dyes that are desirable as the compound for photoresist of the present invention will be given below. However, the present invention is not limited thereto.
In Table 1 below, the notation "R^{α1}/R^{α2}," for example, means either R^{α1} or R^{α2}. Accordingly, compounds with this notation are mixtures of substitution-position isomers. When unsubstituted, that is, when substituted with hydrogen, the notation is omitted.

**[Table 1]**

| | | |
|---|---|---|
| 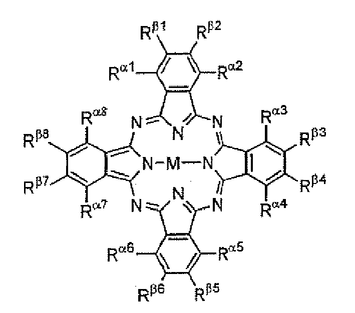 | | |

| Specific examples of phthalocyanine dye | | |
|---|---|---|
| No. | Substituent position and substituent | M |
| (VII-1) | R^{α1}/R^{α2}, R^{α3}/R^{α4}, R^{α5}/R^{α6}, R^{α1}/R^{α8} -SO₂N(C₅H₁₁-*i*)₂ | Cu |
| (VII-2) | R^{α1}/R^{α2}, R^{α3}/R^{α4}, R^{α5}/R^{α6}, R^{α7}/R^{α8} -SO₂NH(2-*s*-butoxy-5 -t-amylphenyl) | Cu |
| (VII-3) | R^{α1}/R^{α2}, R^{α3}/R^{α4}, R^{α5}/R^{α6} -SO₂NH(CH₂)₃O(2,4-di-t-amyl -phenyl) R^{α7}/R^{α8}-SO₃H | Cu |
| (VII-4) | R^{α1}/R^{α2}, R^{α3}/R^{α4}, R^{α5}/R^{α6}, R^{α7}/R^{α8} -SO₂N(3-methoxypropyl)₂ | Zn |
| (VII-5) | R^{α1}/R^{α2}, R^{α3}/R^{α4,} R^{α5}/R^{α6}, R^{α7}/R^{α8} -SO₂NMe (cyclohexyl) | Zn |
| (VII-6) | R^{α1}/R^{α2}, R^{α3}/R^{α4}, R^{a5}/R⁶, R^{α7}/R^{α8} -SO₂N(3-*i*-propoxyphenyl)₂ | Zn |
| (VII-7) | R^{α1}/R^{α2}, R^{α3}/R^{α4}, R^{α5}/R^{α6}, R^{α7}/R^{α8} -SO₂NH(2-*i*-amyloxy -carbonylphenyl) | Pd |
| (VII-8) | R^{α1}/R^{α2}, R^{α3}/R^{α4}, R^{α5}/R^{α6}, R^{α7}/R^{α8} -SO₂NH (2,4,6-trimethyl -phenyl) | Pd |
| (VII-9) | R^{α1}/R^{α2}, R^{α3}/R^{α4}, R^{α5}/R^{α6}, R^{α7}/R^{α8} -SO₂CH(CH₃)CH₂CH₃ | Cu |
| (VII-10) | R^{α1}/R^{α2}, R^{α3}/R^{α4}, R^{α5}/R^{α6}, R^{α7}/R^{α8} -SO₂CH(CH₃)CH₂CH₃ | Zn |
| (VII-11) | R^{α1}/R^{α2}, R^{α3}/R^{α4}, R^{α5}/R^{α6}, R^{α7}/R^{α9} -SO₂CH(CH₃)CH₂CH₃ | H₂ |
| (VII-12) | R^{α1}/R^{α2}, R^{α3}/R^{α4}, R^{α5}/R^{α6} -SO₂Ph | Cu |
| (VII-13) | R^{α1}/R^{α2}_{,} R^{α3}/R^{α4}, R^{α5}/R^{α6}, R^{α7}/R^{α8} -SO₂C(CH₃) ₃ | Cu |
| (VII-14) | R^{α1}/R^{α2}, R^{α3}/R^{α4}, R^{α5}/R^{α6}, R^{α7}/R^{α8} -SO₂C(CH₃)₃ | V=O |
| (VII-15) | R^{α1}/R^{α2}, R^{α3}/R^{α4}, R^{α5}/R^{α6}, R^{α7}/R^{α8} -SO_{2C}(CH₃)₂CO₂C₂H₅ | Cu |
| (VII-16) | R^{α1}/R^{α2}, R^{α3}/R^{α4}, R^{α5}/R^{α6}, R^{α7}/R^{α8} -SO₂Ph | Mg |
| (VII-17) | R^{α1}/R^{α2}, R^{α3}/R^{α4}, R^{α5}/R^{α6}, R^{α7}/R^{α8} -SO₂(cyclohexyl) | Cu |
| (VII-18) | R^{α1}/R^{α2}, R^{α3}/R^{α4}, R^{α5}/R^{α6}, R^{α7}/R^{α8} -SO₂{4-(2-*s*-butoxy -benzoylamino) phenyl} | Zn |
| (VII-19) | R^{α1}/R^{α2}, R^{α3}/R^{α4}, R^{α5}/R^{α6} -SO₂(2,6-dichloro -4-methoxyphenyl) | H₂ |
| (VII-20) | R^{α1}/R^{α2}, R^{α3}/R^{α4}, R^{α5}/R^{α6} -SO₂CH(Me)CO₂CH₂ -CH(C₂H₅)C₄H₉-*n* | Mg |
| (VII-21) | R^{α1}/R^{α2}, R^{α3}/R^{α4}, R^{α5}/R^{α6}, R^{α7}/R^{α8} -SO₂{2-(2-ethoxyethoxy) -phenyl} R^{β1}/R^{β2}, R^{β3}/R^{β4}, R^{β5}/R^{β6}, R^{β7}/R^{β8} -C₂H₅ | Zn |
| (VII-22) | R^{α1}/R^{α2}, R^{α3}/R^{α4}, R^{α6}/R^{α6}, R^{α7}/R^{α8} -SO₂N(CH₂CH₂OMe)₂ | Cu |
| (VII-23) | R^{α1}/R^{α2}, R^{α3}/R^{α4}, R^{α5}/R^{α6}, R^{α7}/R^{α8} -OCH₂CH(C₂H₅)C₄H₉-*n* | H₂ |
| (VII-24) | R^{α1}/R^{α2}, R^{α3}/R^{α4}, R^{α5}/R^{α6,} R^{α7}/R^{α8} -OCHMe(phenyl) | Zn |
| (VII-25) | R^{α1}, R^{α2}, R^{α3}, R^{α4}, R^{α5}, R^{α6}, R^{α7} R^{α8} -OCH(*s*-butyl)₂ | Cu |
| (VII-26) | R^{α1}, R^{α2}, R^{α3}, R^{α4}, R^{α5}, R^{α6}, R^{α7}, R^{α8} -OCH₂CH₂OC₃H₇-*i* | SiCl₂ |
| (VII-27) | R^{α1}/R^{α2}, R^{α3}/R^{α4}, R^{α5}/R^{α6}, R^{α7}/R^{α8} -*t*-amyl R^{β1}/R^{β2}, R^{β3}/R^{β4}_{`} R^{β5}/R^{β6}, R^{β7}/R^{β8} -Cl | Ni |
| (VII-28) | R^{α1}/R^{α2}, R^{α3}/R^{α4}, R^{α5}/R^{α6}, R^{α7}/R^{α8} -(2,6-di-ethoxyphenyl) | Zn |
| (VII-29) | R^{α1}/R^{α2}, R^{α3}/R^{α4}, R^{α5}/R^{α6}, R^{α7}/R^{α8} -SO₂NHCH₂CH₂OC₃H₇-*i* | Cu |
| (VII-30) | R^{α1}/R^{α2}, R^{α3}/R^{α4}, R^{α5}/R^{α6} -CO₂CH₂CH₂OC₂H₅ R^{α7}/R^{α8}-CO₂H | Cu |
| (VII-31) | R^{α1}R^{α2}, R^{α3}/R^{α4}, R^{α5}/R^{α6}, R^{α7}/R^{α8} -CO₂CH(Me)CO₂C₃H₇-*i* | Co |
| (VII-32) | R^{α1}/R^{α2}, R^{α3}/R^{α4}, R^{α5}/R^{α6}, R^{α7}/R^{α8} -CONHCH₂CH₂OC₃H₇-*i* | Cu |
| (VII-33) | R^{α1}/R^{α2}, R^{α3}/R^{α4}, R^{α5}/R^{α6} -CON(CH₂CH₂OC₄Hg-*n*)₂ R^{α7}/R^{α8}-CO₂H | Pd |
| (VII-34) | R^{α1}/R^{α2}, R^{α3}/R^{α4}, R^{α5}/R^{α6}, R^{α7}/R^{α8} -NHCOCH(C₂H₅)C₄H₉-*n* | Co |
| (VII-35) | R^{α1}/R^{α2}, R^{α3}/R^{α4}, R^{α5}/R^{α6}, R^{α7}/R^{α8} -NHCO (2-*n*-butoxycarbony -phenyl) | Mg |
| (VII-36) | R^{α1}/R^{α2}, R^{α3}/R^{α4}, R^{α5}/R^{α6}, R^{α7}/R^{αg} -NHSO₂(2-*i*-propoxyphenyl) | Pd |
| (VII-37) | R^{α1}/R^{α2}, R^{α3}/R^{α4}, R^{α5}/R^{α5}, R^{α7}/R^{α8} -NHSO₂(2-*n*-butoxy-5-*t*-amyl -phenyl) | Zn |
| (VII-38) | R^{α1}/R^{α2}, R^{α3}/R^{α4}, R^{α5}/R^{a8}, R^{α7}/R^{α8} -NHSO₂(n-propyl) | Zn |

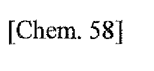

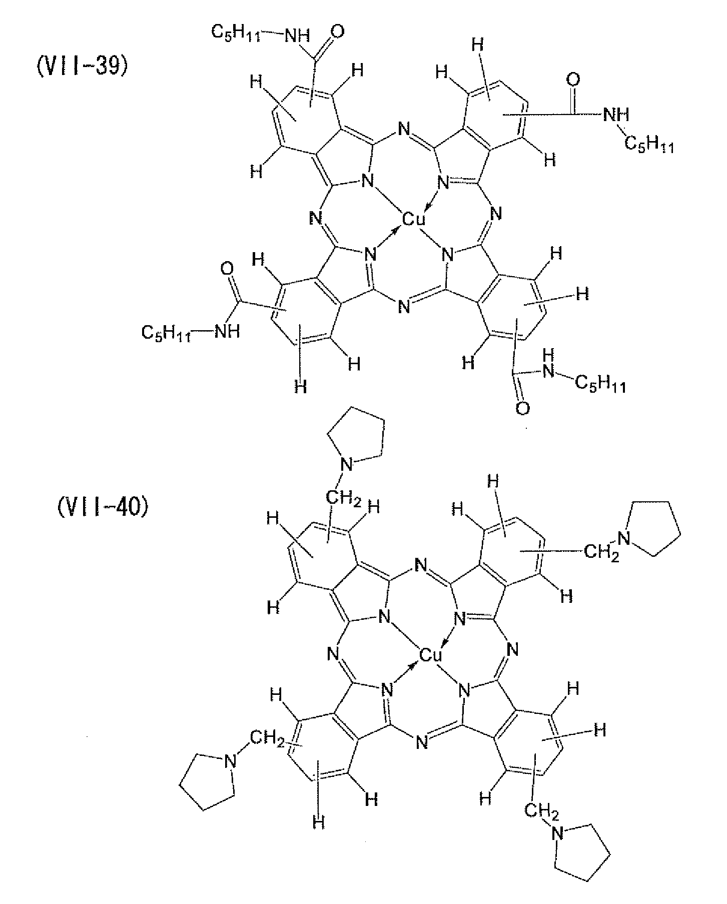

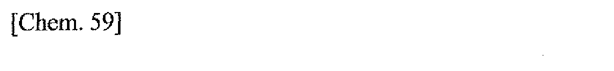

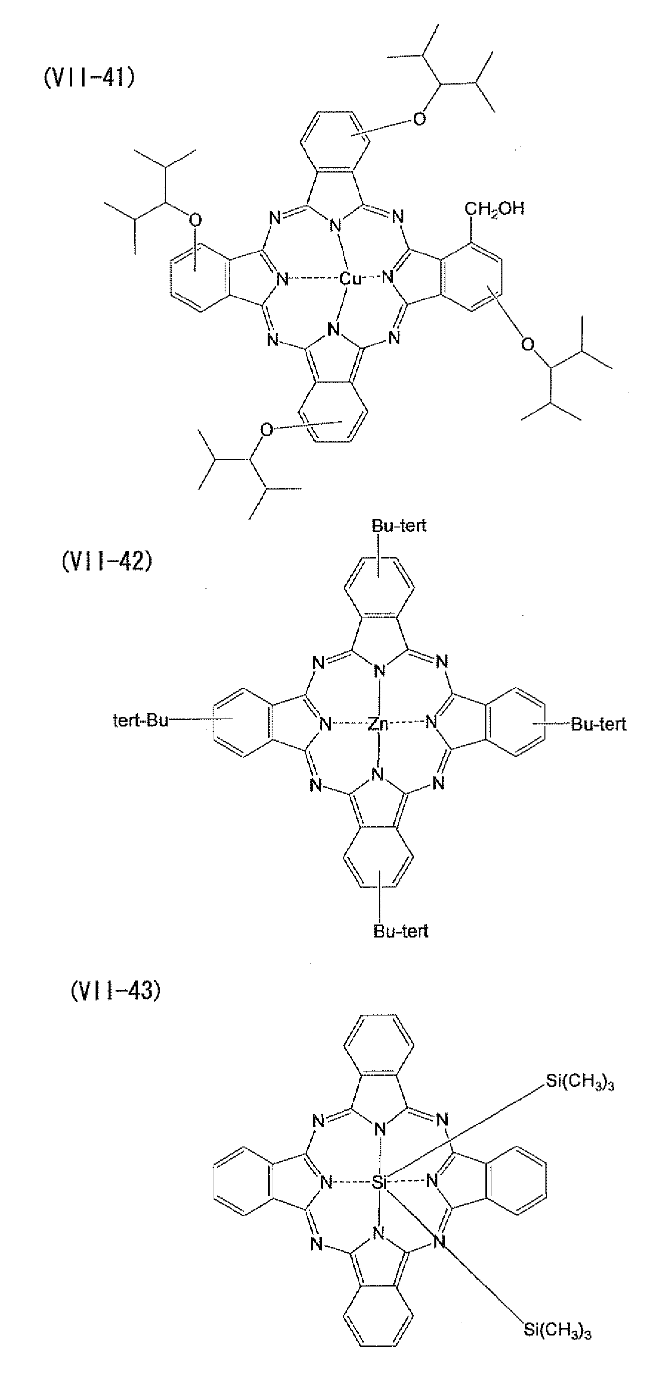

The phthalocyanine dye as the compound for photoresist of the present invention can be synthesized, for example, by the method described or cited by Shirai and Kobayashi, published by IPC (Ltd.), "phthalocyanine Chemistry and Functions" (pp. 1 to 62); C. C. Leznoff and A. B. P. Lever, published by VCH, "Phthalocyanines - Properties and Applications" (pp. 1 to 54), which are expressly incorporated herein by reference in their entirety, or a similar method. It is also available as a commercial product in some cases.

From the perspective of sensitivity during pattern exposure by laser, the thermal decomposition temperature of the compound for photoresist of the present invention in the form of a compound comprising a phthalocyanine dye skeleton is desirably equal to or higher than 100°C but equal to or lower than 600°C., preferably equal to or higher than 120°C but equal to or lower than 550°C., and optimally equal to or higher than 150°C but equal to or lower than 500°C.

The compound for photoresist of the present invention can be an azo compound or a complex compound of an azo compound and a metal ion. In the present invention, the term "azo compound" is a general term for organic compounds in which two organic groups (R and R') are linked by an azo group (-N=N-).

Various metals capable of forming complexes can be employed as the metal forming a complex with the azo compound. From the perspective of forming an absorption spectrum with good shape, transition metals are desirable and Ni, Co, Cu, Fe, Zn, and Pd are preferred. The complex affords good thin film formation properties in the course of forming a resist film from a resist coating liquid, so the azo compound desirably forms a complex with a metal ion.

The azo compound denoted by general formula (IX) below is a desirable example of an azo compound from the perspective of light absorption characteristics, thermal decomposition characteristics, and the like.

[Chem. 60]

General formula (IX) Q¹-N=N-Q²

In general formula (IX), Q¹ denotes an aryl group or a heterocyclic group, with a hetero ring being desirable.

When Q¹ is an aryl group, it is desirably a substituted or unsubstituted aryl group having 6 to 20 carbon atoms, preferably a substituted or unsubstituted benzene having 6 to 20 carbon atoms.

When Q¹ is a hetero ring, it is desirably a substituted or unsubstituted five-membered hetero ring or a substituted or unsubstituted six-membered hetero ring. A five-membered hetero ring comprising 1 to 20 carbon atoms and 1 or more nitrogen atoms is preferred. It may form a condensed ring with a benzene ring, benzofuran ring, pyridine ring, pyrrole ring, indole ring, thiophene ring, or the like.

Examples of Q¹ are an oxazole nucleus having 3 to 25 carbon atoms (such as 2-3-methyloxazolyl), a thiazole nucleus having 3 to 25 carbon atoms (such as 2-3-methylthiazolyl), an imidazole nucleus having 3 to 25 carbon atoms (such as 2-1,3-diethylimidazolyl), an indolenine nucleus having 10 to 30 carbon atoms (such as 3,3-dimethylindolenine), a quinoline nucleus having 9 to 25 carbon atoms (such as 2-1-methylquinolyl), a selenozole nucleus having 3 to 25 carbon atoms (such as 2-3-methylbenzoselenazolyl), a pyridine nucleus having 5 to 25 carbon atoms (such as 2-pyridyl), a thiazoline nucleus, an oxazoline nucleus, a selenazoline nucleus, a tellurazoline nucleus, a tellurazole nucleus, a benzotellurazole nucleus, an imidazoline nucleus, an imidazo[4,5-quinoxaline] nucleus, an oxadiazole nucleus, a thiadiazole nucleus, a tetrazole nucleus, a pyrimidine nucleus, a pyrrole nucleus, a pyrazole nucleus, a pyrazolone, a pyridine nucleus, an isooxazole nucleus, a triazole nucleus, barbituric acid, and Meldrum's acid. These may be further substituted.

In general formula (IX), Q² denotes an aryl group, heterocyclic group, or CR⁴¹R⁴². In this context, each of R⁴¹ and R⁴² independently denotes a substituent. However, the total value of the Hammett's σₚ value of the substituent denoted by R⁴¹ and that of the substituent denoted by R⁴² is equal to or greater than 0.6. When the total value of these Hammett's σₚ values is equal to or greater than 0.6, the compound for photoresist can achieve suitable absorption characteristics and thermal decomposition properties. Hammett's substituent constant σₚ values (referred to as "σₚ values", hereinafter) are described, for example, in Chem. Rev. 91, 165 (1991) and in references cited therein. Those that are not described therein can be calculated by the method described in these references.

When Q² is an aryl group, it is desirably a substituted or unsubstituted aryl group having 6 to 20 carbon atoms, preferably a substituted or unsubstituted benzene having 6 to 20 carbon atoms.

When Q² is a hetero ring, it is desirably a substituted or unsubstituted five-membered hetero ring or a substituted or unsubstituted six-membered hetero ring, and preferably a five-membered hetero ring having 1 to 20 carbon atoms and comprising one or more nitrogen atoms.

When Q² is the group denoted by CR⁴¹R⁴², the Hammett's σₚ value of the substituent denoted by R⁴¹ and that of the substituent denoted by R⁴² are both desirably equal to or greater than 0.6. Examples of such R⁴¹ and R⁴² are: cyano groups, nitro groups, acyl groups having 1. to 10 carbon atoms (such as acetyl, propionyl, butyryl, pivaloyl, and benzoyl groups), alkoxycarbonyl groups having 2 to 12 carbon atoms (such as methoxycarbonyl, ethoxycarbonyl, isopropoxycarbonyl, butoxycarbonyl, and decyloxycarbonyl groups), aryloxycarbonyl groups having 7 to 11 carbon atoms (such as phenoxycarbonyl groups), carbamoyl groups having 1 to 10 carbon atoms (such as methylcarbamoyl, ethylcarbamoyl, and phenylcarbamoyl groups), alkylsulfonyl groups having 1 to 10 carbon atoms (such as methanesulfonyl groups), arylsulfonyl groups having 6 to 10 carbon atoms (such as benzenesulfonyl groups), alkoxysulfonyl groups having 1 to 10 carbon atoms (such as methoxysulfonyl groups), sulfamoyl groups having 1 to 10 carbon atoms (such as ethylsulfamoyl and phenylsulfamoyl groups), alkylsulfinyl groups having 1 to 10 carbon atoms (such as methanesulfinyl and ethane sulfinyl groups), arylsulfinyl groups having 6 to 10 carbon atoms (such as benzenesulfinyl groups), alkylsulfenyl groups having 1 to 10 carbon atoms (such as methanesulfenyl and ethanesulfenyl groups), arylsulfenyl groups having 6 to 10 carbon atoms (such as benzenesulfenyl groups), halogen atoms, alkynyl groups having 2 to 10 carbon atoms (such as ethynyl groups), diacylamino groups having 2 to 10 carbon atoms (such as diacetylamino groups), phosphoryl groups, carboxyl groups, and five-membered or six-membered heterocyclic groups (such as 2-benzothiazolyl, 2-benzooxazolyl, 3-pyridyl, 5-(1H)-tetrazolyl, and 4-pyrimidyl groups).

R⁴¹ and R⁴² are desirably cyano groups, acyl groups having 1 to 10 carbon atoms, alkoxycarbonyl groups having 2 to 12 carbon atoms, carbamoyl groups having 1 to 10 carbon atoms, or five- or six-membered heterocyclic groups; preferably acyl groups having 1 to 10 carbon atoms, alkoxycarbonyl groups having 2 to 12 carbon atoms, or carbamoyl groups having 1 to 10 carbon atoms; and optimally, alkoxycarbonyl groups having 2 to 12 carbon atoms or carbamoyl groups having 1 to 10 carbon atoms.

General formula (IX) comprises multiple tautomers due to differences in notation of resonant structures. In particular, when Q² is CR⁴¹R⁴² and either R⁴¹ or R⁴² is -CO-E¹ (where E¹ is a substituent) -- for example, when R⁴² is -CO-E¹ -- the usual notation is that of general formula (XI) below. Compounds of such notation are included in general formula (IX).

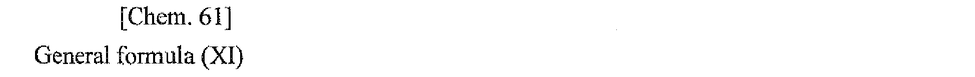

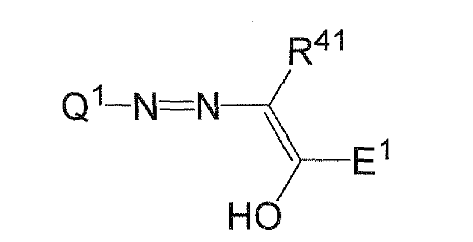

[In general formula (XI), Q¹ is defined in the same manner as in general formula (IX), R⁴¹ denotes a substituent of which total value of a Hammett's σₚ value with that of the substituent denoted by -C(OH)-E¹ is equal to or greater than 0.6, and E denotes a substituent.]

The compound denoted by general formula (IX) is desirably denoted by general formula (X-1) or (X-2) below.

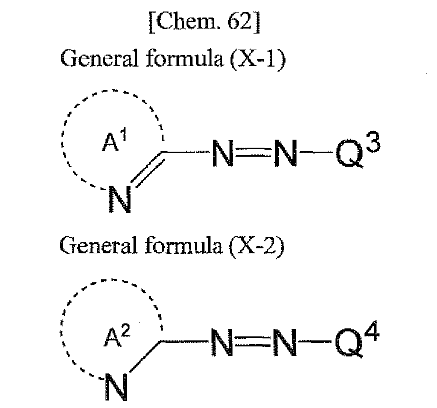

In general formula (X-1), A¹ denotes a group of atoms forming a hetero ring with a carbon atom and nitrogen atom to which this is bonded. In general formula (X-2), A² denotes a group of atoms forming a hetero aromatic ring with a carbon atom and nitrogen atom to which this is bonded.

The hetero aromatic rings formed by A¹ and A² are desirably thioazole, oxazole, pyrazole, imidazole, thiadiazole, isoxazole, or triazole rings; preferably oxazole, pyrazole, thiadiazole, isoxazole, or triazole rings; and optimally, pyrazole, thiadiazole, or isoxazole rings.

Q³ and Q⁴ are defined identically to Q² in general formula (IX), and the specific examples and desirable ranges thereof are also identical thereto.

The above groups may comprise substituents. Examples of the substituents, when present, are substituted or unsubstituted linear, branched, or cyclic alkyl groups having 1 to 18 carbon atoms (desirably, I to 8 carbon atoms) (such as methyl, ethyl, propyl, isopropyl, n-butyl, isobutyl, sec-butyl, t-butyl, cyclohexyl, methoxyethyl, ethoxycarbonylethyl, cyanoethyl, diethylaminoethyl, hydroxyethyl, chloroethyl, acetoxyethyl, and trifluoromethyl groups); alkenyl groups having 2 to 18 carbon atoms (desirably, 2 to 8 carbon atoms) (such as vinyl groups); alkynyl groups having 2 to I8 8 carbon atoms (desirably, 2 to 8 carbon atoms) (such as ethynyl groups); substituted or unsubstituted aryl groups having 6 to 18 carbon atoms (desirably, 6 to 10 carbon atoms) (such as phenyl, 4-methylphenol, 4-methoxyphenyl, 4-carboxyphenyl, and 3,5-dicarboxyphenyl groups); substituted or unsubstituted aralkyl groups having 7 to 18 carbon atoms (desirably, 7 to 12 carbon atoms) (such as benzyl and carboxybenzyl groups); substituted or unsubstituted acryl groups having 2 to 18 carbon atoms (desirably 2 to 8 carbon atoms) (such as acetyl, propionyl, butanoyl, and chloroacetyl groups); substituted or unsubstituted alkyl or arylsulfonyl groups having 1 to 18 carbon atoms (desirably, 1 to 8 carbon atoms) (such as methanesulfonyl and p-toluenesulfonyl groups); alkylsulfinyl groups having 1 to 18 carbon atoms (desirably, 1 to 8 carbon atoms) (such as methanesulfinyl, ethanesulfinyl, and octanesulfinyl groups); alkoxycarbonyl groups having 2 to 18 carbon atoms (desirably, 2 to 8 carbon atoms) (such as methoxycarbonyl, ethoxycarbonyl, and butoxycarbonyl groups); aryloxycarbonyl groups having 7 to 18 carbon atoms (desirably, 7 to 12 carbon atoms) (such as phenoxycarbonyl, 4-methylphenoxycarbonyl and 4-methoxyphenylcarbonyl groups); substituted or unsubstituted alkoxy groups having 1 to 18 carbon atoms (desirably, 1 to 8 carbon atoms) (such as methoxy, ethoxy, n-butoxy, and methoxyethoxy groups); substituted or unsubstituted aryloxy groups having 6 to 18 carbon atoms (desirably, 6 to 10 carbon atoms) (such as phenoxy and 4-methoxyphenoxy groups); alkylthio groups having 1 to 18 carbon atoms (desirably, 1 to 8 carbon atoms) (such as methylthio and ethylthio groups); arylthio groups having 6 to 10 carbon atoms (desirably, 1 to 8 carbon atoms) (such as phenylthio groups); substituted or unsubstituted acyloxy groups having 2 to 18 carbon atoms (desirably, 2 to 8 carbon atoms) (such as acetoxy, ethylcarbonyloxy, cyclohexylcarbonyloxy, benzoyloxy, and chloroacetyloxy groups); substituted or unsubstituted sulfonyloxy groups having 1 to 18 carbon atoms (desirably 1 to 8 carbon atoms) (such as methanesulfonyloxy groups); substituted or unsubstituted carbamoyloxy groups having 2 to 18 carbon atoms (desirably, 2 to 8 carbon atoms) (such as methylcarbamoyloxy and diethylcarbamoyloxy groups); unsubstituted amino groups and substituted amino groups having 1 to 18 carbon atoms (desirably 1 to 8 carbon atoms) (such as methylamino, dimethylamino, diethylamino, anilino, methoxyphenylamino, chlorophenylamino, pyridylamino, methoxycarbonylamino, n-butoxycarbonylamino, phenoxycarbonylamino, phenylcarbamoylamino, ethylthiocarbamoylamino, methylsulfamoylamino, phenylsulfamoylamino, ethylcarbonylamino, ethylthiocarbonylamino, cyclohexylcarbonylamino, benzoylamino, chloroacetylamino, methanesulfonylamino, and benzenesulfonylamino groups); amide groups having 1 to 18 carbon atoms (desirably, 1 to 8 carbon atoms) (such as acetamide, acetylmethylamide, and acetyloctylamide groups); substituted or unsubstituted ureido groups having 1 to 18 carbon atoms (desirably, 1 to 8 carbon atoms) (such as unsubstituted ureido, methylureido, ethylureido, and dimethylureido groups); substituted or unsubstituted carbamoyl groups having 1 to 18 carbon atoms (desirably 1 to 8 carbon atoms) (such as unsubstituted carbamoyl, methylcarbamoyl, ethylcarbamoyl, n-butylcarbamoyl, t-butylcarbamoyl, dimethylcarbamoyl, morpholinocarbamoyl, and pyrrolidinocarbamoyl groups); unsubstituted sulfamoyl groups and substituted sulfamoyl groups having 1 to 18 carbon atoms (desirably, 1 to 8 carbon atoms) (such as methylsulfamoyl and phenyl sulfamoyl groups); halogen atoms (such as fluorine, chlorine, and bromine); hydroxyl groups; mercapto groups; nitro groups; cyano groups; carboxyl groups; sulfo groups; phosphono groups (such as diethoxyphosphono groups); and heterocyclic groups (such as oxazole rings, benzooxazole rings, thiazole rings, benzothiazole rings, imidazole rings, benzoimidazole rings, indolenine rings, pyridine rings, morpholine rings, piperidine rings, pyrrolidine rings, sulfolane rings, furan rings, thiophene rings, pyrazole rings, pyrrole rings, chroman rings, and coumarin rings).

Specific examples of azo compounds that are desirable as the compound for photoresist of the present invention are given below. However, the present invention is not limited thereto.

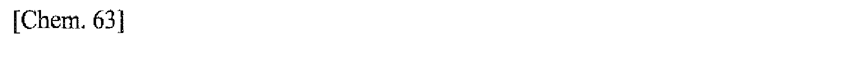

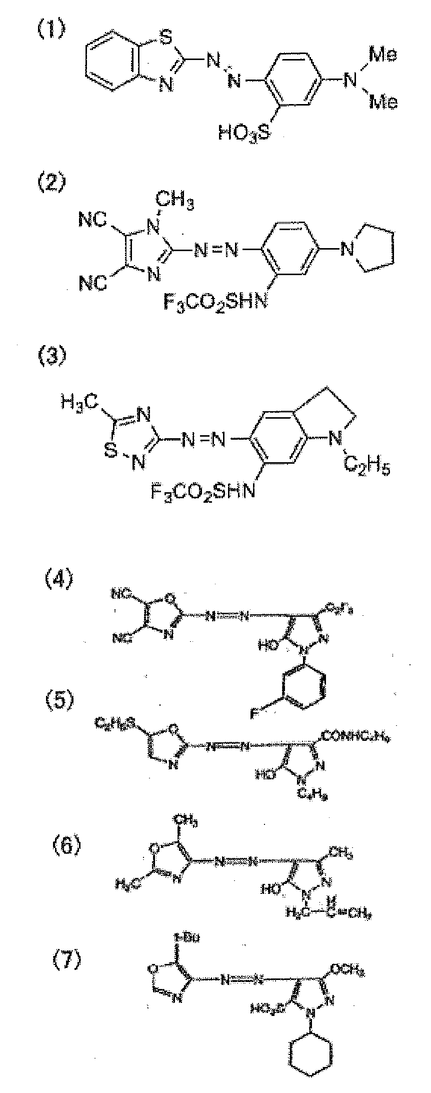

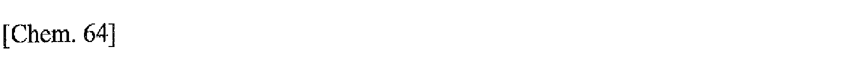

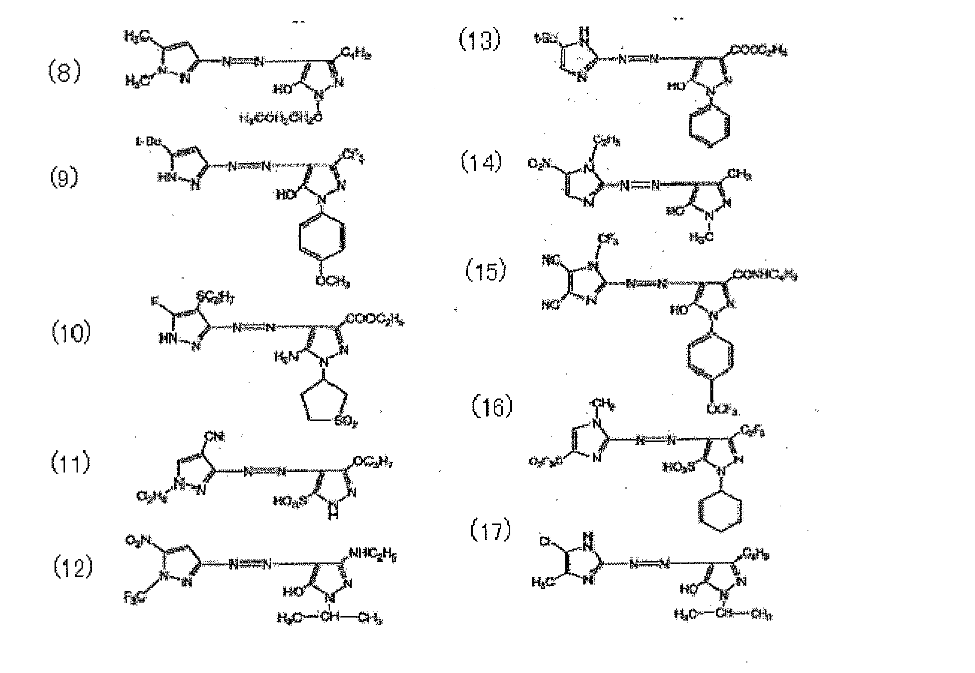

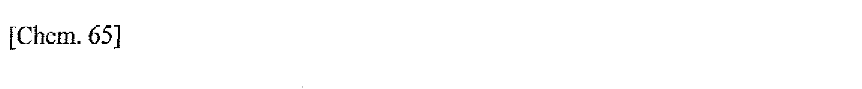

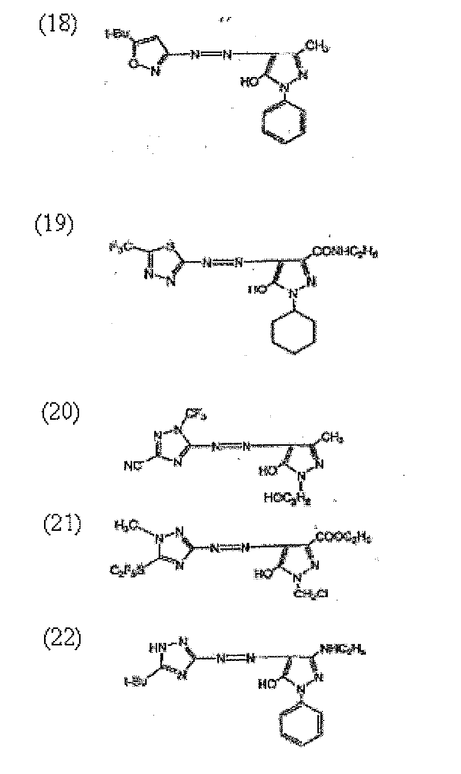

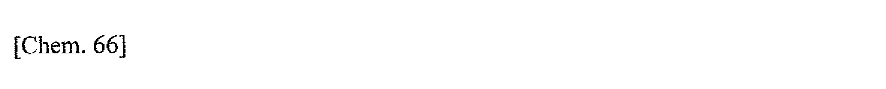

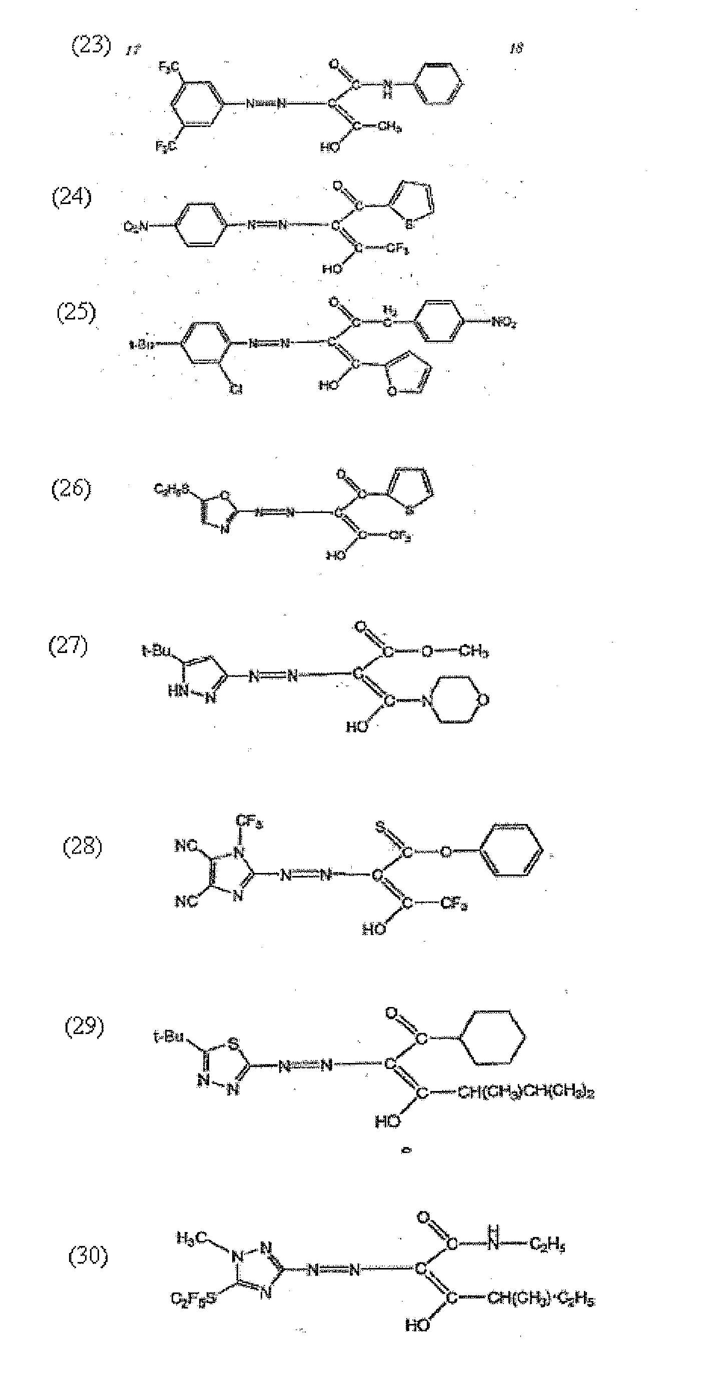

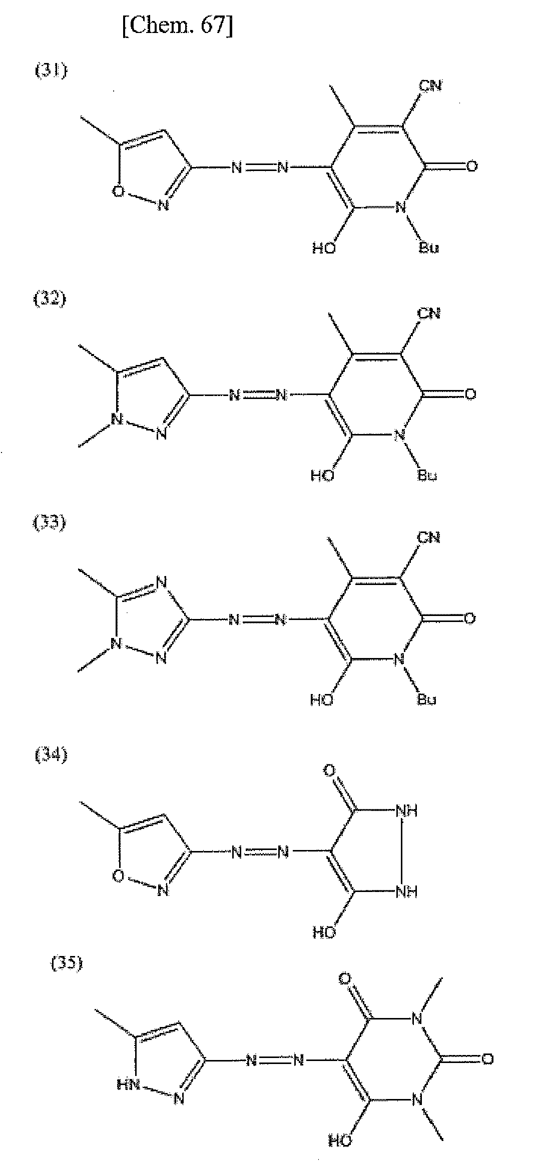

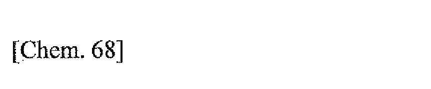

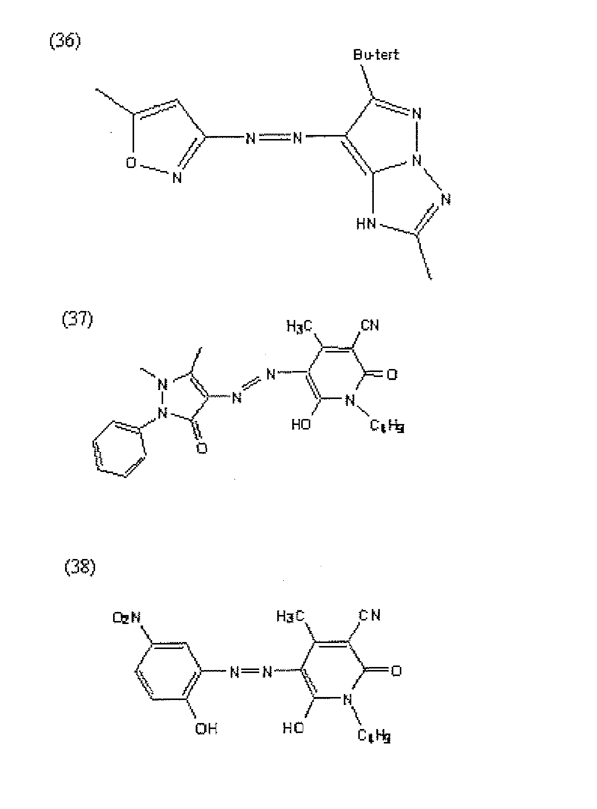

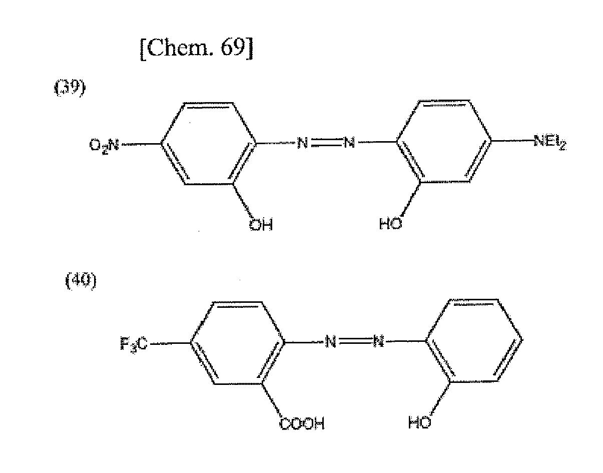

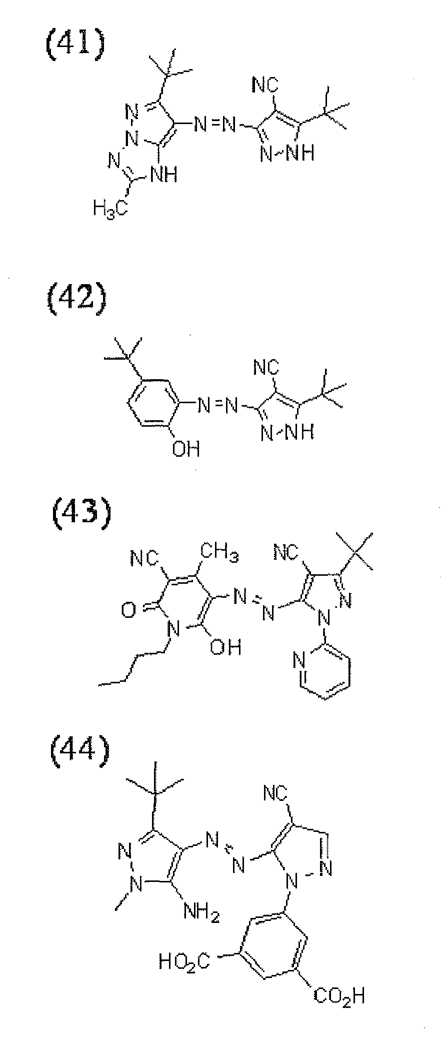

Specific examples of azo complex compounds that are desirable as the compound for photoresist of the present invention are given below. However, the present invention is not limited thereto. When forming a complex, a ligand is employed in which a suitably dissociative hydrogen dissociates to form a dissociation product.

**[Table 2]**

| No. of Example Compound | Ligand | Central metal |
|---|---|---|
| 45 | Example Compound (1) | Ni |
| 46 | Example Compound (2) | Ni |
| 47 | Example Compound (3) | Ni |
| 48 | Example Compound (4) | Ni |
| 49 | Example Compound (5) | Ni |
| 50 | Example Compound (6) | Co |
| 51 | Example Compound (7) | Co |
| 52 | Example Compound (8) | Cu |
| 53 | Example Compound (9) | Cu |
| 54 | Example Compound (10) | Cu |
| 55 | Example Compound (11) | Ni |
| 56 | Example Compound (12) | Cu |
| 57 | Example Compound (13) | Zn |
| 58 | Example Compound (14) | Ni |
| 59 | Example Compound (15) | Ni |
| 60 | Example Compound (16) | Ni |
| 61 | Example Compound (17) | Ni |
| 62 | Example Compound (18) | Ni |
| 63 | Example Compound (19) | Cu |
| 64 | Example Compound (20) | Cu |
| 65 | Example Compound (21) | Cu |
| 66 | Example Compound (22) | Cu |
| 67 | Example Compound (23) | Cu |
| 68 | Example Compound (24) | Ni |
| 69 | Example Compound (25) | Ni |
| 70 | Example Compound (26) | Ni |
| 71 | Example Compound (27) | Ni |
| 72 | Example Compound (28) | Ni |
| 73 | Example Compound (29) | Cu |
| 74 | Example Compound (30) | Cu |
| 75 | Example Compound (31) | Ni |
| 76 | Example Compound (32) | Cu |
| 77 | Example Compound (33) | Cu |
| 78 | Example Compound (34) | Ni |
| 79 | Example Compound (35) | Ni |
| 80 | Example Compound (36) | Cu |
| 81 | Example Compound (37) | Cu |
| 82 | Example Compound (38) | Co |
| 83 | Example Compound (39) | Co |
| 84 | Examples Compound (40) | Ni |
| 85 | Example Compound (41) | Cu |
| 86 | Example Compound (42) | Cu |
| 87 | Example Compound (43) | Cu |

The compound for photoresist of the present invention in the form of azo compounds and azo complex compounds can be synthesized by known methods, and are in some cases available as commercial products.

From the perspective of sensitivity during pattern exposure by laser, the thermal decomposition temperature of the compound for photoresist of the present invention in the form of azo compounds and azo complex compounds is desirably equal to or higher than 100°C but equal to or lower than 600°C, preferably equal to or higher than 120°C but equal to or lower than 550°C, and more preferably, equal to or higher than 150°C but equal to or lower than 500°C.

The compound for photoresist of the present invention that is optimal for the wavelength of light employed in pattern exposure can be selected.
For example, as for the maximum absorption wavelength (λmax), as the general index, when the wavelength of the laser beam employed is λnm, a compound for photoresist can be selected that has a λmax falling within a range of λ± 150 nm, desirably λ± 100 nm, so that the photoresist film will be efficiently decomposed or modified during pattern exposure. For example, when employing a semiconductor laser beam with a wavelength of 650 nm, a compound for photoresist with a maximum absorption wavelength falling within a range of 500 nm to 800 nm, desirably falling within a range of 550 nm to 750 nm, can be selected. When employing a semiconductor laser beam with a wavelength of 405 nm, a compound for photoresist with a maximum absorption wavelength falling within a range of 255 nm to 555 nm, desirably falling within a range of 305 nm to 505 nm, can be selected.
For the reasons as described above, the compound for photoresist of the present invention in the form of a compound comprising a phthalocyanine dye skeleton can be selected that has a maximum absorption wavelength (λmax) falling within a range of λ ± 150 nm, desirably λ ± 100 nm. For example, when employing a semiconductor laser beam with a wavelength of 650 nm, a compound with a maximum absorption wavelength falling within a range of 500 nm to 800 nm, desirably falling within a range of 550 nm to 750 nm, can be selected. Further, a compound with a maximum absorption wavelength falling within a range of 255 nm to 555 nm, desirably falling within a range of 305 nm to 505 nm, can be selected. Phthalocyanine dyes are known to have intense primary absorption at 600 nm to 900 nm, generally known as Q-band absorption, and secondary absorption at 300 nm to 500 nm, known as Soret-band absorption. The above maximum absorption wavelength may refer to either the primary absorption wavelength or the secondary absorption wavelength. When employing a semiconductor laser beam with a wavelength of 405 nm, the 300 nm to 500 nm Soret-band absorption wavelength desirably falls within the desirable range given above.

### [Photoresist liquid]

The photoresist liquid of the present invention comprises the compound for photoresist of the present invention and, desirably, a solvent. The photoresist liquid of the present invention may comprise one or more of the compound for photoresists of the present invention. A solvent that is a good solvent to the compound for photoresist of the present invention is desirably employed. In addition to the above components, the photoresist liquid of the present invention may optionally comprise other components. To form a resist film of good processability, the content of the compound for photoresist in the photoresist liquid of the present invention is desirably equal to or greater than 50 mass percent, preferably equal to or greater than 70 mass percent, more preferably equal to or greater than 90 mass percent, based on the total solid component of the photoresist liquid. By way of example, the upper limit is 100 mass percent.

The photoresist liquid of the present invention can be coated on a surface being processed and the solvent can be evaporated off to form a photoresist film. Examples of coating methods are spraying, spin coating, dipping, roll coating, blade coating, doctor roll coating, doctor blade coating, curtain coating, slit coating, and screen printing. The use of spin coating is desirable from the perspectives of good production efficiency and ease of controlling the film thickness. Conventionally known methods can be employed to remove the solvent from the photoresist liquid that has been coated. For example, when coated by the spin coating method, the rotational speed of the spinning can be increased to evaporate off the solvent. In this process, air can be sprayed through nozzles onto the coated surface to accelerate evaporation of the solvent. In the same manner as in the process of coating conventional photoresist, a spin coated photoresist liquid film can be heated (baked) in what is known as prebaking. One particularly preferred method of removing the solvent is to coat the photoresist liquid by spin coating and then increase the rotational speed of the spinning to remove the solvent. In that case, it is desirable to further conduct annealing by heating. Annealing has the effect of increasing the strength and stability of the photoresist film. The lower limit of the heating temperature is, for example, equal to or higher than 55°C, desirably equal to or higher than 65°C, and preferably, equal to or higher than 75°C. The upper limit of the heating temperature is, for example, equal to or lower than 200°C, desirably equal to or lower than 150°C, and preferably, equal to or lower than 100°C. The lower limit of the time is, for example, equal to or more than 5 minutes, desirably equal to or more than 15 minutes, and preferably, equal to or more than 30 minutes. The upper limit is, for example, equal to or less than 4 hours, desirably equal to or less than 2 hours, and preferably, equal to or less than 1 hour. Conducting annealing under conditions within such ranges can improve the strength and stability as the photoresist film without decreasing production efficiency.

Taking into account the coating properties (such as keeping the film thickness after coating and removing the solvent within desired ranges, achieving a uniform film thickness over the entire surface being processed, and the formation of a coating of uniform thickness over a number of irregularities on the surface being processed), the concentration of the total solid component in the photoresist liquid of the present invention is desirably equal to or greater than 0.1 mass percent but equal to or less than 10 mass percent, preferably equal to or greater than 0.4 mass percent but equal to or less than 5 mass percent, and more preferably, equal to or greater than 0.7 mass percent but equal to or less than 2 mass percent.

Among solvents that can be employed in the photoresist liquid of the present invention, taking into account the coating properties in the spin coat method, it is desirable for the solvent to be suitably volatile during coating, and in terms of manufacturing suitability, desirable for the solvent to have physical properties such as the following:
1. A boiling point of equal to or higher than 60°C but equal to or lower than 300°C is desirable, equal to or higher than 70°C but equal to or lower than 250°C is preferred, and equal to or higher than 80°C but equal to or lower than 200°C is optimal.
2. A viscosity of equal to or higher than 0.1 cP but equal to or lower than 100 cP is desirable, equal to or higher than 0.5 cP but equal to or lower than 50 cP is preferred, and equal to or higher than 1 cP but equal to or lower than 10 cP is optimal.
3. A flash point of equal to or higher than 25°C is desirable, equal to or higher than 30°C is preferred, and equal to or higher than 35°C is optimal.

Specific examples of the above solvents are: hydrocarbons (such as cyclohexane and 1,1-dimethylcyclohexane), alcohols (such as butanol, diacetone alcohol, and tetrafluoropropanol), glycol ethers (such as methyl cellosolve, propylene glycol monomethylether, and propylene glycol monomethylether acetate), esters (such as butyl acetate, methyl lactate, and ethyl lactate), ketones (such as methyl ethyl ketone and methyl isobutyl ketone), nitriles (such as propionitrile and benzonitrile), amides (such as dimethylformamide), sulfones (such as dimethylsulfoxide), carboxylic acids (such as acetic acid), amines (such as triethylamine), halogens (such as trichloromethane and hydrofluorocarbons), and aromatics (such as toluene and xylene). Of these, the particularly preferred solvents in terms of coating properties are: alcohols or glycol ethers. The above solvents may be employed singly or in combinations of two or more.

It is sufficient for the photoresist liquid of the present invention to comprise at least the compound for photoresist as a solid component. Other components can be incorporated as needed. However, the total of the other components is desirably equal to or lower than 1 parts, relative to the mass of the compound for photoresist.
Examples of other components are binders, antifading agents, oxidation inhibitors, UV-absorbing agents, plasticizers, and lubricants. Examples of binders are natural organic polymeric substances such as gelatins, cellulose derivatives, dextran, rosins, and rubbers; and synthetic organic polymers such as hydrocarbon-based resins such as polyethylene, polypropylene, polystyrene, and polyisobutylene; vinyl-based resins such as polyvinyl chloride, polyvinylidene chloride, polyvinyl chloride/polyvinyl acetate copolymers; acrylic resins such as polymethyl acrylate and polymethyl methacrylate; and initial condensates of polyvinylalcohol, chlorinated polyethylene, epoxy resin, butyral resin, rubber derivatives, phenol formaldehyde resins, and other thermosetting resins. When adding a binder to the photoresist liquid of the present invention, the quantity of binder added is desirably 0.01 to 1 part, preferably 0.1 to 0.5 part, relative to the mass of the compound for photoresist of the present invention.

The compound for photoresist of the present invention generally does not decompose or denature in a normal indoor illuminated environment. There is thus no need to handle it under safety lamps (such as illumination from which UV radiation or light of shorter wavelengths has been cut), such as is required by conventional photoresists. Various antifading agents can be incorporated to the photoresist liquid to form a resist film affording good light resistance when handled under such common indoor environment illumination.
Generally, singlet oxygen quenchers are employed as antifading agents. Known singlet oxygen quenchers that have been disclosed in the literature, such as in patent specifications, can be employed. Specific examples are described in each publication such as Japanese Unexamined Patent Publication (KOKAI) Showa Nos. 58-175693, 59-81194, 60-18387, 60-19586, 60-19587, 60-35054, 60-36190, 60-36191, 60-44554, 60-44555, 60-44389, 60-44390, 60-54892, 60-47069, and 63-209995; Japanese Unexamined Patent Publication (KOKAI) Heisei No. 4-25492; Japanese Examined Patent Publication (KOKOKU) Heisei Nos. 1-38680 and 6-26028; German Patent No. 350399; and the Journal of the Chemical Society of Japan, October, 1992, p. 1,141. The quantity of the above singlet oxygen quenchers and other antifading agents that is employed, for example, falls within a range of 0.1 to 50 mass percent, desirably within a range of 0.5 to 45 mass percent, preferably within a range of 3 to 40 mass percent, and more preferably, within a range of 5 to 25 mass percent, relative to the quantity of the compound for photoresist of the present invention.

As is described further below, the photoresist liquid of the present invention permits the formation of an etching mask without a developing step. Accordingly, neither the component combination of an o-naphthoquinonediazidosulfonic acid ester and a novolak resin, the component combination of a photoacid generator and a compound decomposing in the presence of an acid, the component combination of a photobase generator and a compound decomposing in the presence of a base, nor the component combination of a photoradical generator and an unsaturated addition-polymerizable compound is an essential component in the photoresist liquid of the present invention, despite the fact that these are contained as essential components in normal photopolymer-type resist liquids requiring a development step. These components are desirably not incorporated in the photoresist liquid of the present invention.

The photoresist liquid of the present invention can be obtained by mixing the compound for photoresist of the present invention with the above components as needed.

The photoresist liquid of the present invention can be coated on a surface that is to be processed and the solvent removed to form a photoresist film. The photoresist film can then be exposed to a desired pattern with a laser beam to form a desired resist pattern. The details of coating the photoresist liquid to form a resist film are as set forth above.

The compound for photoresist of the present invention assumes the function of the photoresist film. Thus, the compound for photoresist is desirably incorporated in a proportion of equal to or more than 50 mass percent, preferably equal to or more than 70 mass percent, and more preferably, equal to or more than 90 mass percent of the total mass of the photoresist film. The upper limit is, for example, 100 mass percent. The various components that may be contained in the photoresist film are as set forth above for the photoresist composition of the present invention.

The embodiment of the photoresist liquid of the present invention in which the total solid component thereof is comprised of the compound for photoresist is particularly desirable from the perspective of the ease of recovering and re-using excess photoresist liquid (for example, photoresist liquid that is thrown off the surface being processed during spin coating) after providing it on the surface processed in the spin coating step.

The photoresist liquid of the present invention can be applied to any application that requires fine processing. For example, it can be employed instead of conventional photoresist liquid in various steps, such as the manufacturing steps of semiconductor devices such as LSIs, LEDs, CCDs, and solar cells; the manufacturing steps of FPDs such as liquid crystals, Pups, and ELs; and the manufacturing steps of optical parts such as lenses and film. That is, the steps of coating the photoresist liquid of the present invention, removing the solvent, and pattern exposure can be used instead of the steps of coating a conventional photoresist liquid, removing the solvent, pattern exposure, and development.

The photoresist liquid of the present invention can also be used in the process of fabricating a master for nanoimprinting.

The photoresist liquid of the present invention can be used to form minute irregularities in surfaces such as the front surface, the rear surface (for example, a sapphire substrate and the like), and the lateral surface of an LED chip to enhance the light output efficiency of an LED. Generally, the refractive index of the material constituting the outermost layer (for example, a current diffusion layer or transparent electrode) serving as the light outlet of an LED chip differs from that of the package resin. For example, the refractive index of a current diffusion layer is equal to or greater than 3, while the refractive index of the package resin is about 1.5. When light is outputted from a portion of such a high refractive index to a portion of low refractive index, the light ends up reflecting at the boundary, reducing light output efficiency. In contrast, providing minute irregularities at the boundary can enhance light output efficiency. Accordingly, after forming the layer serving as the light outlet (for example, a current diffusion layer) of an LED chip, a photoresist film can be formed by coating the photoresist liquid of the present invention and removing a solvent, and exposed to a pattern by irradiation with a laser beam in just portions corresponding to the indentations in a pattern of desired minute irregularities, and subsequently, etching can be conducted to etch the surface of the outlet corresponding to the portions irradiated with the laser beam to form indentations, thereby forming minute irregularities on the outlet. Then, necessary processing (such as forming electrodes on the surface of the current diffusion layer) can be conducted to complete the LED chip. The light outlet of an LED chip obtained in this manner will have minute irregularities on the surface thereof. The LED obtained by packaging this LED element will have minute irregularities formed at the boundary of the package resin and the light outlet, so reflection at the boundary will be reduced, permitting the fabrication of an LED with good light output efficiency. In this manner, when outputting from a portion of high refractive index to a portion of low refractive index, the provision of minute irregularities at the boundary can increase light output efficiency. It suffices for the depth h and the diameter d of indentations formed at the boundary of the light-emitting element to be of a size causing the scattering and diffraction of light generated in the light-emitting element. They are desirably equal to or greater than one-fourth the emission wavelength, and can be designed based on scattering theory.

When forming minute irregularities on the surface being processed in this manner, the photoresist liquid of the present invention can be used to form a photoresist film on the surface, a laser can be used to expose a minute pattern, and it can be employed as a mask to form minute irregularities corresponding to the minute pattern in the surface being processed by RIE or the like. Further, a mask layer can be provided on the surface being processed, the photoresist liquid of the present invention can be used to form a photoresist film thereover, minute processing can be conducted thereon with a laser, minute holes can then be formed in the mask layer by RIE, and the surface being processed can be further deeply etched by ICP (inductively coupled plasma) through the mask layer in which the minute holes have been formed. Etching methods employing such a mask layer are advantageous when the surface being processed is hard and difficult to etch, such as sapphire. A mask layer of SiO₂, TiO₂, SiN, SiON, or some other inorganic oxide film or nitride film is desirable.

The thickness t of the photoresist film formed with the photoresist liquid of the present invention and the diameter d of the indentations can be established based on the etching step conditions such as the type of the compound for photoresist of the present invention, material of the surface being processed, and selection ratio. They should also be set taking into account the optical characteristics during laser recording. As a desirable range, the upper limit of the thickness t of the resist layer satisfies t < 100d, with t < 10d being preferable. The lower limit desirably satisfies t > d/100, with t > d/10 being preferable.

### [Method of etching the surface being processed]

The present invention further relates to a method of etching a surface being processed. The etching method of the present invention comprises: forming a photoresist film by coating the photoresist liquid of the present invention on a surface being processed; pattern exposing the photoresist film; and subjecting at least a portion of the surface being processed on which is present the photoresist film following the pattern exposure to etching, to etch at least a portion of the surface being processed in an area corresponding to the portion that has been exposed in the pattern exposure.

In the photoresist that has been pattern exposed, pits are formed in portions, that have been exposed during pattern exposure, of the photoresist film, or portions are formed in which localized physical changes have occurred, such as low-durability portions. In etching, the surface being processed corresponding to pits and/or low-durability portions of the photoresist film is preferentially etched, and the underlying surface being processed is also etched, forming indentations. At least a portion of the surface being processed can be etched in areas corresponding to the portion that has been exposed by pattern exposure to form minute irregularities in the surface being processed. When the surface being processed comprises plural thin films, at least one of the thin films can be removed in the form of a pattern. This can be utilized to fabricate various semiconductor devices.

Pattern exposure can be conducted by the known method of exposure through a photomask using a stepper. However, it is desirable to pulse modulate the laser beam, narrow the modulated laser beam through a lens, and conduct pattern exposure with the focal point on the photoresist film. The recording devices used to record information on optical disks are suitable as the pattern exposure device for conducting such light irradiation. However, so long as an adequate amount of light can be converged, a monochromatic beam such as a laser beam is not required.

As the type of laser beam, any type of laser, such as a gas laser, solid laser, or semiconductor laser, can be employed. However, to simplify the optical system, a solid laser or a semiconductor laser is desirably employed. The laser beam may be a continuous beam or a pulsed beam, but the use of a laser beam with a readily adjustable light-emission interval is desirable. A semiconductor laser is an example of such a laser beam. When the laser cannot be directly on/off modulated, it is desirably modulated with an external modulation element.

As high a laser power as possible is desirable to increase the processing rate. However, as the laser power increases, the scan rate (the rate at which the laser beam is scanned over the coating film - for example, the rotational speed of the optical disk drive, described further below) must be increased. Thus, taking into account the upper limit of the scan rate, the upper limit of the laser power is desirably 100 W, preferably 10 W, more preferably 5 W, and optimally, 1 W. The lower limit of the laser powder is desirably 0.1 mW, preferably 0.5 mW, and more preferably, 1 mW.

The laser beam desirably has good transmission wavelength breadth and coherence, permitting narrowing to a spot size of about the wavelength. Further, the strategies such as those generally employed for optical disks are desirably adopted for the beam pulse irradiation conditions. That is, the conditions such as those employed for optical disks, such as the recording rate, peak value of the irradiated laser beam, and pulse width, are desirably employed.

It suffices for the wavelength of the laser beam to permit high laser power. Desirable examples of readily achievable laser wavelengths are 1064 ± 30 nm, 800 ± 50 nm, 670 ± 30 nm, 532 ± 30 nm, 405 ± 50 nm, 266 ± 30 nm, and 200 ± 30 nm. Of these, 780 ± 30 nm, 660 ± 20 nm, or 405 ± 20 nm at which high output can be achieved in a semiconductor laser is preferred; 405 ± 10 nm is optimal. It does not matter if λa ≤ λw, or λa ≥ λw, where λa is the maximum absorption wavelength of the compound for photoresist employed and λw is the laser beam wavelength. To uniformly apply light from the front surface to the rear surface of the photoresist film in the direction of thickness and totally apply heat to form holes of regular shape, the level of absorption of the thin film desirably falls within a fixed range. When absorption is excessively high, light only reaches the front surface, and when excessively low, the light is not converted to heat and the efficiency deteriorates. The upper limit of extinction coefficient k, which denotes the absorption tendency of a material, is suitably equal to or lower than 2, desirably equal to or lower than 1, and particularly preferably, equal to or lower than 0.5. The lower limit is desirably equal to or higher than 0.0005, equal to or higher than 0.005, or equal to or higher than 0.05. When the above relations are satisfied, the level of light absorption of the compound for photoresist is suitable and it is possible to form good pits or low-durability portions by pattern exposure.

The thickness of the resist film can be suitably set within a range of 1 to 10,000 nm, for example. The lower thickness limit is desirably equal to or higher than 10 nm, preferably equal to or higher than 30 nm. This is because it is difficult to achieve an etching effect when the resist film is excessively thin. The upper thickness limit is desirably equal to or lower than 1,000 nm, preferably equal to or lower than 500 nm. This is because when the resist film is excessively thick, great laser power becomes necessary and it becomes difficult to form deep holes, and further, the processing rate decreases.

For example, pit-forming methods publicly known in a write-once optical disk, a recordable optical disk and the like can be applied as the light irradiation method. As a specific example, a publicly known running OPC technique (for example, see Japanese Patent No. 3,096,239) can be applied, where the intensity of the reflected light of a laser varying with the pit size is detected, the output of the laser is corrected to render the intensity of the reflected light uniform, and uniform pits are formed. In the resist film of the present invention, when portions the physical properties of which have been changed to the point where they are removed by etching when irradiated with light are present in a localized manner, such portions can function as an etching mask by being removed during etching. It is thus unnecessary for pits (openings) that are recognizable to the eye, or the like, to be formed. The size and processing pitch of pits and portions with changed physical properties can be controlled by adjusting the optical system. Since the light in a laser beam is the most intense near the center, gradually lessening toward the exterior, it is possible to form minute pits, smaller in diameter than the diameter of the laser beam spot, in the coating film. It suffices to link laser spots when it is desirable to form pits that are larger than the minimum processing shape of the laser beam.

Specific embodiments of the optical system used in processing are described below. However, the present invention is not limited to the embodiments indicated below.
The light irradiating device having the same configuration as that of a common optical disk drive can be employed. An optical disk drive configured as described in Japanese Unexamined Patent Publication (KOKAI) No. 2003-203348 can be employed. When employing such an optical disk drive and the object being processed, on which the coating film has been formed, is disk-shaped, it is loaded into the disk drive as is. When not of such a shape, the object being processed is adhered to a dummy optical disk or the like and loaded into the disk drive. A laser beam of suitable output is then irradiated onto the coating film. It then suffices to input a pulse signal or continuous signal to the laser beam source to match the pattern being irradiated with the processing pattern. A focusing technique identical to that of an optical disk drive, such as an astigmatizing method, can be employed to readily converge the light onto the surface of the coating film, even when waviness or warping is present on the surface of the coating film. Displacing the optical system toward the radius direction while rotating the object being processed in the same manner as when recording information on an optical recording disk permits periodic irradiation of the entire coating film with light.

As the light irradiating conditions, the lower limit of the numerical aperture NA of the optical system is desirably equal to or greater than 0.4, preferably equal to or greater than 0.5, and more preferably, equal to or greater than 0.6. The upper limit of the numerical aperture NA is desirably equal to or lower than 2, preferably equal to or lower than 1, and more preferably, equal to or lower than 0.9. When employing a large numerical aperture, employing what is known as the liquid immersion method of positioning a liquid between an object lens and the photoresist film affords the advantage of facilitating focal point adjustment. That is because, when the numerical aperture NA is excessively small, minute processing is precluded, and when excessively large, the margin relative to the angular during light irradiation decreases. The wavelength of the optical system is, for example, 405 ± 30 nm, 532 ± 30 nm, 650 ± 30 nm, or 780 ± 30 nm. That is because these wavelengths readily achieve high output. The shorter the wavelength, the finer the processing that is possible, which is desirable.

The lower limit of the output of the optical system is, for example, equal to or higher than 0.1 mW, desirably equal to or higher than 1 mW, preferably equal to or higher than 5 mW, and more preferably, equal to or higher than 20 mW. The upper limit of the output of the optical system is, for example, equal to or lower than 1,000 mW, desirably equal to or lower than 500 mW, and preferably, equal to or lower than 200 mW. This is because processing takes time when the output is excessively low, and the durability of the components making up the optical system decreases when the output is excessively high.

The lower limit of the linear speed of displacement of the optical system relative to the surface of the coating film is, for example, equal to or greater than 0.1 m/s, desirably equal to or greater than 1 m/s, more preferably equal to or greater than 5 m/s, and still more preferably, equal to or greater than 20 m/s. The upper limit of the linear speed is, for example, equal to or lower than 500 m/s, desirably equal to or lower than 200 m/s, more preferably equal to or lower than 100 m/s, and still more preferably, equal to or lower than 50 m/s. That is because it becomes difficult to increase processing precision when the linear speed is excessively high, and time is required for processing as well as it becomes difficult to achieve good shape processing when the linear speed is excessively low. As a specific example of an optical processing device comprising an optical system, a NEO500 made by Pulstec Industrial Co., Ltd. can be employed.

The photoresist film set forth above can be employed as an etching mask without a developing step following pattern exposure. A post-baking step, during which a heat treatment is conducted, can be inserted after pattern exposure and before the etching step described further below. Post baking can firmly bond the photoresist film to the surface being processed following pattern exposure, and enhance its function as a mask during subsequent etching. The lower limit of the heating temperature of post baking is, for example, equal to or higher than 55°C, desirably equal to or higher than 65°C, and preferably, equal to or higher than 75°C. The upper limit of the temperature is, for example, equal to or lower than 200°C, desirably equal to or lower than 150°C, and preferably, equal to or lower than 100°C. Conducting a heat treatment with such a range can enhance the above-described effect without diminishing production efficiency.

Various examples of etching methods can be given, such as wet etching and dry etching; it suffices to employ a method corresponding to the physical properties of the surface being etched. To conduct minute processing it is desirable to employ RIE (reactive ion etching), which permits fine patterning with high direct etching gas propagation. RIE is conducted by placing the object being processed within a gas-tight processing chamber, generating a prescribed reduced pressure atmosphere within the processing chamber by introducing a prescribed processing gas and drawing a vacuum, then applying high-frequency power to electrodes formed within the processing chamber, for example, to excite a plasma, and using the etchant ions in the plasma to conduct etching to the object being processed. The etching gas of RIE can be selected based on the substance being etched.
The photoresist film formed of the photoresist liquid of the present invention is normally removed following etching but can be allowed to remain, depending on the application. The photoresist film can be removed by a wet removal method employing a stripping solution (such as ethanol), for example.

The embodiment in which the photoresist liquid of the present invention is employed in etching has been described above. However, the photoresist liquid of the present invention can also be used to deposit a desired substance in a desired area on a surface being processed.
For example, an electrode such as AuZn or AuGe is provided on a portion of the surface of the light outlet (for example, the current diffusion layer) of an LED chip. In that case, the photoresist liquid of the present invention is coated on the surface of the light outlet (such as the surface of the current diffusion layer), the solvent is removed to form a photoresist film, and a laser beam is then irradiated onto an area where an electrode is to be formed to remove the photoresist film. In this case, the amount of the laser beam irradiated onto the photoresist film may be that sufficient to form low-durability portions. In that case, etching can subsequently be conducted to remove the photoresist film from low-durability portions, thereby removing the photoresist film in the area in which an electrode is being formed. Subsequently, the substance serving as the electrode (such as AuZn or AuGe) is deposited under vacuum and the photoresist film is then removed to form an electrode in a desired area on the surface of the light outlet.

As set forth above, the compound for photoresist of the present invention can be used to form minute irregularities and to fabricate semiconductor devices. Specific examples are semiconductor elements, magnetic bubble memories, integrated circuits, and various other electronic components, LED and fluorescent lamps, organic EL elements, plasma displays, and other light-emitting, but is not limited thereto.

### EXAMPLES

The present invention will be described below based on Examples. However, the present invention is not limited to the embodiments shown in Examples.

### [Example 1]

### Formation of photoresist film

A 2 g quantity of oxonol dye (Example Compound (II)-5, film λmax: 378 nm; thermal decomposition temperature: 216°C) was dissolved in 100 mL of tetrafluoropropanol (TFP), and spin coated on a disk-shaped silicon substrate (0.6 mm in thickness, 120 mm in outer diameter, 15 mm in inner diameter) to form a coating film. The spin coating was conducted by dispensing a coating liquid on the inner circumferential portion of the substrate at a coating starting rotational speed of 500 rpm and a coating ending rotational speed of 100 rpm. The rotational speed was gradually increased to 2,200 rpm to dry the coating film. The coating film that was formed was 100 nm in thickness.
The silicon substrate on which the coating film had been formed was placed in a NEO500 made by Pulstec Industrial Co., Ltd. (wavelength: 405 nm, NA: 0.65), and a laser beam was directed onto the surface of the coating film. The laser beam irradiation conditions were as set forth below. Pits were formed on the coating film at a pitch of 0.5 micrometer.
Laser output: 2 mW
Linear speed: 5 m/s
Recording signal: 5 MHz rectangular wave

### [Example 2]

### Formation of irregularities

The silicon substrate processed in Example 1 was subjected to RIE etching under the following conditions from the surface side on which the coating film had been formed, after which the coating film was removed with ethanol as stripping solution. The formation of minute irregularities on the surface of the silicon substrate from which the coating film had been removed was visually confirmed. From this result, it can be understood that the coating film processed in Example 1 had functioned as an etching mask.
Etching gas: SF₆ + CHF₃ (1:1)
Etching depth: 50 nm

### [Examples 3 to 14]

With the exception that Example Compounds given in Table 2 below were employed as oxonol dyes, pits were formed on the coating film at a 0.5 micrometer pitch in the same manner as in Example 1 by irradiation of the coating film surface with a laser beam in the same manner as in Example 1.

**[Table 3]**

| | Example Compound | λmax of film (nm) | Thermal decomposition temperature (°C) |
|---|---|---|---|
| Example 3 | (II-1) | 380 | 188 |
| Example 4 | (II-2) | 393 | 245 |
| Example 5 | (II-3) | 385 | 183 |
| Example 6 | (II-4) | 378 | 200 |
| Example 7 | (II-16) | 382 | 228 |
| Example 8 | (II-17) | 393 | 265 |
| Example 9 | (II-18) | 385 | 166 |
| Example 10 | (II-19) | 378 | 220 |
| Example 11 | (II-20) | 378 | 200 |
| Example 12 | (II-21) | 377 | 145 |
| Example 13 | (II-22) | 462 | 188 |
| Example 14 | (II-23) | 572 | 237 |

### [Examples 15 to 26]

Silicon substrates having the coating films on which pits had been formed that were obtained in Examples 3 to 14 were subjected to RIE etching in the same manner as in Example 2 and the coating films were removed with a stripping solution in the form of ethanol. The formation of minute irregularities was visually confirmed on the surface of each of the silicon substrates in the same manner as in Example 2. Based on this result, it can be understood that, in the oxonol dyes employed in Examples 3 to 14, the coating films thereof had functioned as etching masks. Better shape of pits was achieved in the Examples in which dyes having a λmax within the laser beam wavelength (405 nm) ± 150 nm range were employed than in the Examples in which dyes having a λmax outside the above range were employed.

### [Example 15]

### Formation of photoresist film

A 2 g quantity of cyanine dye (Example Compound IV-57, film λmax: 448 nm, thermal decomposition temperature: 275°C) was dissolved in 100 mL of tetrafluoropropanol (TFP), and spin coated on a disk-shaped silicon substrate (0.6 mm in thickness, 120 mm in outer diameter, 15 mm in inner diameter) to form a coating film. The spin coating was conducted by dispensing a coating liquid on the inner circumferential portion of the substrate at a coating starting rotational speed of 500 rpm and a coating ending rotational speed of 100 rpm. The rotational speed was gradually increased to 2,200 rpm to dry the coating film. The coating film that was formed was 100 nm in thickness.
The silicon substrate on which the coating film had been formed was placed in a NEO500 made by Pulstec Industrial Co., Ltd. (wavelength: 405 nm, NA: 0.65), and a laser beam was directed onto the surface of the coating film. The laser beam irradiation conditions were as set forth below. Pits were formed on the coating film at a pitch of 0.5 micrometer.
Laser output: 2 mW
Linear speed: 5 m/s
Recording signal: 5 MHz rectangular wave

### [Example 16]

With the exception that the dye employed was changed from a cyanine dye to a styryl dye (Example Compound V-1, film λmax: 543 nm, thermal decomposition temperature: 280°C), a photoresist film was formed on a silicon substrate by the same method as in Example 15. The resist film was irradiated with a laser beam in the same manner as in Example 1 to form pits at a pitch of 0.5 micrometer in the resist film.

### [Examples 17 and 18]

### Formation of irregularities

The silicon substrates processed in Examples 15 and 16 were subjected to RIE etching under the conditions set forth below from the surface side on which the coating film had been formed, after which the coating films were removed with ethanol as stripping solution. The formation of minute irregularities on the surfaces of the silicon substrates from which the coating films had been removed was visually confirmed From this result, it can be understood that the coating films processed in Examples 1 and 2 had functioned as etching masks.
Etching gas: SF6 + CHF₃ (1:1)
Etching depth: 50 nm

### [Examples 19 to 26]

With the exception that the cyanine dyes or styryl dyes listed in Table 3 below were employed as the dye, resist film surfaces were irradiated with laser beams in the same manner as in Example 15 to form pits at a pitch of 0.5 micrometer in resist films in the same manner as in Example 1.

**[Table 4]**

| | Example Compound | Maximum absorption wavelength (nm) | Thermal decomposition temperature (°C) |
|---|---|---|---|
| Example 19 | IV-61 | 441 | 249 |
| Example 20 | IV-62 | 360 | 310 |
| Example 21 | IV-63 | 379 | 308 |
| Example 22 | IV-64 | 612 | 270 |
| Example 23 | IV-65 | 695 | 268 |
| Example 24 | V-2 | 542 | 280 |
| Example 25 | V-3 | 524 | 300 |
| Example 26 | V-4 | 526 | 305 |

### [Examples 27 to 34]

Silicon substrates having the resist films on which pits had been formed obtained in Examples 19 to 26 were subjected to RIE etching in the same manner as in Example 17, the coating films were removed with ethanol as stripping solution, and the formation of minute irregularities on the surface of each of the substrates was visually confirmed in the same manner as in Example 17. From this result, it can be understood that, also in the cyanine dyes and the styryl dyes employed in Examples 19 to 26, the resist films thereof had functioned as etching masks. Better shape of pits was achieved in the Examples in which dyes having a λmax within the laser beam wavelength (405 nm) ± 150 nm range were employed than in the Examples in which dyes having a λmax outside the above range were employed.

### [Example 35]

### (1) Formation of photoresist film

A 2 g quantity of merocyanine dye (Example Compound (S-39), thermal decomposition temperature: 263°C) was dissolved in 100 mL of tetrafluoropropanol (TFP), and spin coated on a disk-shaped silicon substrate (0.6 mm in thickness, 120 mm in outer diameter, 15 mm in inner diameter) to form a coating film. The spin coating was conducted by dispensing a coating liquid on the inner circumferential portion of the substrate at a coating starting rotational speed of 500 rpm and a coating ending rotational speed of 100 rpm. The rotational speed was gradually increased to 2,200 rpm to dry the coating film. The coating film that was formed was 100 nm in thickness with λmax of 379 nm.
The silicon substrate on which the coating film had been formed was placed in a NEO500 made by Pulstec Industrial Co., Ltd. (wavelength: 405 nm, NA: 0.65), and a laser beam was directed onto the surface of the coating film. The laser beam irradiation conditions were as set forth below. Pits were formed on the coating film at a pitch of 0.5 micrometer.
Laser output: 2 mW
Linear speed: 5 m/s
Recording signal: 5 MHz rectangular wave

### (2) Formation of irregularities

The silicon substrate processed in (1) above was subjected to RIE etching under the conditions set forth below from the surface side on which the coating film had been formed, after which the coating film was removed with ethanol as stripping solution. The formation of minute irregularities on the surface of the silicon substrate from which the coating film had been removed was visually confirmed. From this result, it can be understood that the coating film processed in (1) above functioned as an etching mask.
Etching gas: SF₆ + CHF₃ (1:1)
Etching depth: 50 nm

### [Examples 36 to 47]

With the exception that the merocyanine dye (Example Compound S-39) was replaced with Example Compounds listed in Table 4 below, processing identical to that in Example 35 yielded the same results as in Example 35.

**[Table 5]**

| | Example Compound | Maximum absorption wavelength(nm) |
|---|---|---|
| Example 35 | (S-39) | 379 |
| Example 36 | (S-31) | 381 |
| Example 37 | (S-32) | 401 |
| Example 38 | (S-33) | 416 |
| Example 39 | (S-34) | 385 |
| Example 40 | (S-35) | 370 |
| Example 41 | (S-36) | 376 |
| Example 42 | (S-37) | 388 |
| Example 43 | (S-38) | 413 |
| Example 44 | (S-40) | 344 |
| Example 45 | (S-41) | 392 |
| Example 46 | (S-42) | 402 |
| Example 47 | (S-43) | 368 |

### [Example 48]

### (1) Formation of photoresist film

A 2 g quantity of phthalocyanine dye (Example Compound (VII-9), thermal decomposition temperature: 325°C, maximum absorption wavelength λmax: 346 nm) was dissolved in 100 mL of tetrafluoropropanol (TFP), and spin coated on a disk-shaped silicon substrate (0.6 mm in thickness, 120 mm in outer diameter, 15 mm in inner diameter) to form a coating film. The spin coating was conducted by dispensing a coating liquid on the inner circumferential portion of the substrate at a coating starting rotational speed of 500 rpm and a coating ending rotational speed of 100 rpm. The rotational speed was gradually increased to 2,200 rpm to dry the coating film. The coating film that was formed was 100 nm in thickness.
The silicon substrate on which the coating film had been formed was placed in a NEO500 made by Pulstec Industrial Co., Ltd. (wavelength: 405 nm, NA: 0.65), and a laser beam was directed onto the surface of the coating film. The laser beam irradiation conditions were as set forth below. Pits were formed on the coating film at a pitch of 0.5 micrometer.
Laser output: 2 mW
Linear speed: 5 m/s
Recording signal: 5 MHz rectangular wave

### (2) Formation of irregularities

The silicon substrate processed in (1) above was subjected to RIE etching under the conditions set forth below from the surface side on which the coating film had been formed, after which the coating film was removed with ethanol as stripping solution. The formation or minute irregularities on the surface of the silicon substrate from which the coating film had been removed was visually confirmed. From this result, it can be understood that the coating film processed in (1) above functioned as an etching mask.
Etching gas: SF₆ + CHF₃ (1:1)
Etching depth: 50 nm

### [Examples 49 to 59]

With the exception that phthalocyanine resin (VII-9) was replaced with Example Compounds listed in Table 5 below, processing identical to that in Example 1 yielded results identical to those in Example 48.

**[Table 6]**

| | Example Compound | Maximum absorption wavelength (nm) | Thermal decomposition temperature (°C) |
|---|---|---|---|
| Example 48 | (VII-9) | 346 | 325 |
| Example 49 | (VII-10) | 343 | 333 |
| Example 50 | (VII-11) | 342 | 367 |
| Example 51 | (VII-12) | 349 | 364 |
| Example 52 | (VII-13) | 345 | 253 |
| Example 53 | (VII-14) | 352 | 278 |
| Example 54 | (VII-15) | 350 | 294 |
| Example 55 | (VII-16) | 377 | 415 |
| Example 56 | (VII-29) | 341 | 308 |
| Example 57 | (VII-41) | 322 | 358 |
| Example 58 | (VII-42) | 342 | 363 |
| Example 59 | (VII-43) | 357 | 355 |

### [Example 60]

### Formation of photoresist film

A 2 g quantity of azo dye (Example Compound (75), film maximum absorption wavelength λmax: 441 nm, thermal decomposition temperature: 270°C) was dissolved in 100 mL of tetrafluoropropanol (TFP), and spin coated on a disk-shaped silicon substrate (0.6 mm in thickness, 120 mm in outer diameter, 15 mm in inner diameter) to form a coating film. The spin coating was conducted by dispensing a coating liquid on the inner circumferential portion of the substrate at a coating starting rotational speed of 500 rpm and a coating ending rotational speed of 100 rpm. The rotational speed was gradually increased to 2,200 rpm to dry the coating film. The coating film that was formed was 100 nm in thickness.
The silicon substrate on which the coating film had been formed was placed in a NEO500 made by Pulstec Industrial Co., Ltd. (wavelength: 405 nm, NA: 0.65), and a laser beam was directed onto the surface of the coating films. The laser beam irradiation conditions were as set forth below. Pits were formed on the coating film at a pitch of 0.5 micrometer.
Laser output: 2 mW
Linear speed: 5 m/s
Recording signal: 5 MHz rectangular wave

### [Example 61]

### Formation of irregularities

The silicon substrate having a photoresist film in which pits were formed that had been processed in Example 60 was subjected to RIE etching under the conditions set forth below from the surface side on which the coating film had been formed, after which the coating film was removed with ethanol as stripping solution. The formation of minute irregularities on the surface of the silicon substrate from which the coating film had been removed was visually confirmed. From this result, it can be understood that the photoresist film obtained in Example 60 in which pits had been formed functioned as an etching mask.
Etching gas: SF₆ + CHF₃ (1:1)
Etching depth: 50 nm

### [Examples 62 to 69]

With the exception that Example Compounds listed in Table 6 below were employed as an azo dye, a laser beam was irradiated onto the photoresist film surface in the same manner as in Example 60, forming pits in the photoresist film at a pitch of 0.5 micrometer in the same manner as in Example 60.

**[Table 7]**

| | Example Compound | Maximum absorption wavelength (nm) | Thermal decomposition temperature (°C) |
|---|---|---|---|
| Example 62 | (81) | 460 | 254 |
| Example 63 | (82) | 482 | 331 |
| Example 64 | (85) | 439 | 275 |
| Example 65 | (86) | 377 | 322 |
| Example 66 | (87) | 457 | 321 |
| Example 67 | (44) | 455 | 321 |
| Example 68 | (46) | 598 | 340 |
| Example 69 | (47) | 603 | 320 |

### [Examples 70 to 77]

With the silicon substrates having photoresist films in which pits were formed that had been obtained in Examples 62 to 69, RIE etching was conducted in the same manner as in Example 61, the coating films were removed with ethanol as stripping solution, and the formation of minute irregularities on the surface of each of the silicon substrates was visually confirmed in the same manner as in Example 2. Based on this result, it can be understood that, also in the azo dyes employed in Examples 62 to 69, the photoresist films thereof had functioned as etching masks. Better shape of pits was achieved in the Examples in which dyes having a λmax within the laser beam wavelength (405 nm) ± 150 nm range were employed than in the Examples in which dyes having a λmax outside the above range were employed.

Minute surface processing can be readily conducted according to the present invention.

## Claims

1. A compound for photoresist, selected from the group consisting of a compound comprising an oxonol dye skeleton, a cyanine dye, a styryl dye, a compound comprising a merocyanine dye skeleton, a compound comprising a phthalocyanine dye skeleton, an azo compound, and a complex compound of an azo compound and a metal ion.

2. A compound for photoresist according to claim 1, which is a compound denoted by the following general formula (I): 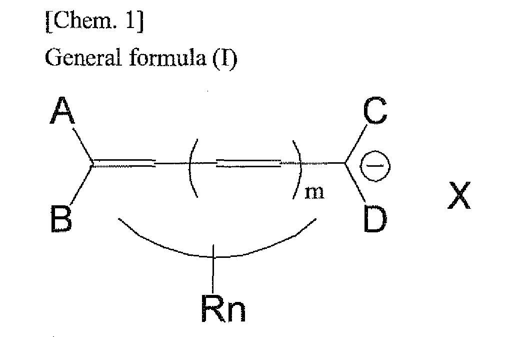 wherein, in general formula (I), each of A, B, C, and D independently denotes an electron-withdrawing group, with a total of a Hammett's σₚ value of the electron-withdrawing group denoted by A and that of the electron-withdrawing group denoted by B being equal to or greater than 0.6 and a total of a Hammett's σₚ value of the electron-withdrawing group denoted by C and that of the electron-withdrawing group denoted by D being equal to or greater than 0.6, A and B may be linked together to form a ring, C and D may be linked together to form a ring, R denotes a substituent on a methine carbon, m denotes an integer of equal to or greater than 0 but equal to or less than 3, n denotes an integer of equal to or greater than 0 but equal to or less than (2m+1), plural Rs present may be respectively identical or different and may be linked together to form a ring when n denotes an integer of equal to or greater than 2, and X denotes a counter ion that neutralizes a charge of the compound denoted by general formula (I).

3. The compound for photoresist according to claim 2, which has a thermal decomposition temperature of equal to or higher than 100°C but equal to or lower than 500 °C.

4. The compound for photoresist according to claim 1, which is a compound denoted by the following general formula (IV): 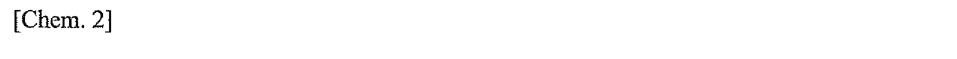 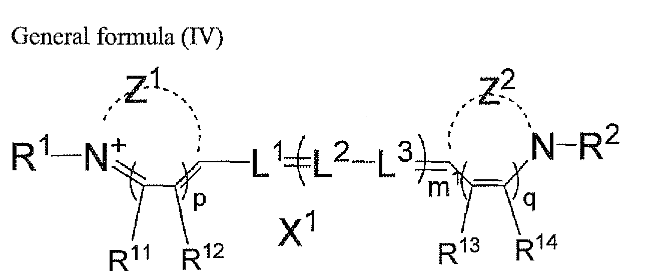 wherein, in general formula (IV), each of Z¹ and Z² independently denotes a group of nonmetal atoms required to form an optionally condensed, five- or six-membered nitrogen-containing hetero ring, each of L¹, L², and L³ independently denotes a methine chain, m¹ denotes an integer ranging from 0 to 2, each of R¹ and R² independently denotes a substituent, plural L²s and L³s present may be identical or different when m¹ denotes 2; each of p and q independently denotes 0 or 1, each of R¹¹, R¹², R¹³, and R¹⁴ independently denotes a hydrogen atom or a substituent; and X¹ denotes a counter ion neutralizing a charge of the compound denoted by general formula (IV).

5. The compound for photoresist according to claim 1, which is a compound denoted by the following general formula (V): 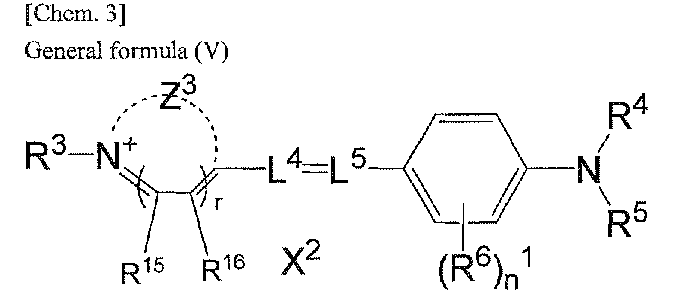 wherein, in general formula (V), Z³ denotes a group of nonmetal atoms required to form an optionally condensed, five- or six-membered nitrogen-containing hetero ring, each of L⁴ and L⁵ independently denotes a methine chain, each of R³, R⁴, R⁵, and R⁶ independently denotes a substituent, n¹ denotes an integer ranging from 0 to 4, plural R⁶s present may be identical or different when n¹ is equal to or greater than 2; r denotes 0 or 1, each of R¹⁵ and R¹⁶ independently denotes a hydrogen atom or a substituent; and X² denotes a counter ion neutralizing a charge of the compound denoted by general formula (V).

6. The compound for photoresist according to claim 4 or 5, which has a thermal decomposition temperature of equal to or higher than 100 °C but equal to or lower than 600°C.

7. The compound for photoresist according to claim 1, which is a compound denoted by the following general formula (VI): 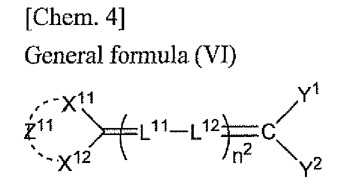 wherein, in general formula (VI), Z¹¹ denotes a group of atoms forming a five- or six-membered hetero ring with X¹¹ and X¹², each of X¹¹ and X¹² independently denotes a carbon atom or a hetero atom, with at least either of X¹¹ or X¹² denoting a hetero atom, each of Y¹ and Y² independently denotes a substituent, with at least either of Y¹ and Y² denoting a cyano group, alkylcarbonyl group, arylcarbonyl group, alkoxycarbonyl group, aryloxycarbonyl group, aminocarbonyl group, alkylsulfone group, arylsulfone group, alkylsulfonyl group, arylsulfonyl group, or aminosulfonyl group, Y¹ and Y² may be linked together to form a ring, each of L¹¹ and L¹² independently denotes a methane group, and n² denotes an integer ranging from 0 to 2.

8. The compound for photoresist according to claim 7, which has a thermal decomposition temperature of equal to or higher than 150°C but equal to or lower than 500 °C.

9. The compound for photoresist according to claim 1, which is a compound denoted by the following general formula (VII): 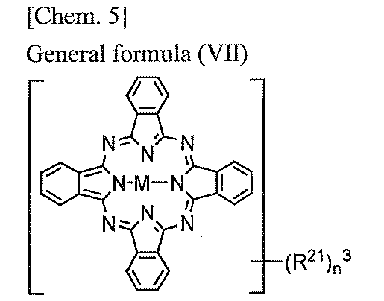 wherein, in general formula (VII), R²¹ denotes a substituent, n³ denotes an integer ranging from I to 8, plural R²¹s present may be identical to or different from each other when n³ is an integer of equal to or greater than 2, and M denotes two hydrogen atoms, a divalent to tetravalent metal atom, a divalent to tetravalent oxymetal atom, or a divalent to tetravalent mental atom comprising a ligand.

10. The compound for photoresist according to claim 9, wherein the compound denoted by general formula (VII) is a compound denoted by the following general formula (VIII): 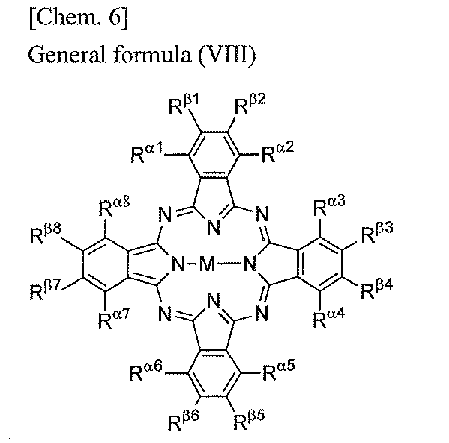 wherein, in general formula (VIII), each of Rα¹ to Rα⁸ and Rβ¹ to Rβ⁸ independently denotes a hydrogen atom, halogen atom, cyano group, nitro group, formyl group, carboxyl group, sulfo group, substituted or unsubstituted alkyl group having 1 to 20 carbon atoms, substituted or unsubstituted aryl group having 6 to 14 carbon atoms, substituted or unsubstituted heterocyclic group having 1 to 10 carbon atoms, substituted or unsubstituted alkoxy group having 1 to 20 carbon atoms, substituted or unsubstituted aryloxy group having 6 to 14 carbon atoms, substituted or unsubstituted acyl group having 2 to 21 carbon atoms, substituted or unsubstituted alkylsulfonyl group having 1 to 20 carbon atoms, substituted or unsubstituted arylsulfonyl group having 6 to 14 carbon atoms, heterylsulfonyl group having 1 to 10 carbon atoms, substituted or unsubstituted carbamoyl group having 1 to 25 carbon atoms, substituted or unsubstituted sulfamoyl group having 0 to 32 carbon atoms, substituted or unsubstituted alkoxycarbonyl group having 2 to 20 carbon atoms, substituted or unsubstituted aryloxycarbonyl group having 7 to 15 carbon atoms, substituted or unsubstituted acylamino group having 2 to 21 carbon atoms, substituted or unsubstituted sulfonylamino group having 1 to 20 carbon atoms, or substituted or unsubstituted amino group having 0 to 36 carbon atoms, with at least 8 from among Rα¹ to Rα⁸ and Rβ¹ to Rβ⁸ being hydrogen atoms, but without all of Rα¹ to Rα⁸ being hydrogen atoms; and M is defined in the same manner as in general formula (VII).

11. The compound for photoresist according to claim 10, wherein, in general formula (VIII), either Rα¹ or Rα², either Rα³ or Rα⁴, either Rα⁵ or Rα⁶, and either Rα⁷ or Rα⁸ are not a hydrogen atom.

12. The compound for photoresist according to any of claims 9 to 11, which has a thermal decomposition temperature of equal to or higher than 150°C but equal to or lower than 500 °C.

13. The compound for photoresist according to claim 1, which is a compound denoted by the following general formula (IX) or a complex compound of the compound and a metal ion:
[Chem. 7] General formula (IX) Q¹-N=N-Q²
wherein, in general formula (IX), Q¹ denotes an aryl group or a heterocyclic group, Q² denotes an aryl group, heterocyclic group, or CR⁴¹R⁴², each of R⁴¹ and R⁴² independently denotes a substituent with a total value of a Hammett's σp value of the substituent denoted by R⁴¹ and that of the substituent denoted by R⁴² being equal to or greater than 0.6.

14. The compound for photoresist according to claim 13, wherein the compound denoted by general formula (IX) is a compound denoted by the following general formula (X-1): 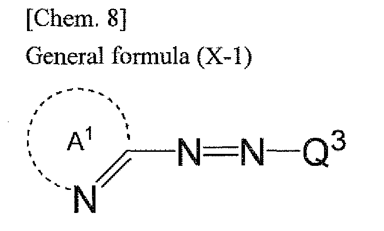 wherein, in general formula (X-1), A¹ denotes a group of atoms forming a hetero aromatic ring with a carbon atom and nitrogen atom to which this is bonded, and Q³ is defined in the same manner as Q² in general formula (IX).

15. The compound for photoresist according to claim 13, wherein the compound denoted by general formula (IX) is a compound denoted by the following general formula (X-2): 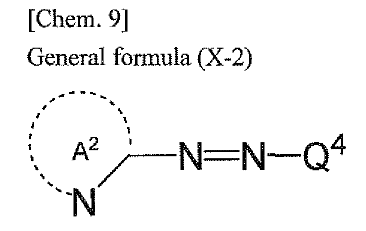 wherein, in general formula (X-2), A² denotes a group of atoms forming a hetero aromatic ring with a carbon atom and nitrogen atom to which this is bonded, and Q⁴ is defined in the same manner as Q² in general formula (IX).

16. The compound for photoresist according to any of claims 13 to 15, which has a thermal decomposition temperature of equal to or higher than 150 °C but equal to or lower than 500°C.

17. A photoresist liquid, comprising at least one of the compound for photoresist according to any of claims 1 to 16.

18. The photoresist liquid according to claim 17, which comprises the compound for photoresist in a quantity of equal to or greater than 50 mass percent based on total solid component comprised in the photoresist liquid.

19. A method of etching a surface being processed, comprising:
forming a photoresist film by coating the photoresist liquid according to claim 17 or 18 on a surface being processed;
pattern exposing the photoresist film; and
subjecting at least a portion of the surface being processed on which is present the photoresist film following the pattern exposure to etching, to etch at least a portion of the surface being processed in an area corresponding to the portion that has been exposed in the pattern exposure.

20. The method of etching a surface being processed according to claim 19, wherein
a light employed for the pattern exposure is a laser beam having a wavelength, λnm,
the compound for photoresist comprised in the photoresist film is a compound selected from the group consisting of a compound comprising an oxonol dye skeleton, a cyanine dye, a styryl dye, a compound comprising a merocyanine dye skeleton, an azo compound, and a complex compound of an azo compound and a metal ion, and has a maximum wavelength within a range of λ±150 nm.

21. The method of etching a surface being processed according to claim 19, wherein
a light employed for the pattern exposure is a laser beam having a wavelength, λnm,
the compound for photoresist comprised in the photoresist film is a compound comprising a phthalocyanine dye skeleton, and has a maximum absorption within a range of λ±150 nm.
